# EUROPEAN PATENT APPLICATION

(11) **EP 4 703 404 A1**
(43) Date of publication of application: **04.03.2026**
(21) Application number: 25198064.5
(22) Date of filing: 26.08.2025
(51) Int. Cl.: C08G 61/12, C07D 519/00, C08L 65/00, C09D 165/00, C09K 11/06, H10K 30/00

(54) **COMPOSITION, THIN FILM, AND ELECTROLUMINESCENCE DEVICE INCLUDING THE THIN FILM**

(30) Priority: 28.08.2024 KR 20240116281
(71) Applicant: Samsung Electronics Co., Ltd., Suwon-si, Gyeonggi-do 16677 (KR); Samsung Display Co., Ltd., Yongin-si, Gyeonggi-do 17113 (KR)
(72) Inventor: YOON, Won Sik, 16678 Suwon-si (KR); TSUJI, Masashi, 16678 Suwon-si (KR); LEE, Jae Yong, 16678 Suwon-si (KR); CHA, Soonmin, 16678 Suwon-si (KR)
(74) Representative: Elkington and Fife LLP

(57) **Abstract**

A composition including a polymer having a structural unit (A) represented by Chemical Formula 1 and a compound represented by Chemical Formula 10 an electroluminescence device including a hole transport layer formed as a film from the composition, the film having excellent luminescence characteristics and high luminous efficiency:

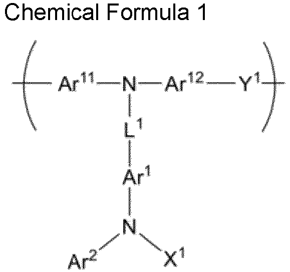

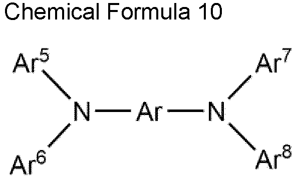

In Chemical Formulas 1 and 10, Ar, Ar¹, Ar², Ar⁵ to Ar⁸, Ar¹¹, Ar¹², L¹, X¹, and Y¹ are as described.

## Description

### FIELD OF THE INVENTION

A composition, a thin film fabricated from the composition, and an electroluminescence device including the thin film.

### BACKGROUND OF THE INVENTION

Research and development of electroluminescence devices (EL devices) are actively progressing. In particular, EL devices may be expected to be used as a solid light-emitting type large area full color display device or a writing light source array. An EL device is a light emitting device including a thin film having a thickness of several nanometers to several hundred nanometers between an anode and a cathode. The EL devices usually include a hole transport layer, a light emitting layer, an electron transport layer, or the like.

In many EL devices, the light emitting layer includes a fluorescent light emitting material and/or a phosphorescent light emitting material. The phosphorescent light emitting material is a material expected to have a higher luminous efficiency than the fluorescent light emitting material. In addition, phosphorescent light emitting materials should cover a wide color gamut, and an RGB light source requires an emission spectrum having a narrow full width at half maximum (FWHM). For example, although deep blue is of particular interest for blue, at present, there are no blue phosphorescent EL devices that have a commercially-sufficient life-span and satisfy the viewpoint of color purity.

As a method of solving the above technical problems, there is a light emitting device using "quantum dot" which is an inorganic light emitting material as a light emitting material (See, Patent Document 1). Quantum dots (QD) are semiconductor materials having crystal structures of several nanometers in size and are made up of hundreds to thousands of atoms. Because quantum dots are very small in size, a surface area per unit volume is large. For this reason, most of the atoms are present on the surface of the nanocrystals, and exhibit quantum confinement effects. Due to the quantum confinement effect, a quantum dot is able to adjust the emission wavelength by adjusting its size. Quantum dots have gained wide attention because characteristics such as improved color purity and high photoluminescence (PL) luminous efficiency can be achieved. A quantum dot electroluminescence device (QD LED) is a three-layered device including a hole transport layer, a quantum dot light emitting layer, and an electron transport layer.

In order to improve the characteristics of such quantum dot electroluminescence devices, techniques for improving the hole transport properties and hole injection properties of hole transport materials have been proposed. For example, Patent Document 2 proposes arylamine-fluorene alternating copolymer (polymeric compound) having a hydrocarbon group in the side chain as a hole transport material.
[Patent Document 1] Japanese Patent Laid-Open Publication No. 2010-199067
[Patent Document 2] Japanese Patent Laid-Open Publication No. 2021-138915

### SUMMARY OF THE INVENTION

An embodiment is to provide a composition for forming a hole transport layer, for example, a hole-transporting material having high resistance to a solvent used in the manufacture of a light-emitting layer of an electroluminescent device, for example, a quantum dot electroluminescent device, and consequently, a high film retention rate and excellent hole transport characteristics.

Another embodiment provides a thin film manufactured by using the composition.

Another embodiment provides an electroluminescent device including the thin film.

An embodiment provides a polymer including a structural unit (A) represented by Chemical Formula 1, and a compound represented by Chemical Formula 10:

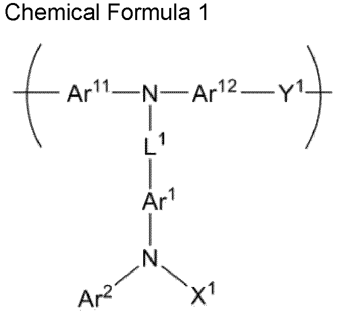

In Chemical Formula 1,
Ar¹¹ and Ar¹² are each independently a substituted or unsubstituted aromatic hydrocarbon group having 6 to 25 ring-forming atoms, wherein Ar¹¹ and Ar¹² are optionally linked to form a ring,
L¹ is a substituted or unsubstituted aromatic hydrocarbon group having 6 to 25 ring-forming atoms, or a substituted or unsubstituted heteroaromatic group having 5 to 25 ring-forming atoms,
Ar¹ is a substituted or unsubstituted aromatic hydrocarbon group having 6 to 25 ring-forming atoms,
Ar² is a substituted or unsubstituted aromatic hydrocarbon group having 6 to 25 ring-forming atoms, or a substituted or unsubstituted heteroaromatic group having 5 to 25 ring-forming atoms, and Ar² may optionally form a ring with Ar¹,
X¹ is a substituted or unsubstituted aromatic hydrocarbon group having 6 to 25 ring-forming atoms, or a substituted or unsubstituted heteroaromatic group having 5 to 25 ring-forming atoms, and
Y¹ is a group selected from an aromatic hydrocarbon group having 6 to 25 ring-forming atoms substituted with a thiol group-containing alkyl group having 1 to 14 carbon atoms, an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms, and a thiol group-containing alkoxyalkyl group having 2 to 14 carbon atoms;

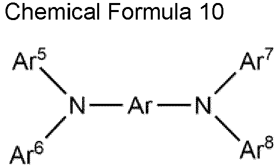

In Chemical Formula 10,
Ar and Ar⁵ to Ar⁸ are each independently a substituted or unsubstituted aromatic hydrocarbon group having 6 to 25 ring-forming atoms, a substituted or unsubstituted heteroaromatic ring group having 5 to 25 ring-forming atoms, or a combination thereof, wherein the aromatic hydrocarbon group and the heteroaromatic ring group include a single ring, a fused ring of two or more rings, a ring assembly in which the single ring and/or the fused ring are connected by a single bond,
Ar⁵ and Ar⁶, and/or Ar⁷ and Ar⁸, are, each independently optionally linked to form a ring, respectively,
at least two of Ar and Ar⁵ to Ar⁸ are each independently substituted by a C2 to C10 aliphatic hydrocarbon group containing a carbon-carbon double bond or a carbon-carbon triple bond, or a C3 to C10 alicyclic hydrocarbon group containing a carbon-carbon double bond or a carbon-carbon triple bond.

The structural unit (A) represented by Chemical Formula 1 may be represented by Chemical Formula 1-1:

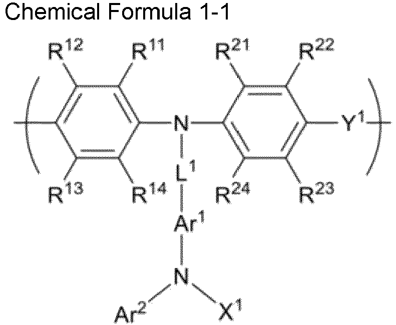

In Chemical Formula 1-1
R¹¹ to R¹⁴ and R²¹ to R²⁴ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R¹¹ and R²¹ may be joined to form a ring,
wherein L¹, Ar¹, Ar², X¹, and Y¹ are the same as defined in Chemical Formula 1.

The polymer may further include a structural unit (B) represented by Chemical Formula 2:

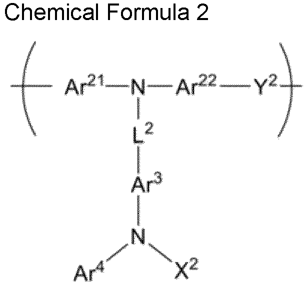

In Chemical Formula 2,
Ar²¹ and Ar²² are each independently a substituted or unsubstituted aromatic hydrocarbon group having 6 to 25 ring-forming atoms, wherein Ar²¹ and Ar²² are optionally linked to form a ring,
L² is a substituted or unsubstituted aromatic hydrocarbon group having 6 to 25 ring-forming atoms, or a substituted or unsubstituted heteroaromatic group having 5 to 25 ring-forming atoms,
Ar³ is a substituted or unsubstituted aromatic hydrocarbon group having 6 to 25 ring-forming atoms,
Ar⁴ is a substituted or unsubstituted aromatic hydrocarbon group having 6 to 25 ring-forming atoms, or a substituted or unsubstituted heteroaromatic group having 5 to 25 ring-forming atoms, and Ar⁴ may optionally form a ring with Ar³,
X² is a substituted or unsubstituted aromatic hydrocarbon group having 6 to 25 ring-forming atoms, or a substituted or unsubstituted heteroaromatic group having 5 to 25 ring-forming atoms,
Y² is an aromatic hydrocarbon group having 6 to 25 ring-forming atoms, substituted or unsubstituted with an alkyl group having 1 to 14 carbon atoms, and
Ar²¹, Ar²², L², Ar³, Ar⁴, and X² do not have a thiol group-containing alkyl group having 1 to 14 carbon atoms, and do not have a thiol group-containing alkoxyalkyl group having 2 to 14 carbon atoms.

The structural unit (B) represented by Chemical Formula 2 may be represented by Chemical Formula 2-1:

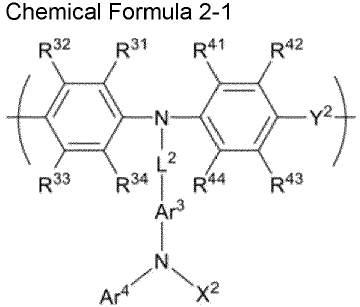

In Chemical Formula 2-1,
R³¹ to R³⁴ and R⁴¹ to R⁴⁴ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R³¹ and R⁴¹ may be optionally linked to form a ring,
wherein L², Ar³, Ar⁴, X², and Y² are the same as defined in Chemical Formula 2, and
R³¹ to R³⁴, R⁴¹ to R⁴⁴, L², Ar³, Ar⁴, and X² do not have a thiol group-containing alkyl group having 1 to 14 carbon atoms, and do not have a thiol group-containing alkoxyalkyl group having 2 to 14 carbon atoms.

In the polymer, the structural unit (A) may be included in an amount of greater than or equal to 1 mol% and less than or equal to 30 mol% based on a total number of moles of the structural unit (A) and the structural unit (B).

The thiol group-containing alkoxyalkyl group substituent of Y¹ of Chemical Formula 1 may be represented by Chemical Formula i-1, and the thiol group-containing alkyl group substituent of Y¹ of Chemical Formula 1 may be represented by Chemical Formula i-2:

Chemical Formula i-1, *-Z¹-O-Z²-SH

Chemical Formula i-2 *-Z¹-SH

In Chemical Formula i-1 and Chemical Formula i-2,
Z¹ is an alkylene group having 1 to 14 carbon atoms, which may be substituted or unsubstituted with a thiol group,
Z² is an alkylene group having 1 to 13 carbon atoms, which may be substituted or unsubstituted with a thiol group,
wherein, in Chemical Formula i-1, a sum of the carbon number of the alkylene group represented by Z¹ and the carbon number of the alkylene group represented by Z² is an integer of 14 or less, and
* is bonded to an aromatic hydrocarbon group having 6 to 25 ring-forming atoms of Y¹.

In Chemical Formula 1, Y¹ may be an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 10 carbon atoms.

The thiol group-containing alkoxyalkyl group may have two or more thiol groups.

In Chemical Formula 1, Y¹ may be represented by Chemical Formulae (3-1) to (3-6):

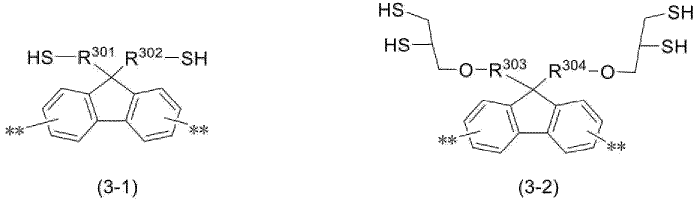

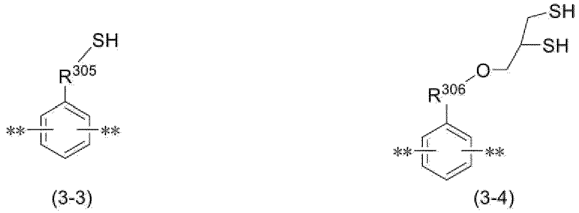

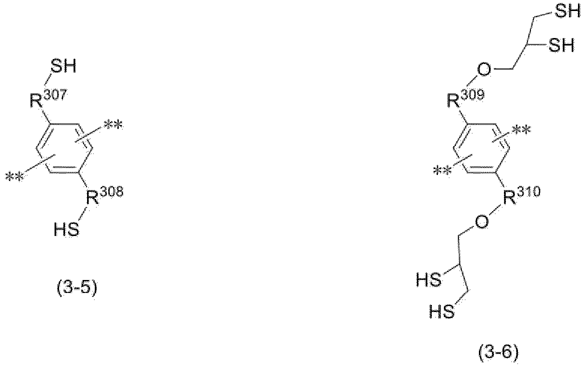

In Chemical Formulae (3-1) to (3-6),
R³⁰¹, R³⁰², R³⁰⁵, R³⁰⁷ and R³⁰⁸ are each independently a substituted or unsubstituted alkylene group having 1 to 14 carbon atoms,
R³⁰³, R³⁰⁴, R³⁰⁶, R³⁰⁹ and R³¹⁰ are each independently a substituted or unsubstituted alkylene group having 1 to 11 carbon atoms, and
one ** represents a connection to Ar¹² and the other ** indicates a connection to an adjacent structural unit.

In Chemical Formula 1, L¹ may be represented by any one of the groups represented by Chemical Formulae (4-1) to (4-24):

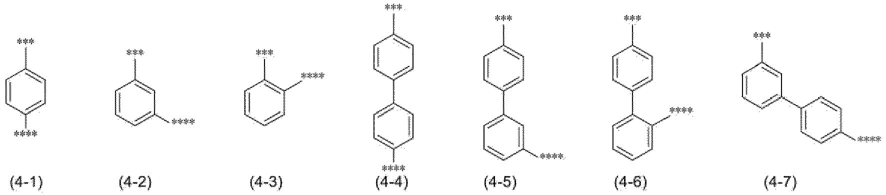

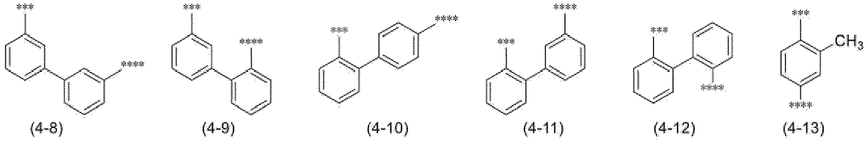

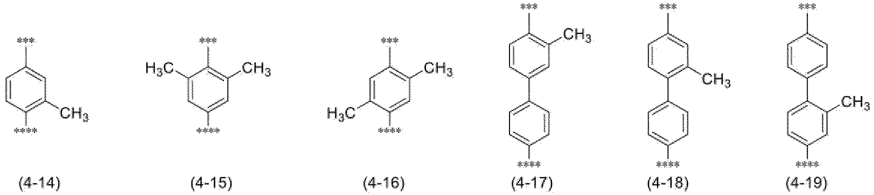

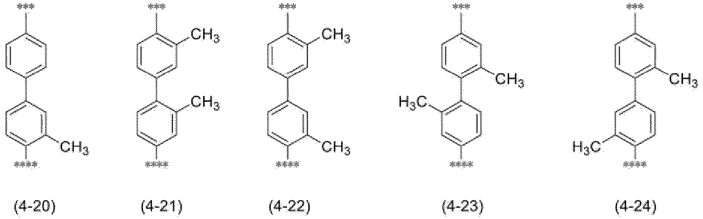

In Chemical Formulae (4-1) to (4-24),
*** indicates a connection to the nitrogen atom of Chemical Formula 1, and **** indicates a connection to Ar¹.

In Chemical Formula 1, -L¹-Ar¹-N(Ar²)(X¹) may be a group represented by Chemical Formulae (5-1), (5-2), or (5-3):

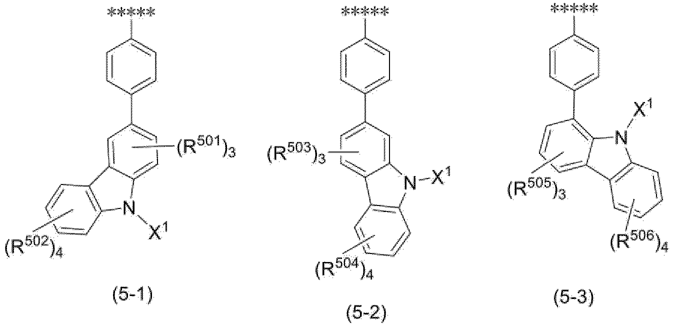

In Chemical Formulae (5-1), (5-2), or (5-3),
R⁵⁰¹ to R⁵⁰⁶ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom,
X¹ is the same as defined in Chemical Formula 1, and
***** indicates a connection to a nitrogen atom of Chemical Formula 1.

In Chemical Formula 10,
Ar and Ar⁵ to Ar⁸ are each independently a substituted or unsubstituted aromatic hydrocarbon group having 6 to 15 ring-forming atoms, a substituted or unsubstituted heteroaromatic ring group having 5 to 15 ring-forming atoms, or a combination thereof, wherein the aromatic hydrocarbon group and the heteroaromatic ring group include a single ring, a fused ring of two or more rings, a ring assembly in which the single ring and/or the fused ring are connected by a single bond,
Ar⁵ and Ar⁶, and/or Ar⁷ and Ar⁸, are, each independently optionally linked to form a ring, respectively, and
at least two of Ar⁵ to Ar⁸ are each independently substituted by a C2 to C5 aliphatic hydrocarbon group containing a carbon-carbon double bond or a carbon-carbon triple bond, or a C3 to C6 alicyclic hydrocarbon group containing a carbon-carbon double bond or a carbon-carbon triple bond.

In Chemical Formula 10,
Ar is a substituted or unsubstituted phenylene group, a substituted or unsubstituted pyridinylene group, a substituted or unsubstituted pyrimidylene group, a substituted or unsubstituted pyrazinylene group, a substituted or unsubstituted triazinylene group, a substituted or unsubstituted biphenylene group, or a combination thereof,
Ar⁵ to Ar⁸ are each independently a substituted or unsubstituted phenyl group, a substituted or unsubstituted biphenyl group, a substituted or unsubstituted naphthyl group, a substituted or unsubstituted anthracenyl group, a substituted or unsubstituted phenanthrenyl group, a substituted or unsubstituted acridinyl group, a substituted or unsubstituted pyridinyl group, or a combination thereof,
wherein Ar⁵ and Ar⁶, and/or Ar⁷ and Ar⁸, are, each independently optionally linked to form a substituted or unsubstituted carbazole ring, or a fused ring including an indole or a pyridine ring, wherein the indole and/or the pyridine ring is optionally substituted, and
one of Ar⁵ and Ar⁶, and one of Ar⁷ and Ar⁸, are each independently substituted with a C2 to C4 aliphatic hydrocarbon group including a carbon-carbon double bond or a carbon-carbon triple bond.

Chemical Formula 10 may be represented by Chemical Formula 10-1:

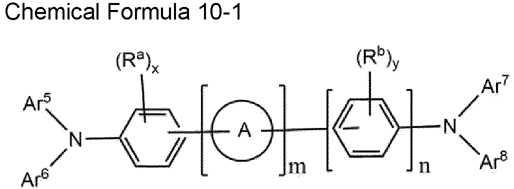

In Chemical Formula 10-1, 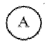
is a substituted or unsubstituted heteroaromatic ring group having 5 to 15 ring-forming atoms,
Ar⁵ to Ar⁸ are each independently the same as defined in Chemical Formula 10,
R^{a} and R^{b} are each independently, deuterium, a C1 to C10 alkyl group, a C2 to C10 alkenyl group, a C1 to C10 haloalkyl group, a halogen atom, a cyano group, a nitro group, or a combination thereof,
x and y are each independently an integer from 0 to 4, and
m and n are each independently an integer from 0 to 3.

The polymer represented by Chemical Formula 1 and the compound represented by Chemical Formula 10 each independently have a hole transport coefficient of greater than or equal to 10⁻⁵ cm²V⁻¹s⁻¹.

A thin film according to another embodiment may be fabricated by curing the composition according to an embodiment.

An electroluminescence device according to another embodiment includes a first electrode and a second electrode facing each other, a light-emitting layer disposed between the first electrode and the second electrode, and at least one organic film disposed between the first electrode and the light-emitting layer, wherein the at least one organic film comprises a thin film according to an embodiment.

The thin film may be a hole transport layer.

The at least one organic film includes two or more organic films, and the two or more organic films are hole injection layers disposed between the first electrode and the thin film.

The light-emitting layer may include semiconductor nanocrystal particles, a perovskite-type compound, or a combination thereof.

The composition according to an embodiment may have excellent hole transport properties and can be used as a composition for forming a hole transport layer of an electroluminescent device, for example, a quantum dot electroluminescent device. A thin film including a cured product of the composition may have excellent resistance to organic solvents in a composition for forming a light-emitting layer, for example, a light-emitting layer including quantum dots, when manufacturing an electroluminescent device, for example, a quantum dot electroluminescent device, and thus, may have a high film retention rate after forming the light-emitting layer. Therefore, the thin film may be advantageously used as a hole transport layer of an electroluminescent device, for example, a quantum dot electroluminescent device. In addition, as the thin film may be manufactured by heat-treating the composition at a low temperature, it may be easily disposed on another organic layer without damaging the already existing organic layers under the thin film. Therefore, the composition according to an embodiment may be advantageously applied to a hole transport layer of an electroluminescent device, for example, a quantum dot electroluminescent device, and the electroluminescent device including the hole transport layer may exhibit low driving voltage, high luminance, and high external quantum efficiency due to excellent and improved hole transport characteristics.

### BRIEF DESCRIPTION OF THE DRAWINGS

FIG. 1 is a schematic view showing an electroluminescence device according to an embodiment.
FIG. 2 is a plot (spectrum) showing extinction coefficient versus wavelength of the thin film prepared by heat-treating the composition according to Comparative Example 1 at 150°C, measured by using an ellipsometer before and after treating the thin film with cyclohexylbenzene.
FIG. 3 is a plot showing extinction coefficient versus wavelength of the thin film prepared by heat-treating the composition according to Comparative Example 1 at 190°C, measured by using an ellipsometer before and after treating the thin film with cyclohexylbenzene.
FIG. 4 is a plot showing extinction coefficient versus wavelength of the thin film prepared by heat-treating the composition according to Comparative Example 2 at 150°C, measured by using an ellipsometer before and after treating the thin film with cyclohexylbenzene.
FIG. 5 is a plot showing extinction coefficient versus wavelength of the thin film prepared by heat-treating the composition according to Comparative Example 2 at 190°C, measured by using an ellipsometer before and after treating the thin film with cyclohexylbenzene.
FIG. 6 is a plot showing extinction coefficient versus wavelength of the thin film prepared by heat-treating the composition according to Comparative Example 3 at 150°C, measured by using an ellipsometer before and after treating the thin film with cyclohexylbenzene.
FIG. 7 is a plot showing extinction coefficient versus wavelength of the thin film prepared by heat-treating the composition according to Comparative Example 3 at 190°C, measured by using an ellipsometer before and after treating the thin film with cyclohexylbenzene.
FIG. 8 is a plot showing extinction coefficient versus wavelength of the thin film prepared by heat-treating the composition according to Example 1 at 150°C, measured by using an ellipsometer before and after treating the thin film with cyclohexylbenzene.
FIG. 9 is a plot showing extinction coefficient versus wavelength of the thin film prepared by heat-treating the composition according to Example 1 at 190°C, measured by using an ellipsometer before and after treating the thin film with cyclohexylbenzene.
FIG. 10 is a plot showing extinction coefficient versus wavelength of the thin film prepared by heat-treating the composition according to Example 2 at 150°C, measured by using an ellipsometer before and after treating the thin film with cyclohexylbenzene.
FIG. 11 is a plot showing extinction coefficient versus wavelength of the thin film prepared by heat-treating the composition according to Example 2 at 190°C, measured by using an ellipsometer before and after treating the thin film with cyclohexylbenzene.
FIG. 12 shows plots of external quantum efficiencies (EQE) versus luminance of the comparative quantum dot electroluminescence devices 1 and 2 according to Comparative Synthesis Examples 1 and 2, respectively, and of the quantum dot electroluminescence devices 3 and 4 according to Synthesis Examples 2-3 and 2-4, respectively.
FIG. 13 shows plots of luminance versus hours of the comparative quantum dot electroluminescence devices 1 and 2 according to Comparative Synthesis Examples 1 and 2, respectively, and of the quantum dot electroluminescence devices 3 and 4 according to Synthesis Examples 2-3 and 2-4, respectively.

### DETAILED DESCRIPTION OF THE EMBODIMENTS

An embodiment provides a composition comprising a polymer including a structural unit (A) represented by Chemical Formula 1, and a compound represented by Chemical Formula 10:

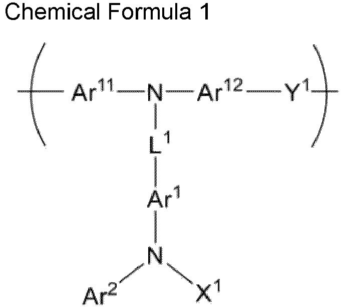

In Chemical Formula 1,
Ar¹¹ and Ar¹² are each independently a substituted or unsubstituted aromatic hydrocarbon group having 6 to 25 ring-forming atoms, whereinAr¹¹ and Ar¹² are optionally linked to form a ring,
L¹ is a substituted or unsubstituted aromatic hydrocarbon group having 6 to 25 ring-forming atoms, or a substituted or unsubstituted heteroaromatic group having 5 to 25 ring-forming atoms,
Ar¹ is a substituted or unsubstituted aromatic hydrocarbon group having 6 to 25 ring-forming atoms,
Ar² is a substituted or unsubstituted aromatic hydrocarbon group having 6 to 25 ring-forming atoms, or a substituted or unsubstituted heteroaromatic group having 5 to 25 ring-forming atoms, and Ar² may form a ring with Ar¹,
X¹ is a substituted or unsubstituted aromatic hydrocarbon group having 6 to 25 ring-forming atoms, or a substituted or unsubstituted heteroaromatic group having 5 to 25 ring-forming atoms, and
Y¹ is a group selected from an aromatic hydrocarbon group having 6 to 25 ring-forming atoms substituted with a thiol group-containing alkyl group having 1 to 14 carbon atoms, an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms, and a thiol group-containing alkoxyalkyl group having 2 to 14 carbon atoms;

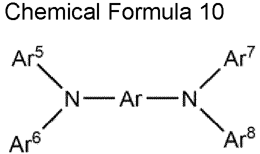

In Chemical Formula 10,
Ar and Ar⁵ to Ar⁸ are each independently a substituted or unsubstituted aromatic hydrocarbon group having 6 to 25 ring-forming atoms, a substituted or unsubstituted heteroaromatic ring group having 5 to 25 ring-forming atoms, or a combination thereof, wherein the aromatic hydrocarbon group and the heteroaromatic ring group include a single ring, a fused ring of two or more rings, a ring assembly in which the single ring and/or the fused ring are connected by a single bond,
Ar⁵ and Ar⁶, and/or Ar⁷ and Ar⁸, are each independently optionally linked to form a ring,
at least two of Ar and Ar⁵ to Ar⁸ are each independently substituted by a C2 to C10 aliphatic hydrocarbon group containing a carbon-carbon double bond or a carbon-carbon triple bond, or a C3 to C10 alicyclic hydrocarbon group containing a carbon-carbon double bond or a carbon-carbon triple bond.

In this specification, structural unit (A) represented by Chemical Formula 1 is at times referred to as "structural unit (A)" or "structural unit (A) according to an embodiment."

The structural unit (A) represented by Chemical Formula 1 includes unit portion X represented by the following structure:

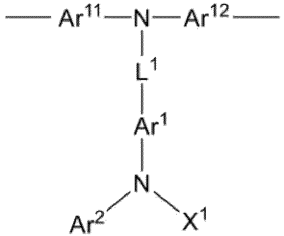

The structural unit (A) represented by Chemical Formula 1 also includes unit portion Y, which corresponds to the structure "-Y¹-" in Chemical Formula 1.

The polymeric compound having structural unit (A) represented by Chemical Formula 1 is at times referred to as "polymeric compound" or "polymeric compound according to an embodiment."

According to another embodiment, a thin film prepared by curing the composition according to an embodiment is provided.

According to another embodiment, an electroluminescence device including the thin film according to an embodiment is provided.

The electroluminescence device includes a first electrode and a second electrode facing each other, a light-emitting layer disposed between the first electrode and the second electrode, and at least one organic film disposed between the first electrode and the light-emitting layer, wherein the at least one organic film comprises a thin film according to an embodiment.

As used herein, the electroluminescence device is at times referred to as "LED."

The quantum dot electroluminescence device is at times referred to simply as "Q LEDs."

The perovskite electroluminescence devices are at times referred to as "PeLEDs."

Materials present in a light emitting layer or carrier transport layer of an electroluminescence device, include various low-molecular materials and polymeric materials. In some instances, low-molecular materials may be superior in terms of device efficiency and life-span than polymeric materials. However, when using low-molecular materials, there is a problem of high manufacturing costs because the device needs to be manufactured using a vacuum process. For example, polymeric materials, TFB of Patent Document 1 (e.g., paragraph "0037") and arylamine-fluorene alternating copolymer of Patent Document 2 are known as hole transport materials. However, the TFB of Patent Document 1 cannot be said to have sufficiently long durability (luminescence life-span), and the arylamine-fluorene alternating copolymer of Patent Document 2, though the polymer certainly exhibits excellent durability, the polymer cannot be said to have sufficient luminous efficiency and there are no technical options for improvement.

On the other hand, organic polymers or single molecules used in the hole transport layer during QLED production may have relatively low resistance to organic solvents included in the composition for preparing the light-emitting layer, e.g., QD inkjet compositions, and thus, the residual film properties after the light-emitting layer is prepared may be poor. Therefore, when forming a light-emitting layer including QDs on top of the hole transport layer using a solution process such as spin coating or inkjet coating, the types of solvents that can be used are limited. For example, in the case of inkjet coating, an organic aromatic solvent having a high boiling point is generally used, and in this case, a hole transport layer including a conventional hole transport organic polymer may exhibit a very low film retention rate after the formation of the light-emitting layer. If the hole transport layer is not formed thick enough to a desired thickness, it is difficult to implement the desired hole transport characteristics, and accordingly, it is difficult to expect the desired light-emitting characteristics or excellent light-emitting efficiency from the electroluminescent device.

In some instances, the film retention ratio may be increased by heat-treating a hole-transporting organic polymer at a high temperature of higher than about 200°C. However, it is known that when heat-treating at a high temperature of higher than about 200°C, the hole-injecting properties of a hole-injecting material, such as PEDOT:PSS, included in a hole-injecting layer disposed under the hole-transporting layer is likely to exhibit some degradation. Therefore, it is difficult to improve the film retention ratio of a hole-transporting layer by a high-temperature heat-treating method above 200°C. That is, if the composition for preparing a hole transport layer is cured at a low temperature of 200°C or less, so that the stability of the hole injection layer disposed can be maintained. Moreover, if the cured hole transport layer has high resistance to the organic solvent included in the composition for preparing a light-emitting layer disposed thereon so that the film retention rate is also high, it is expected that an electroluminescence device including the same may be guaranteed excellent hole injection and hole transport characteristics, and thus, may exhibit excellent light-emitting characteristics and high light-emitting efficiency under a low driving voltage.

The composition according to an embodiment comprises a polymer having a structural unit (A) represented by Chemical Formula 1 and a compound represented by Chemical Formula 10, so that when heat-treated at a low temperature, for example, a temperature of less than or equal to 200 °C, less than 195°C , or less than 190°C, a cross-linking bond may be formed between the polymer and the compound by a thiol-ene bonding reaction between a thiol group (-SH) included in the polymer and an unsaturated bond of a carbon-carbon double bond or a carbon-carbon triple bond included in the compound, as shown in the following reaction scheme:

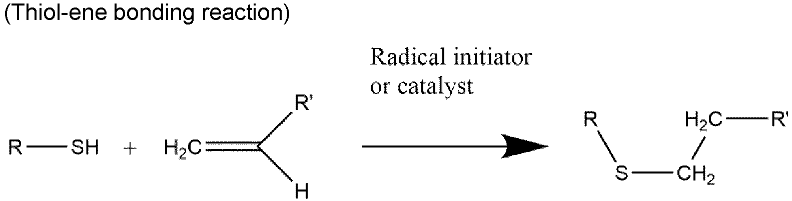

Accordingly, the composition may be formed into a thin film that includes a crosslinked product between the polymer and the compound by a low-temperature heat treatment, and the thin film may have significantly increased resistance to organic solvents compared to a thin film simply including an organic polymer or a low-molecular-weight compound. Accordingly, if a composition including an aromatic organic solvent such as an inkjet composition including a quantum dot is applied to form a light-emitting layer on the generated thin film, the probability of the thin film being partially dissolved in the organic solvent is reduced or minimized and a decrease in the film remaining ratio may be minimized or prevented. In addition, since the thiol-ene bonding reaction is carried out at a low temperature of less than or equal to 250 °C, it is possible to prevent deterioration of a layer disposed below the layer to which the composition is applied, for example, a hole injection layer.

Accordingly, the composition according to an embodiment may be advantageously applied as a hole transport layer of an electroluminescence device, and an electroluminescence device including a hole transport layer prepared from the composition may maintain excellent hole transport characteristics due to a high film retention rate of the hole transport layer. The electroluminescence device may also maintain excellent hole injection characteristics by preventing deterioration of the hole injection layer disposed under the hole transport layer. Therefore, an electroluminescence device including a hole transport layer prepared by applying the composition may achieve excellent luminescence characteristics and high luminescence efficiency while maintaining a low driving voltage.

Further, as the composition according to an embodiment may have excellent film-forming properties and solvent solubility, it may be formed into a film by a wet (coating) method. Accordingly, by using the composition according to an embodiment, which in turn makes it possible to enlarge the area of the electroluminescence device and achieve high productivity. The effects may further be advantageously exhibited when the composition according to an embodiment is applied as a hole transport layer of an electroluminescence (EL) device, for example, a hole transport layer of a quantum dot electroluminescence device (QLED).

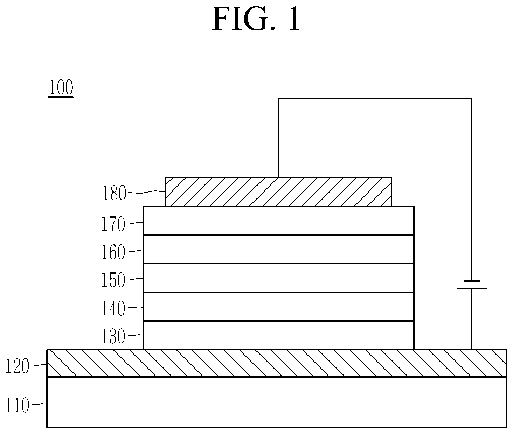

The present disclosure is not limited to the following embodiments. The drawing of Fig. 1 is exaggerated for better understanding and ease of description, and the dimensional ratio of each constituent element in the drawing may differ from an actual device. It will be understood that when an element is referred to as being "on" another element, it can be directly on the other element or intervening elements may be present therebetween. In contrast, when an element is referred to as being "directly on" another element, there are no intervening elements present.

The terminology used herein is for the purpose of describing particular embodiments only and is not intended to be limiting. As used herein, the singular forms "a," "an," and "the" are intended to include the plural forms, including "at least one," unless the content clearly indicates otherwise. Therefore, reference to "an" element in a claim followed by reference to "the" element is inclusive of one element as well as a plurality of the elements. "At least one" is not to be construed as limiting "a" or "an." "Or" means "and/or." As used herein, the term "and/or" includes any and all combinations of one or more of the associated listed items.

It will be further understood that the terms "comprise" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ±10% or ±5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

In this specification, unless otherwise specified, operation and physical properties are measured under the conditions of room temperature, such as, for example, 20°C or more and 25°C or less, and relative humidity (RH) of 40% or more and 50% or less.

In this specification, the number of ring-forming atoms refers to the number of atoms constituting the corresponding ring itself of the compound (e.g., monocyclic compound, condensed ring compound, crosslinked compound, carbocyclic compound, and heterocyclic compound) having a structure in which atoms are bonded in a ring (e.g., monocycle, condensed ring, ring assembly, etc.). Atoms that do not form a ring (e.g., a hydrogen atom that terminates the bond of the atoms forming a ring) or atoms included in a substituent, e.g., if a ring-forming atom includes a substituent are not included in the number of ring-forming atoms. The number of ring-forming atoms described below is assumed to be the same unless otherwise specified.

For example, a benzene ring has 6 ring-forming atoms, a naphthalene ring has 10 ring-forming atoms, a pyridine ring has 6 ring-forming atoms, and a furan ring has 5 ring-forming atoms.

When the benzene ring is substituted with a substituent, for example, an alkyl group, the number of carbon atoms of the alkyl group is not included in the number of ring-forming atoms of the benzene ring. Accordingly, the number of ring-forming atoms of the benzene ring substituted by the alkyl group is 6. In addition, when the naphthalene ring is substituted with an alkyl group as a substituent, for example, the number of atoms of the alkyl group is not included in the number of ring-forming atoms of the naphthalene ring. Accordingly, the number of ring-forming atoms of the naphthalene ring substituted by the alkyl group is 10.

For example, the number of hydrogen atoms bonded to the pyridine ring or the atoms constituting the substituent is not included in the number of ring-forming atoms of the pyridine ring. Accordingly, the number of ring-forming atoms of the pyridine ring to which the hydrogen atom or substituent is bonded is 6.

In the present specification, "the substituent represents a hydrogen atom" indicates that the structure in which the substituent exists is unsubstituted. For example, in Chemical Formula 1-1, when R¹¹ to R¹⁴ are all hydrogen atoms, it means that the benzene ring having R¹¹ to R¹⁴ is a p-phenylene group.

In the present specification, unless specifically defined, the term "substituted" refers to being substituted with an alkyl group, a cycloalkyl group, a hydroxyalkyl group, an alkoxy group, an alkoxyalkyl group, a cycloalkoxy group, an alkenyl group, an alkynyl group, a primary amino group (-NH₂), a secondary amino group -NH(R¹): R¹ is an alkyl group or an aryl group), a tertiary amino group (-N(R¹)(R²): R¹ and R² are each independently an alkyl group or an aryl group, and in this case, R¹ and R² may form a ring), an aryl group, an aryloxy group, an alkylthio group, a cycloalkylthio group, an arylthio group, an alkoxycarbonyl group, an aryloxycarbonyl group, a hydroxy group (-OH), a carboxyl group (-COOH), a thiol group (-SH), a cyano group (-CN), a halogen atom (a fluorine atom, a chlorine atom, a bromine atom, or an iodine atom), or a combination thereof. On the other hand, when a group is substituted, the form of the group which is included in the definition of a substituent does not include a form which has been further substituted with the group as a substituent. For example, when the substituent is an alkyl group, this alkyl group as a substituent is not further substituted with an alkyl group.

Herein, the alkyl group as the substituent may be either a linear or branched alkyl group, for example a linear alkyl group having 1 to 20 carbon atoms or a branched alkyl group having 3 to 20 carbon atoms. Specifically, the alkyl group may be a methyl group, an ethyl group, an n-propyl group, an isopropyl group, an n-butyl group, an isobutyl group, a sec-butyl group, a tert-butyl group, an n-pentyl group, an isopentyl group, a tert-pentyl group, a neopentyl group, a 1,2-dimethylpropyl group, an n-hexyl group, an isohexyl group, a 1,3-dimethylbutyl group, a 1-isopropylpropyl group, a 1,2-dimethylbutyl group, an n-heptyl group, a 1,4-dimethylpentyl group, a 3-ethylpentyl group, a 2-methyl-1-isopropylpropyl group, a 1-ethyl-3-methylbutyl group, an n-octyl group, a 2-ethylhexyl group, a 3-methyl-1-isopropylbutyl group, a 2-methyl-1-isopropylbutyl group, a 1-tert-butyl-2-methylpropyl group, an n-nonyl group, a 3,5,5-trimethylhexyl group, an n-decyl group, an isodecyl group, an n-undecyl group, a 1-methyldecyl group, an n-dodecyl group, an n-tridecyl group, an n-tetradecyl group, an n-pentadecyl group, an n-hexadecyl group, an n-heptadecyl group, an n-octadecyl group, an nonadecyl group, an icosyl group, and the like.

As the substituent, the cycloalkyl group may include for example, a cyclopropyl group, a cyclobutyl group, a cyclopentyl group, and a cyclohexyl group.

The hydroxyalkyl group may be, for example, an alkyl group that is substituted with 1 to 3 (e.g., 1 or 2, and for example 1) hydroxy groups (for example, hydroxymethyl group, hydroxyethyl group).

The alkoxy group as the substituent may be either a linear or branched alkoxy group, but desirably a linear alkoxy group having 1 to 20 carbon atoms or a branched alkoxy group having 3 to 20 carbon atoms. For example, the alkoxy group may be, for example, a methoxy group, an ethoxy group, a propoxy group, an isopropoxy group, a butoxy group, a pentyloxy group, a hexyloxy group, a heptyloxy group, an octyloxy group, a nonyloxy group, a decyloxy group, an undecyloxy group, a dodecyloxy group, a tridecyloxy group, a tetradecyloxy group, a pentadecyloxy group, a hexadecyloxy group, a heptadecyloxy group, an octadecyloxy group, a 2-ethylhexyloxy group, a 3-ethylpentyloxy group, and the like.

The hydroxyalkyl group may be, for example, an alkyl group that is substituted with 1 to 3 (e.g., 1 or 2, and for example 1) hydroxy groups (for example, hydroxymethyl group, hydroxyethyl group).

The cycloalkoxy group as a substituent may be, for example, a cyclopropyl oxy group, a cyclobutyl oxy group, a cyclopentyl oxy group, a cyclohexyl oxy group, and the like.

The alkenyl group as a substituent may include, for example, a vinyl group, an allyl group, a 1-propenyl group, an isopropenyl group, a 1-butenyl group, a 2-butenyl group, a 3-butenyl group, a 1-pentenyl group, a 2-pentenyl group, a 3-pentenyl group , a 1-hexenyl group, a 2-hexenyl group, a 3-hexenyl group, a 1-heptenyl group, a 2-heptenyl group, a 5-heptenyl group, a 1-octenyl group, a 3-octenyl group, a 5-octenyl group, and the like.

The alkynyl group as a substituent may include, for example, an acetylenyl group, a 1-propynyl group, a 2-propynyl group, a 1-butynyl group, a 2-butynyl group, a 3-butynyl group, a 1-pentetyl group, a 2-pentetyl group, a 3-pentetyl group , 1-hexynyl group, a 2-hexynyl group, a 3-hexynyl group, a 1-heptinyl group, a 2-heptinyl group, a 5-heptinyl group, a 1-octynyl group, a 3-octynyl group, a 5-octynyl group, and the like.

The secondary amino groups as a substituent may include, for example, an alkylamino group having 1 to 10 carbon atoms such as a methylamino group, an ethylamino group, an n-propylamino group, an n-butylamino group, an isobutylamino group, and the like, and a monoarylamino group such as a monophenylamino group, a mononaphthylamino group, and the like.

The tertiary amino group as a substituent may include, for example, a dialkylamino group having 2 to 20 carbon atoms, such as a dimethylamino group, a diethylamino group, a di-n-propylamino group, a di-n-butylamino group, and a methylethylamino group, and a diarylamino group, such as a diphenylamino group and a dinaphthylamino group.

The aryl group as a substituent may be an aryl group having 6 to 30 ring-forming atoms (carbon atoms) may be exemplified. Examples may include a phenyl group, a naphthyl group, a biphenyl group, a fluorenyl group, anthryl group, a pyrenyl group, an azulenyl group, an acenaphthylenyl group, a diphenyl group, and a phenanthryl group.

Examples of the aryloxy group as a substituent may include a phenoxy groups and a naphthyloxy group.

Examples of the alkylthio group as a substituent may include a methylthio group, an ethylthio group, a propylthio group, a pentylthio group, a hexylthio group, an octylthio group, and a dodecylthio group.

Examples of the cycloalkylthio group as a substituent may include a cyclopentylthio group, a cyclohexylthio group, etc.

Examples of the arylthio group as a substituent may include a phenylthio group and a naphthylthio group.

Examples of the alkoxycarbonyl group as a substituent may include a methyloxycarbonyl group, an ethyloxycarbonyl group, a butyloxycarbonyl group, an octyloxycarbonyl group, and a dodecyloxycarbonyl group.

Examples of aryloxycarbonyl groups as a substituent may include a phenyloxycarbonyl group and a naphthyloxycarbonyl group.

The term "aromatic hydrocarbon group" refers to a hydrocarbon having an aromatic ring and includes monocyclic and polycyclic hydrocarbons wherein the additional ring(s) of the polycyclic hydrocarbon may be aromatic or nonaromatic.

The term "heteroaromatic group" refers to an aromatic ring and includes monocyclic and polycyclic ring systems wherein one to three aromatic ring atoms is selected from N, O, S, Si, and P, and additional ring(s) of the polycyclic ring system may be aromatic or nonaromatic.

The polymer and compound included in the composition according to an embodiment are described in detail below.

### Polymer

### Structural unit (A)

The polymer included in the composition according to an embodiment includes a structural unit (A) represented by Chemical Formula 1. The polymer includes two or more structural units (A) in the polymer, that is, the structural unit (A) represented by Chemical Formula 1 may be a repeating unit. The polymer having a structural unit (A) has excellent hole injection properties and may improve the durability (luminescence life-span) of an electroluminescence device, e.g., an electroluminescence device including quantum dots. In addition, high current efficiency and low driving voltage may be achieved, and/or luminous efficiency may be improved. The polymer may include only one type of structural unit (A) or may include two or more different types of structural units (A). The plurality of structural units (A) may exist in a block form, a random form, an alternating form, or a periodic form.

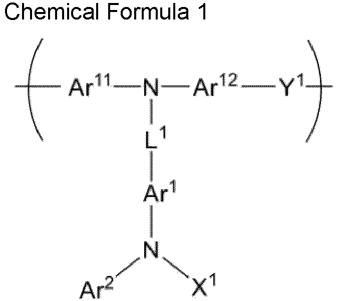

The structural unit A of Chemical Formula 1 includes a unit portion X formed by a nitrogen atom being sandwiched between the two aromatic hydrocarbon groups Ar¹¹ and Ar¹², and a unit portion Y represented by Y¹. In other words, the polymer may be referred to as a copolymer including a portion unit X and a portion unit Y both of which form a repeat unit of the copolymer.

In Chemical Formula 1, Y¹ may be a group selected from an aromatic hydrocarbon group having 6 to 25 ring-forming atoms substituted with a thiol group-containing alkyl group having 1 to 14 carbon atoms, an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms and a thiol group-containing alkoxyalkyl group having 2 to 14 carbon atoms.

In structural unit (A), Y¹ may have a thiol group-containing alkyl group having 1 to 14 carbon atoms (an alkyl group having 1 to 14 carbon atoms having a thiol group), or a thiol group-containing alkoxyalkyl group having 2 to 14 carbon atoms (an alkoxyalkyl group having 2 to 14 carbon atoms having a thiol group). In addition, Y¹ may have both a thiol group-containing alkyl group having 1 to 14 carbon atoms and a thiol group-containing alkoxyalkyl group having 2 to 14 carbon atoms.

For brevity, a thiol group-containing alkyl group having 1 to 14 carbon atoms is at times referred to as a "thiol group-containing alkyl group" or simply as a "substituent (a)."

For brevity, a thiol group-containing alkoxyalkyl group having 2 to 14 carbon atoms is at times referred to as a "thiol group-containing alkoxyalkyl group" or simply as a "substituent (b)."

Y¹ may have at least one of thiol group-containing alkyl group (substituent (a)) and thiol group-containing alkoxyalkyl group (substituent (b)). Y¹ may have both a thiol group-containing alkyl group (substituent (a)) and a thiol group-containing alkoxyalkyl group (substituent (b)). Y¹ may have two or more substituents (a) or may have two or more substituents (b). If only a substituent (a) is included in one Y¹, and if only a substituent (b) is included in one Y¹, the upper limit of the number of substituents (a) or substituents (b) included in one Y¹ is not particularly limited, but may be, for example, 6 or less, and for example, 4 or less. If both substituent (a) and substituent (b) are included in one Y¹, the sum of the numbers of substituents (a) and substituents (b) included in one Y¹ may be 2 or more. Moreover, the upper limit of the sum of the numbers of substituents (a) and substituents (b) is not particularly limited, but may be, for example, 6 or less, and for example, 4 or less.

If Y¹ has two or more substituents (a), the structures of the substituents (a) may be the same or different. Similarly, If Y¹ has two or more substituents (b), the structures of the substituents (b) may be the same or different.

According to an embodiment, the alkyl group having 1 to 14 carbon atoms included in the thiol group-containing alkyl group (substituent (a)) may be a linear or branched alkyl group, and examples thereof may include a methyl group, an ethyl group, an n-propyl group, an isopropyl group, an n-butyl group, an isobutyl group, a sec-butyl group, a tert-butyl group, an n-pentyl group, an isopentyl group, a tert-pentyl group, a neopentyl group, a 1,2-dimethylpropyl group, an n-hexyl group, an isohexyl group, a 1,3-dimethylbutyl group, a 1-isopropylpropyl group, a 1,2-dimethylbutyl group, an n-heptylbutyl group, a 1,4-dimethylpentyl group, a 3-ethylpentyl group, a 2-methyl-1-isopropylpropyl group, a 1-ethyl-3-methylbutyl group, an n-octyl group, a 2-ethylhexyl group, a 3-methyl-1-isopropylbutyl group, a 2-methyl-1-isopropylbutyl group, a 1-tert-butyl-2-methylpropyl group, an n-nonyl group, a 3,5,5-trimethylhexyl group, an n-decyl group, an isodecyl group, an n-undecyl group, a 1-methyldecyl group, an n-dodecyl group, an n-tridecyl group, an n-tetradecyl group, etc.

The alkoxyalkyl group having 2 to 14 carbon atoms included in the thiol group-containing alkoxyalkyl group (substituent (b)) is a linear or branched alkyl group alkoxyalkyl group. As a substituent (b), an alkyl group having 1 to 13 carbon atoms may be a group substituted with 1 to 3 (for example, 1 to 2, for example, 1) alkoxy groups having 1 to 13 carbon atoms (at this time, the sum of the carbon numbers of the alkyl group and the carbon numbers of the alkoxy group is 2 to 14). Specific examples of the alkyl group include those of the substituent (a) having 13 or fewer carbon atoms. Specific examples of the alkoxy group include those having 1 to 13 carbon atoms among the specific examples of the alkoxy group as the substituent.

Accordingly, examples of the alkoxyalkyl group having 2 to 14 carbon atoms included in the substituent (b) may include a methoxymethyl group, an ethoxymethyl group, a methoxyethyl group, an ethoxyethyl group, a propoxyethyl group, a butoxyethyl group, a methoxypropyl group, an ethoxypropyl group, a propoxypropyl group, a butoxypropyl group, a methoxybutyl group, an ethoxybutyl group, a propoxybutyl group, a butoxybutyl group, a methoxypentyl group, an ethoxypentyl group, a propoxypentyl group, a butoxypentyl group, a methoxyhexyl group, an ethoxyhexyl group, a propoxyhexyl group, a butoxyhexyl group, a methoxyheptyl group, an ethoxyheptyl group, a propoxyheptyl group, a butoxyheptyl group, and the like.

In addition, to further improve electroluminescence device durability (e.g., luminescence life-span), Y¹ in Chemical Formula 1 may include a substituent (b). For example, Y¹ in Chemical Formula 1 may be an aromatic hydrocarbon group having 6 to 25 ring-forming atoms, substituted with a thiol group-containing alkoxyalkyl group including 2 to 14 carbon atoms. Y¹ may be an aromatic hydrocarbon group having 6 to 25 ring-forming atoms substituted with a thiol group-containing alkoxyalkyl group including 2 to 10 carbon atoms. The number of carbon atoms in the thiol group-containing alkoxyalkyl group means the sum of the number of carbon atoms constituting the alkoxy group and the alkyl group constituting the group. In a form where Y¹ includes a substituent (b), the number of thiol groups included in the substituent (b) may be 1 or more, e.g., may be 2 or more. Accordingly, in an embodiment, the substituent (b) (thiol group-containing alkoxyalkyl group) may have one or more thiol groups. For example, substituent (b) may have two or more thiol groups. The upper limit of the number of thiol groups included in the substituent (b) is not particularly limited and may be 4 or less.

To further improve upon luminous efficiency, Y¹ in Chemical Formula 1 may include a substituent (a). Accordingly, Y¹ in Chemical Formula 1 may be an aromatic hydrocarbon group having 6 to 25 ring-forming atoms substituted with a thiol group-containing alkyl group having 1 to 14 carbon atoms. Y¹ may be an aromatic hydrocarbon group having 6 to 25 ring-forming atoms substituted with a thiol group-containing alkyl group having 1 to 10 carbon atoms. In a form where Y¹ includes a substituent (a), the number of thiol groups included in the substituent (a) may be 1 or more, e.g., may be 2 or more. Accordingly, in an embodiment, the substituent (a) (thiol group-containing alkyl group) may have one thiol group. In another embodiment, substituent (a) may have two or more thiol groups. The upper limit of the number of thiol groups included in the substituent (a) is not particularly limited but may be 4 or less.

To further improve the balance between durability and luminous efficiency in a device, or ensuring that the glass transition temperature (Tg) of the polymer is within an appropriate range or that good thermal stability can be maintained, the alkyl group (in the case of the substituent (b), an alkyl group moiety bonded to an aromatic hydrocarbon group excluding an alkoxy group (-OR)) included in each of the substituent (a) or the substituent (b) may have 1 or more and 12 or less carbon atoms, for example, 1 or more and 10 or less, for example, 2 or more and 8 or less, or 4 or more and 8 or less, for example, 6. By setting the carbon number of the alkyl group constituting the substituent (a) or the alkyl group constituting the substituent (b) within the above ranges, the solvent solubility may be excellent and the film-forming property may be improved when forming a film using a wet (coating) method.

The alkoxy group included in the substituent (b) may have 1 to 10 carbon atoms, for example, 1 to 8 carbon atoms, 1 to 6 carbon atoms, 2 to 4 carbon atoms, for example, 3 carbon atoms.

The alkyl group included in the substituent (a) or the substituent (b) (the alkyl group constituting the substituent (a) or the substituent (b)) may be linear from the viewpoint of improving durability and luminous efficiency in a better balance. Moreover, the alkoxy group included in the substituent (b) (the alkoxy group constituting the substituent (b)) may be linear.

In substituent (a) or substituent (b), the substitution position of the thiol group is not particularly limited, but, for example, substituent (a) or substituent (b) may have a thiol group at the terminal end of the substituent. In this case, the polymer may more easily form a thiol-ene cross-linking bond with the carbon-carbon unsaturated bond group of the compound represented by Chemical Formula 10 in the composition according to an embodiment.

The thiol group-containing alkyl group (substituent (a)) or the thiol group-containing alkoxyalkyl group (substituent (b)) may have a structure represented by Chemical Formula i:

Chemical Formula i *-Z¹-(O-Z²)n-SH

In Chemical Formula i, Z¹ represents an alkylene group having 1 to 14 carbon atoms, which is unsubstituted or substituted with a thiol group, n is 0 or 1, and when n is 1, Z² represents an alkylene group having 1 to 13 carbon atoms, which is unsubstituted or substituted with a thiol group, and the sum of the carbon numbers of the alkylene group represented by Z¹ and the carbon numbers of the alkylene group represented by Z² is an integer of 14 or less (in other words, n is 0 or 1, and when n is 0, Z¹ represents an alkylene group having 1 to 14 carbon atoms, which is substituted or unsubstituted with a thiol group; and when n is 1, Z¹ represents an alkylene group having 1 to 13 carbon atoms, which is substituted or unsubstituted with a thiol group, Z² represents an alkylene group having 1 to 13 carbon atoms, which is substituted or unsubstituted with a thiol group, and the sum of the carbon numbers of the alkylene group represented by Z¹ and the carbon numbers of the alkylene group represented by Z2 is an integer of 14 or less), and * is bonded to the aromatic hydrocarbon group having 6 to 25 ring-forming atoms. In some instances, a group having a structure represented by Chemical Formula i is simply referred to as a "substituent (i)."

In order for the polymer to more easily form a thiol-ene cross-linking bond with the compound represented by Chemical Formula 10, the alkylene group having 1 to 14 carbon atoms as Z¹ is a linear or branched alkylene group, and may be substituted with a thiol group. Examples of alkylene groups as Z¹ include a methylene group, an ethylene group, an n-propylene group (a trimethylene group), an iso-propylene group (a 1,1-dimethylmethylene group), an n-butylene group, an isobutylene group, a sec-butylene group, a tert-butylene group, an n-pentylene group, an isopentylene group, a tert-pentylene group, a neopentylene group, a 1,2-dimethylpropylene group, an n-hexylene group, an isohexylene group, a 1,3-dimethylbutylene group, a 1-isopropylpropylene group, a 1,2-dimethylbutylene group, an n-heptylene group, a 1,4-dimethylpentylene group, a 3-ethylpentylene group, a 2-methyl-1-isopropylpropylene group, a 1-ethyl-3-methylbutylene group, an n-octylene group, a 2-ethylhexylene group, a 3-methyl-1-isopropylbutylene group, a 2-methyl-1-isopropylbutylene group, a 1-tert-butyl-2-methylpropylene group, an n-nonylene group, a 3,5,5-trimethylhexylene group, an n-decylene group, an isodecylene group, an n-undecylene group, a 1-methyldecylene group, an n-dodecylene group, an n-tridecylene group, and an n-tetradecylene group.

The carbon number of the alkylene group as Z¹ may be 1 or more and 12 or less, for example, 1 or more and 10 or less, 2 or more and 8 or less, 4 or more and 8 or less, for example, 6 carbons.

The alkylene group as Z¹ may be linear, and thus, the polymer may more easily form a thiol-ene cross-linking bond with the compound represented by Chemical Formula 10.

As described in detail below, the composition according to an embodiment may be formed into a film by a coating method. However, to further improve the film-forming properties and form a uniform film, thereby improving electroluminescence device durability (e.g., luminescence life-span), the alkylene group constituting Z¹ may be unsubstituted.

Moreover, to further improve durability (e.g., luminescence life-span), in Chemical Formula i, n may be 1, i.e., [O-Z²] is present. Accordingly, in an embodiment, the thiol group-containing alkoxyalkyl group may have a structure represented by Chemical Formula i-1:

Chemical Formula i-1 *-Z¹-O-Z²-SH

In Chemical Formula i-1, Z¹ represents an alkylene group having 1 to 13 carbon atoms, substituted or unsubstituted with a thiol group, Z² represents an alkylene group unsubstituted or substituted with a thiol group and having 1 to 13 carbon atoms, the sum of the carbon numbers of the alkylene group represented by Z¹ and the carbon numbers of the alkylene group represented by Z² is an integer of 14 or less, and * is bonded to an aromatic hydrocarbon group having 6 to 25 ring-forming atoms. A group having a structure represented by Chemical Formula i-1 may be simply referred to as a "substituent (i-1)."

In Chemical Formula i, when n is 1 (the substituent (b) has a structure represented by Chemical Formula i-1), the alkylene group having 1 to 13 carbon atoms as Z² may be a linear or branched alkylene group, and may be substituted with a thiol group. Examples of alkylene groups as Z², are among the specific examples of alkylene groups as Z¹, those having 1 to 13 carbon atoms may be cited.

The carbon number of the alkylene group as Z² may be 1 or more and 10 or less, for example, 1 or more and 8 or less, for example, 1 or more and 6 or less, 2 or more and 4 or less, for example, 3.

The sum of the carbon number of the alkylene group represented by Z¹ and the carbon number of the alkylene group represented by Z² may be 2 or more and 12 or less, for example, 2 or more and 10 or less, 4 or more and 10 or less, for example, 6 or more and 9 or less.

The alkylene group as Z² may be linear from the viewpoint of better forming a thiol-ene cross-linking bond with the compound represented by Chemical Formula 10.

In addition, in order for the polymer to more easily form a thiol-ene cross-linking bond with the compound represented by Chemical Formula 10, the alkylene group as Z² may be substituted with a thiol group, that is, in Chemical Formula i, when n is 1 (the substituent (b) has a structure represented by Chemical Formula i-1), the substituent (i-1) may have two or more thiol groups. The upper limit of the number of thiol groups included in the above substituent (i-1) is not particularly limited but may be 4 or less.

In Chemical Formula i-1, an exemplary form of Z¹ may be referred to from the description of Z¹ in Chemical Formula i.

To further improve luminous efficiency, n in Chemical Formula i may be 0, i.e., [O-Z²] may be absent. That is, in an embodiment, the thiol group-containing alkyl group may have a structure represented by Chemical Formula i-2:

Chemical Formula i-2 *-Z¹-SH

In Chemical Formula i-2, Z¹ represents an alkylene group having 1 to 14 carbon atoms, unsubstituted or substituted with a thiol group, and * is bonded to an aromatic hydrocarbon group having 6 to 25 ring-forming atoms constituting Y¹. A group having a structure represented by Chemical Formula i-2 may be simply referred to as a "substituent (i-2)."

In Chemical Formula i-2, an exemplary form of Z¹ may be referred to from the description of Z¹ in Chemical Formula i.

The thiol group-containing alkyl group (substituent (a)) or the thiol group-containing alkoxyalkyl group (substituent (b)), i.e., substituent (i), according to an embodiment may be in the following form: in Chemical Formula i-1, Z¹ represents an alkylene group unsubstituted or substituted with a thiol group and having 1 to 10 carbon atoms, Z² represents an alkylene group unsubstituted or substituted with a thiol group and having 1 to 8 carbon atoms, and the sum of the carbon numbers of the alkylene group represented by Z¹ and the carbon numbers of the alkylene group represented by Z² is an integer of 2 to 12, or, in Chemical Formula i-2, Z¹ is an alkylene group unsubstituted or substituted with a thiol group and having 1 to 10 carbon atoms;

in another embodiment, in Chemical Formula i-1, Z¹ represents an alkylene group having 2 to 8 carbon atoms which is unsubstituted or substituted with a thiol group, Z² represents an alkylene group having 1 to 6 carbon atoms which is unsubstituted or substituted with a thiol group, and the sum of the carbon numbers of the alkylene group represented by Z¹ and the carbon numbers of the alkylene group represented by Z² is an integer of 3 to 10, or, in Chemical Formula i-2, Z¹ represents an alkylene group having 2 to 8 carbon atoms which is unsubstituted or substituted with a thiol group; and

in another embodiment, in Chemical Formula i-1, Z¹ represents an alkylene group having 4 to 8 carbon atoms which is unsubstituted or substituted with a thiol group, Z² represents an alkylene group having 2 to 4 carbon atoms which is unsubstituted or substituted with a thiol group, and the sum of the carbon numbers of the alkylene group represented by Z¹ and the carbon numbers of the alkylene group represented by Z² is an integer of 6 to 10, or, in Chemical Formula i-2, Z¹ represents an alkylene group having 4 to 8 carbon atoms which is unsubstituted or substituted with a thiol group.

In each of the above embodiments, both the alkylene group represented by Z¹ and the alkylene group represented by Z² may be linear.

One or more, or two or more, substituent (i) may be included in Y¹ and, the upper limit of the number of substituents (i) included in Y¹ is not particularly limited, but may be, for example, 6 or less, for example, 4 or less. If having two or more substituents (i), the structures of the substituents (i) may be the same or different. Therefore, in an embodiment, Y¹ has 2 or more and 6 or less (e.g., 4 or less) substituents (i-1), and the structures of the substituents (i-1) may be the same as each other. In another embodiment, Y¹ has 2 or more and 6 or less (e.g., 4 or less) substituents (i-2), and the structures of the substituents (i-2) may be the same as each other.

In Chemical Formula 1, Y¹ represents a group selected from an aromatic hydrocarbon group having 6 to 25 ring-forming atoms substituted with the substituent (a), an aromatic hydrocarbon group having 6 to 25 ring-forming atoms substituted with the substituent (b), and an aromatic hydrocarbon group having 6 to 25 ring-forming atoms substituted with the substituent (a) and the substituent (b).

Here, as an aromatic hydrocarbon group having 6 to 25 ring-forming atoms, examples thereof may include groups derived from aromatic hydrocarbons such as benzene, naphthalene, anthracene, pyrene, pentalene, indene, azulene, heptalene, acenaphthene, phenalene, phenanthrene, biphenyl, terphenyl, tetraphenyl, fluorene, or 9,9'-spirobi[fluorene.

Among these, the aromatic hydrocarbon group included in Y¹ may be a group derived from benzene or fluorene (e.g., a phenylene group or a fluorenylene group).

In an embodiment, in Chemical Formula 1, Y¹ may be any one of the groups represented by Chemical Formulas (Y-1) to (Y-3).

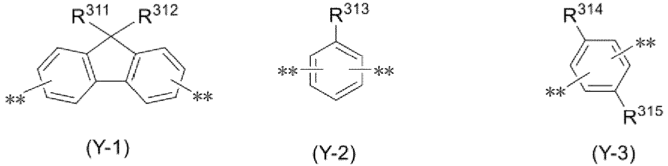

In Chemical Formulas (Y-1) to (Y-3), R³¹¹ to R³¹⁵ are each independently a group having a structure represented by Chemical Formula i (substituent (i)), and ** represents a bonding site. Exemplary forms of the substituent (i) included in Chemical Formulas (Y-1) to (Y-3) refer to the description of the substituent (i), and for example, the substituent (i) may be a substituent (i-1) or a substituent (i-2). In Chemical Formulas (Y-1) and (Y-3), R³¹¹ and R³¹², or R³¹⁴ and R³¹⁵ may be the same or different, respectively, but R³¹¹ and R³¹², and R³¹⁴ and R³¹⁵ may be the same as each other. One ** indicates a connection to Ar¹² and the other ** indicates a connection to an adjacent structural unit. For example, Y¹ may be a group represented by Chemical Formula (Y-1).

In another embodiment, from the viewpoint of improving electroluminescence device durability (e.g., luminescence life-span) and luminous efficiency with a better balance when applied to the electroluminescence device, in Chemical Formula 1, Y¹ may be any one of the groups represented by Chemical Formulas (3-1) to (3-6):

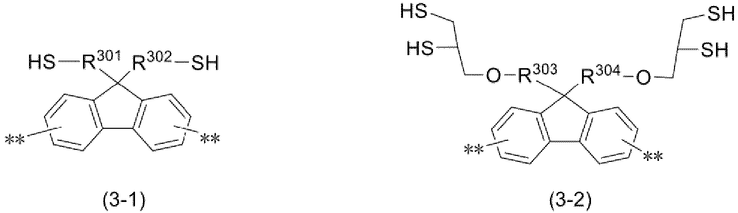

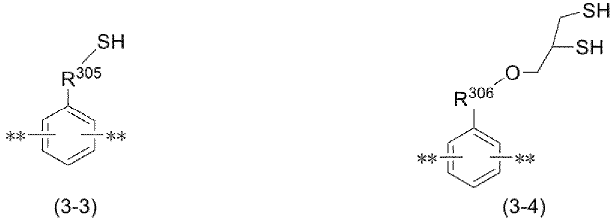

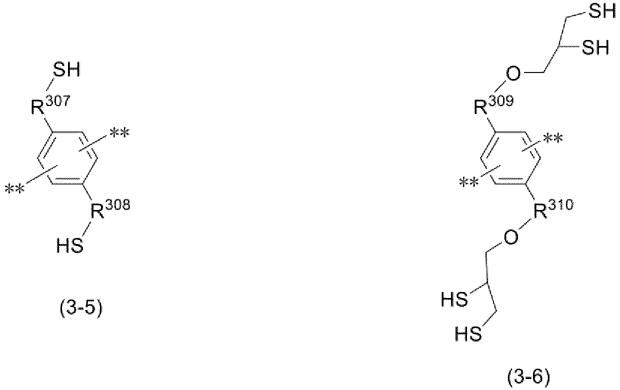

In Chemical Formulas (3-1) to (3-6), R³⁰¹, R³⁰², R³⁰⁵, R³⁰⁷ and R³⁰⁸ are each independently a substituted or unsubstituted alkylene group having 1 to 14 carbon atoms, R³⁰³, R³⁰⁴, R³⁰⁶, R³⁰⁹ and R³¹⁰ are each independently a substituted or unsubstituted alkylene group having 1 to 11 carbon atoms, and ** represents a connection to Ar¹² and the other ** indicates a connection to an adjacent structural unit.

In addition, in Chemical Formulas (3-1), (3-2), (3-5), and (3-6), R³⁰¹ and R³⁰², R³⁰³ and R³⁰⁴, R³⁰⁷ and R³⁰⁸, or R³⁰⁹ and R³¹⁰ may be the same or different, respectively. R³⁰¹ and R³⁰², R³⁰³ and R³⁰⁴, R³⁰⁷ and R³⁰⁸, and R³⁰⁹ and R³¹⁰ may be the same as each other.

The alkylene group having 1 to 14 carbon atoms (or 1 to 11 carbon atoms) as R³⁰¹ to R³¹⁰ is not particularly limited, but is a linear or branched alkylene group, and specific examples thereof include the same alkylene groups having 1 to 14 carbon atoms, for example, 11 or less carbon atoms, as described for Z¹ in Chemical Formula i.

The alkylene group as R³⁰¹ to R³¹⁰ may have 1 to 10 carbon atoms, for example, 1 to 8 carbon atoms, for example, 2 to 8 carbon atoms, for example, 4 to 8 carbon atoms, for example, 6 carbon atoms, from the viewpoint of improving durability (e.g., luminescence life-span) and luminous efficiency with a better balance.

Additionally, from the same viewpoint as above, the alkylene groups as R³⁰¹ to R³¹⁰ may be linear.

In Chemical Formula 1, Y¹ may be a group represented by Chemical Formula (3-1) or (3-2). For further improving durability (e.g., luminescence life-span), Y¹ may be a group represented by Chemical Formula (3-2). For further improving luminous efficiency, Y¹ may be a group represented by Chemical Formula (3-1).

In Chemical Formula 1, Ar¹¹ and Ar¹² may each independently represent a substituted or unsubstituted aromatic hydrocarbon group having 6 to 25 ring-forming atoms. Ar¹¹ and Ar¹² may be the same or different. Examples thereof include a group derived from aromatic hydrocarbons such as benzene, naphthalene, anthracene, pyrene, pentalene, indene, azulene, heptalene, acenaphthene, phenalene, phenanthrene, biphenyl, terphenyl, tetraphenyl, fluorene, or 9,9'-spirobi[fluorene].

The aromatic hydrocarbon group Ar¹¹ and Ar¹² may be a group derived from a compound selected from benzene, biphenyl, terphenyl, and fluorene (for example, a group selected from a phenylene group, a biphenylene group, a terphenylene group, and a fluorenylene group), a group derived from a compound selected from benzene and fluorene (for example, a group selected from a phenylene group and a fluorenylene group), or, for example, a group derived from benzene (for example, a phenylene group).

In a composition according to an embodiment, the structural unit (A) may be represented by Chemical Formula 1-1:

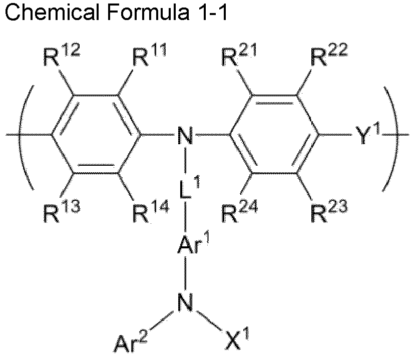

In Chemical Formula 1-1,
R¹¹ to R¹⁴ and R²¹ to R²⁴ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R¹¹ and R²¹ may be joined to form a ring,
L¹ may be a substituted or unsubstituted aromatic hydrocarbon group having 6 to 25 ring-forming atoms, or a substituted or unsubstituted heteroaromatic group having 5 to 25 ring-forming atoms,
Ar¹ may be a substituted or unsubstituted aromatic hydrocarbon group having 6 to 25 ring-forming atoms,
Ar² may be a substituted or unsubstituted aromatic hydrocarbon group having 6 to 25 ring-forming atoms, or a substituted or unsubstituted heteroaromatic group having 5 to 25 ring-forming atoms, and Ar² may form a ring with Ar¹,
X¹ may be a substituted or unsubstituted aromatic hydrocarbon group having 6 to 25 ring-forming atoms, or a substituted or unsubstituted heteroaromatic group having 5 to 25 ring-forming atoms, and
Y¹ may be a group selected from an aromatic hydrocarbon group having 6 to 25 ring-forming atoms substituted with a thiol group-containing alkyl group having 1 to 14 carbon atoms, an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms, and a thiol group-containing alkoxyalkyl group having 2 to 14 carbon atoms.

In Chemical Formula 1-1, Y¹ may be the same as defined in Chemical Formula 1, and the exemplary form of Y¹ in Chemical Formula 1-1 may also be referred to as the description of Y¹ in Chemical Formula 1. In Chemical Formula 1-1, Y¹ may have the same meaning as Y¹ in Chemical Formula 1, and may be an exemplary form thereof or a combination of these forms.

In Chemical Formula 1 (or Chemical Formula 1-1), X¹ may represent a substituted or unsubstituted aromatic hydrocarbon group having 6 to 25 ring-forming atoms; or a substituted or unsubstituted heteroaromatic group having 5 to 25 ring-forming atoms.

The "substituted or unsubstituted aromatic hydrocarbon group having 6 to 25 ring-forming atoms" refers to any one of (I) an aromatic hydrocarbon group having 6 to 25 ring-forming atoms substituted with a substituent (a), an aromatic hydrocarbon group having 6 to 25 ring-forming atoms substituted with a substituent (b), and an aromatic hydrocarbon group having 6 to 25 ring-forming atoms substituted with a substituent (a) and a substituent (b); (II) an aromatic hydrocarbon group having 6 to 25 ring-forming atoms substituted with a substituent other than a substituent (a) and a substituent (b); or (III) an unsubstituted aromatic hydrocarbon group having 6 to 25 ring-forming atoms.

In the above (I) and (II), a substituent other than the substituent (a) and the substituent (b) may be further included. In addition, the "substituted or unsubstituted heteroaromatic group having 5 to 25 ring-forming atoms" may represent any one of (I') a heteroaromatic group having 5 to 25 ring-forming atoms substituted with a substituent (a), a heteroaromatic group having 5 to 25 ring-forming atoms substituted with a substituent (b), and a heteroaromatic group having 5 to 25 ring-forming atoms substituted with a substituent (a) and a substituent (b); (II') a heteroaromatic group having 5 to 25 ring-forming atoms substituted with a substituent other than a substituent (a) and a substituent (b); or (III') an unsubstituted heteroaromatic group having 5 to 25 ring-forming atoms. In the above (I') and (II'), a substituent other than the substituent (a) and the substituent (b) may be further included. In the specification of this application, "a substituent other than substituent (a) and substituent (b)" refers to a substituent other than an alkyl group substituted by a thiol group (-SH) and an alkoxyalkyl group substituted by a thiol group (-SH), among the substituents described for the above "substituted."

As an aromatic hydrocarbon group having 6 to 25 ring-forming atoms, examples thereof may include, for example, benzene, naphthalene, anthracene, pyrene, pentalene, indene, azulene, heptalene, acenaphthene, phenalene, phenanthrene, biphenyl, terphenyl, tetraphenyl, fluorene, or 9,9'-spirobi[fluorene].

In addition, the heteroaromatic group having 5 to 25 ring-forming atoms may be, for example, acridine, phenazine, benzoquinoline, benzisoquinoline, phenanthridine, phenanthroline, anthraquinone, fluorenone, dibenzofuran, dibenzothiophene, carbazole, imidazophenanthridine, benzimidazophenanthridine, azadibenzofuran, azacarbazole, azadibenzothiophene, diazadibenzofuran, diazacarbazole, diazadibenzothiophene, xanthone, thioxanthone, pyridine, quinoline, or anthraquinoline.

X¹ may be a group derived from a compound selected from benzene, biphenyl, terphenyl, fluorene, and carbazole (for example, a group selected from a phenyl group, a biphenyl group, a terphenyl group, a fluorenyl group, and a carbazolyl group), for example, a group derived from a compound selected from benzene, biphenyl, terphenyl, or fluorene (for example, a group selected from a phenyl group, a biphenyl group, a terphenyl group, and a fluorenyl group), or for example, a group derived from benzene (for example, a phenyl group).

Additionally, X¹ may not be substituted with a substituent (a) or a substituent (b). X¹ may be a group derived from a compound selected from benzene, biphenyl, terphenyl, fluorene, or carbazole, which is unsubstituted or substituted with a substituent other than substituent (a) and substituent (b). For example, X¹ may be a group derived from a compound selected from benzene, biphenyl, terphenyl, or fluorene, which is unsubstituted or substituted with a substituent other than substituent (a) and substituent (b). For example, X¹ may be a benzene-derived group (e.g., a phenyl group) that is unsubstituted or substituted with a substituent other than substituent (a) and substituent (b). For example, X¹ may be a benzene-derived group (e.g., a phenyl group) substituted or unsubstituted with an alkyl group having 1 to 14 carbon atoms.

In addition, from the viewpoint of improving durability, in Chemical Formula 1 (or Chemical Formula 1-1), X¹ may be a group represented by Chemical Formula 6-1.

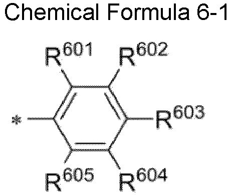

In Chemical Formula 6-1,
R⁶⁰¹ to R⁶⁰⁵ are each independently a hydrogen atom or an alkyl group having 1 to 14 carbon atoms which is unsubstituted or substituted with a substituent other than a thiol group (-SH), and * is bonded to a nitrogen atom (the nitrogen atom bonded to Ar¹).

Among R⁶⁰¹ to R⁶⁰⁵, at least one is an alkyl group having 1 to 14 carbon atoms, which is unsubstituted or substituted with a substituent other than a thiol group (-SH), and the remainder may be hydrogen atoms. Among R⁶⁰¹ to R⁶⁰⁵, at least one is an unsubstituted alkyl group having 1 to 14 carbon atoms, and the remainder may be hydrogen atoms. Among R⁶⁰¹ to R⁶⁰⁵, one may be an unsubstituted alkyl group having 1 to 14 carbon atoms, and the remaining four may be hydrogen atoms. R⁶⁰³ may be an unsubstituted alkyl group having 1 to 14 carbon atoms, and R⁶⁰¹, R⁶⁰², R⁶⁰⁴, and R⁶⁰⁵ may be hydrogen atoms, that is, the alkyl group may be in the para position (p position or 4 position) with respect to the bond (*) to the nitrogen atom (the nitrogen atom bonded to Ar¹).

The alkyl group having 1 to 14 carbon atoms as R⁶⁰¹ to R⁶⁰⁵ is not particularly limited, but is a linear or branched alkyl group, and examples thereof include the same alkyl groups having 1 to 14 carbon atoms as described for the substituent (a).

The alkyl group as R⁶⁰¹ to R⁶⁰⁵ may have 1 to 12 carbon atoms, for example, 2 to 10 carbon atoms, 4 to 8 carbon atoms, for example, an n-hexyl group, from the viewpoint of improving electroluminescence device durability (e.g., luminescence life-span) and luminous efficiency with a better balance. Additionally, R⁶⁰³ may be an alkyl group having a carbon number within the above range.

The alkyl groups as R⁶⁰¹ to R⁶⁰⁵ may be linear from the viewpoint of improving electroluminescence device durability.

In another embodiment, in Chemical Formula 1 (or Chemical Formula 1-1), X¹ may be any one of the groups represented by Chemical Formulae (8-1), (8-2), or 8-3):

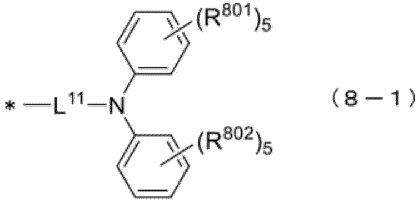

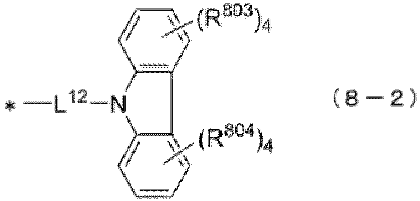

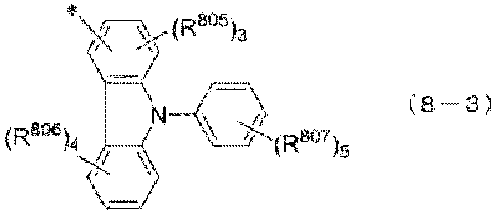

In Chemical Formulae (8-1), (8-2), and (8-3),
L¹¹ and L¹² each independently represent a substituted or unsubstituted aromatic hydrocarbon group having 6 to 12 ring-forming atoms,
R⁸⁰¹ to R⁸⁰⁷ each independently represents a hydrogen atom, a halogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aromatic hydrocarbon group having 6 to 30 ring-forming atoms, or a substituted or unsubstituted heteroaromatic group having 5 to 25 ring-forming atoms, and
* binds to a nitrogen atom (a nitrogen atom bonded to Ar¹).
R⁸⁰¹ to R⁸⁰⁷ present in one benzene ring may be the same or different. R⁸⁰¹ to R⁸⁰⁷ present in different benzene rings may be the same or different.

Examples of aromatic hydrocarbon groups as L¹¹ and L¹² include aromatic hydrocarbon groups having 6 to 12 ring-forming atoms among those exemplified for the aromatic hydrocarbon groups described for X¹.

Examples of halogen atoms as R⁸⁰¹ to R⁸⁰⁷ may include a fluorine atom, a chlorine atom, a bromine atom, or an iodine atom.

The alkyl group as R⁸⁰¹ to R⁸⁰⁷ may be either linear or branched, and examples thereof include a linear alkyl group having 1 to 20 carbon atoms and a branched alkyl group having 3 to 20 carbon atoms. As a specific example, among the substituents described for the above "substituted," the same specific examples as those given for the alkyl group may be exemplified.

As the cycloalkyl group as R⁸⁰¹ to R⁸⁰⁷, for example, a cycloalkyl group having 3 to 16 carbon atoms may be mentioned. As a specific example, among the substituents described for the above "substituted," the same specific examples as those given for the cycloalkyl group may be exemplified.

The alkoxy group as R⁸⁰¹ to R⁸⁰⁷ may be either linear or branched, and examples thereof include linear alkoxy groups having 1 to 20 carbon atoms or branched alkoxy groups having 3 to 20 carbon atoms. As a specific example, among the substituents described for the above "substituted," the same specific examples as those given for the alkoxy group may be exemplified.

As the cycloalkoxy group as R⁸⁰¹ to R⁸⁰⁷, for example, a cycloalkoxy group having 3 to 16 carbon atoms may be exemplified. As a specific example, the same specific examples as those given for the cycloalkoxy group among the substituents described for the above "substituted" may be exemplified.

As the aromatic hydrocarbon group as R⁸⁰¹ to R⁸⁰⁷, examples thereof include an aromatic hydrocarbon group having 6 to 30 ring-forming atoms. As a specific example, among the substituents described for the above "substituted," the same specific examples as those given for the aryl group may be exemplified.

As the heteroaromatic group as R⁸⁰¹ to R⁸⁰⁷, examples thereof include an heteroaromatic group having 5 to 25 ring-forming atoms. As a specific example, the same specific example as that given for the heteroaromatic group described for X¹ may be exemplified.

In Chemical Formula 1 (or Chemical Formula 1-1), the thiol group-containing alkyl group (substituent (a)) or the thiol group-containing alkoxyalkyl group (substituent (b)) may be in either a form included in both X¹ and Y¹ or a form included only in Y¹. For example, the substituent (a) or the substituent (b) may be in a form that is included only in Y¹. That is, in Chemical Formula 1 (or Chemical Formula 1-1), X¹ may be an aromatic hydrocarbon group having 6 to 25 ring-forming atoms which is unsubstituted or substituted with a substituent other than substituent (a) and substituent (b), or a heteroaromatic group having 5 to 25 ring-forming atoms which is unsubstituted or substituted with a substituent other than substituent (a) and substituent (b), and Y¹ may be a group selected from an aromatic hydrocarbon group having 6 to 25 ring-forming atoms which is substituted with a substituent (a), an aromatic hydrocarbon group having 6 to 25 ring-forming atoms which is substituted with a substituent (b), or an aromatic hydrocarbon group having 6 to 25 ring-forming atoms which is substituted with a substituent (a) and a substituent (b). In Chemical Formula 1 (or Chemical Formula 1-1), X¹ may be an aromatic hydrocarbon group having 6 to 25 ring-forming atoms substituted by a substituent other than substituent (a) and substituent (b), or an unsubstituted aromatic hydrocarbon group having 6 to 25 ring-forming atoms, and Y' may be a group selected from an aromatic hydrocarbon group having 6 to 25 ring-forming atoms substituted by substituent (a), an aromatic hydrocarbon group having 6 to 25 ring-forming atoms substituted by substituent (b), or an aromatic hydrocarbon group having 6 to 25 ring-forming atoms substituted by substituent (a) and substituent (b). Also, Ar¹¹, Ar¹², L¹, Ar¹, and Ar² in Chemical Formula 1 may not have a substituent (a) and a substituent (b). In addition, R¹¹ to R¹⁴, R²¹ to R²⁴, L¹, Ar¹, and Ar² in Chemical Formula 1-1 may not have a substituent (a) and a substituent (b).

In Chemical Formula 1 (or Chemical Formula 1-1), L¹ may represent a substituted or unsubstituted aromatic hydrocarbon group having 6 to 25 ring-forming atoms; or a substituted or unsubstituted heteroaromatic group having 5 to 25 ring-forming atoms.

Examples of the aromatic hydrocarbon group include a group derived from aromatic hydrocarbons such as benzene (e.g., phenylene group), naphthalene, anthracene, pyrene, pentalene, indene, azulene, heptalene, acenaphthene, phenalene, phenanthrene, biphenyl, terphenyl, tetraphenyl, fluorene, or 9,9'-spirobi[fluorene]. In addition, the heteroaromatic group may include, for example, a group derived from heteroaromatic compounds, such as, for example, acridine, phenazine, benzoquinoline, benzisoquinoline, phenanthridine, phenanthroline, anthraquinone, fluorenone, dibenzofuran, dibenzothiophene, carbazole, imidazophenanthridine, benzimidazophenanthridine, azadibenzofuran, azacarbazole, azadibenzothiophene, diazadibenzofuran, diazacarbazole, diazadibenzothiophene, xanthone, thioxanthone, pyridine, quinoline, or anthraquinoline.

Among these, L¹ may be a group derived from a compound selected from substituted or unsubstituted benzene, biphenyl, terphenyl, tetraphenyl and fluorene, and may be a group derived from substituted or unsubstituted benzene or biphenyl (a substituted or unsubstituted phenylene group or biphenylene group).

In addition, when L¹ may be a substituted aromatic hydrocarbon group, the substituent may be an alkyl group or a phenyl group, for example, a methyl group, an ethyl group, an n-propyl group, an isopropyl group, or a methyl group or an ethyl group, for example, a methyl group. L¹ may be a group derived from benzene or biphenyl, which is unsubstituted or substituted with a methyl group, an ethyl group, an n-propyl group, or an isopropyl group. For example, L¹ may be a group derived from benzene or biphenyl, substituted or unsubstituted with a methyl group or an ethyl group. For example, L¹ may be a group derived from benzene, which is unsubstituted or substituted with one or two methyl groups, or a group derived from biphenyl, which is unsubstituted or substituted with one or two methyl groups. For example, L¹ may be a benzene-derived group, unsubstituted or substituted with one or two methyl groups. For example, L¹ may be an unsubstituted benzene-derived group (o, m, or p-phenylene group). For example, L¹ may be a p-phenylene group. With such L¹s, the durability (e.g., luminescence life-span) and luminous efficiency of LED (e.g., QLED) may be improved with a better balance.

In Chemical Formula 1 (Chemical Formula 1-1), L¹ may be a group represented by Chemical Formulas (4-1) to (4-24):

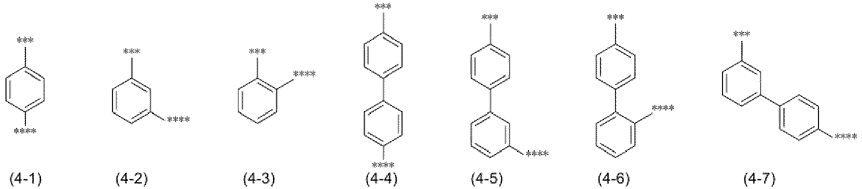

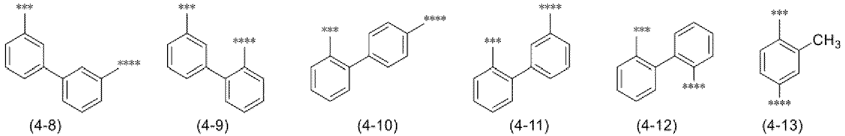

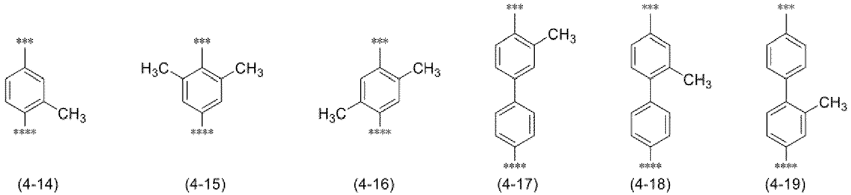

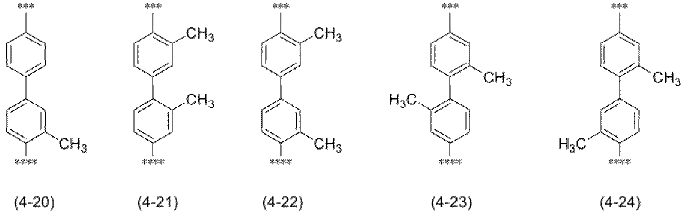

In Chemical Formulas (4-1) to (4-24), *** bonds to a nitrogen atom, and **** bonds to Ar¹.

L¹ may be a group represented by Chemical Formulas (4-1) to (4-3) and (4-13) to (4-16) (i.e., a substituted or unsubstituted phenylene group), or L¹ may be any one of the groups represented by Chemical Formulas (4-1) and (4-13) to (4-16) (i.e., a substituted or unsubstituted p-phenylene group). For example, L¹ may be a group represented by Chemical Formula (4-1) (i.e., an unsubstituted p-phenylene group). Such L¹ may achieve higher hole injection (and consequently higher durability) or better luminous efficiency.

In Chemical Formula 1 (or Chemical Formula 1-1), Ar¹ may represent a substituted or unsubstituted aromatic hydrocarbon group having 6 to 25 ring-forming atoms. Ar¹ may also form a ring with Ar². The aromatic hydrocarbon group as Ar¹ is not particularly limited. Specific examples of Ar¹ include the same ones as those derived from aromatic hydrocarbons having 6 to 25 ring-forming atoms described for the above L¹.

Ar¹ may be a group derived from a compound selected from substituted or unsubstituted benzene, biphenyl and fluorene, may be a substituted or unsubstituted group derived from benzene or biphenyl, or may be a substituted or unsubstituted group derived from benzene (for example, when Ar¹ and Ar² do not form a ring, Ar¹ may be, for example, an o-, *m-,* or p-phenylene group, and when Ar¹ and Ar² form a ring, Ar¹ may be, for example, a 1,3,4-phenylylene group). Additionally, Ar¹ may form a ring with Ar² and may be a substituted or unsubstituted 1,3,4-phenylylene group. With such Ar¹, durability and luminous efficiency may be improved with a better balance.

The substituent that may exist when any one of the hydrogen atoms of Ar¹ is substituted is not particularly limited, and the same substituents as those described for the above "substituted" may be applied. In an embodiment, Ar¹ may be unsubstituted.

In Chemical Formula 1 (or Chemical Formula 1-1), Ar² may represent a substituted or unsubstituted aromatic hydrocarbon group having 6 to 25 ring-forming atoms; or a substituted or unsubstituted heteroaromatic group having 5 to 25 ring-forming atoms. Ar² may also form a ring with Ar¹.

The aromatic hydrocarbon group and heteroaromatic group as Ar² are not particularly limited. Specific examples of the aromatic hydrocarbon group as Ar² may include a group derived from an aromatic hydrocarbon having 6 to 25 ring-forming atoms as described for L¹. Likewise, specific examples of the heteroaromatic group as Ar² may include a group derived from a heteroaromatic compound having 5 to 25 ring-forming atoms as described for L¹.

Ar² may be a group derived from a compound selected from substituted or unsubstituted benzene, biphenyl or fluorene, may be a substituted or unsubstituted group derived from benzene or biphenyl, may be a substituted or unsubstituted group derived from benzene (for example, when Ar¹ and Ar² do not form a ring, Ar² may be, for example, a phenyl group, and when Ar¹ and Ar² form a ring, Ar² may be, for example, an o-, *m-,* or p-phenylene group), or may be, for example, a substituted or unsubstituted o-phenylene group. Ar² may form a ring with Ar¹. With such Ar², durability and luminous efficiency may be improved with a better balance.

The substituent that may exist when any one of the hydrogen atoms of Ar² is substituted is not particularly limited, and the same substituents as those described for the above "substituted" may be applied. As an example, Ar² may be unsubstituted.

As described above, Ar¹ and Ar² may be joined to form a ring. In this way, by forming a ring between Ar¹ and Ar², higher hole injection properties may be obtained, durability (e.g., luminescence life-span) may be further improved, and good film-forming properties may be achieved.

When Ar¹ and Ar² form a ring, the ring structure formed by Ar¹ and Ar² is not particularly limited, but Ar¹ and Ar² may be joined to form a carbazole ring. Additionally, in an embodiment, -Ar¹-N(Ar²)(X¹) in Chemical Formula 1 (or Chemical Formula 1-1) may have a structure represented by any one of Chemical Formulae (7-1), (7-2), or (7-3). For example, -Ar¹-N(Ar²)(X¹) in Chemical Formula 1 (or Chemical Formula 1-1) may have a structure represented by Chemical Formula (7-2).

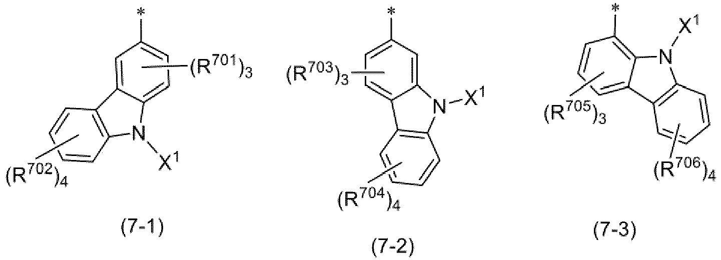

In Chemical Formulas (7-1) to (7-3),
R⁷⁰¹ to R⁷⁰⁶ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom,
X¹ is the same as defined in Chemical Formula 1 (Chemical Formula 1-1), and * binds to L¹.
R⁷⁰¹ to R⁷⁰⁶ present in one benzene ring may be the same or different. R⁷⁰¹ to R⁷⁰⁶ present in different benzene rings may be the same or different.

The alkyl group as R⁷⁰¹ to R⁷⁰⁶ may be either linear or branched, and examples thereof include linear alkyl groups having 1 to 20 carbon atoms or branched alkyl groups having 3 to 20 carbon atoms. As a specific example, among the substituents described for the above "substituted," the same specific examples as those given for the alkyl group may be exemplified.

R⁷⁰¹ to R⁷⁰⁶, for example, may be a cycloalkyl group having 3 to 16 carbon atoms may be exemplified. As a specific example, among the substituents described for the above "substituted," the same specific examples as those given for the cycloalkyl group may be exemplified.

The alkoxy group as R⁷⁰¹ to R⁷⁰⁶ may be either linear or branched, and examples thereof may include linear alkoxy groups having 1 to 20 carbon atoms or branched alkoxy groups having 3 to 20 carbon atoms. As a specific example, the same specific examples as those given for the alkoxy group among the substituents described for the above "substituted" may be exemplified.

R⁷⁰¹ to R⁷⁰⁶, for example, may be a cycloalkyl group having 3 to 16 carbon atoms may be exemplified. As a specific example, the same specific examples as those given for the cycloalkoxy group among the substituents described for the above "substituted" may be exemplified.

R⁷⁰¹ to R⁷⁰⁶, for example, may be an aryl group having 6 to 30 ring-forming atoms (carbon atoms) may be exemplified. As a specific example, among the substituents described for the above "substituted," the same specific examples as those given for the aryl group may be exemplified.

Examples of halogen atoms as R⁷⁰¹ to R⁷⁰⁶ may include a fluorine atom, a chlorine atom, a bromine atom, or an iodine atom.

In Chemical Formulae (7-1), (7-2), or (7-3), R⁷⁰¹ to R⁷⁰⁶ may each independently be a hydrogen atom or a substituted or unsubstituted alkyl group, for example, a hydrogen atom. In Chemical Formulae (7-1), (7-2), or (7-3), exemplary forms of X¹ are referred to in the description of X¹.

From the viewpoint of improving durability (e.g., luminescence life-span) and luminous efficiency with a better balance, in Chemical Formula 1 (or Chemical Formula 1-1), Ar¹ may form a ring with Ar², and -L¹-Ar¹-N(Ar²)(X¹) may be any one of the groups represented by Chemical Formulae (5-1), (5-2), or (5-3). In an embodiment, -L¹-Ar¹-N(Ar²)(X¹) in Chemical Formula 1 (or Chemical Formula 1-1) may have a structure represented by Chemical Formula (5-2).

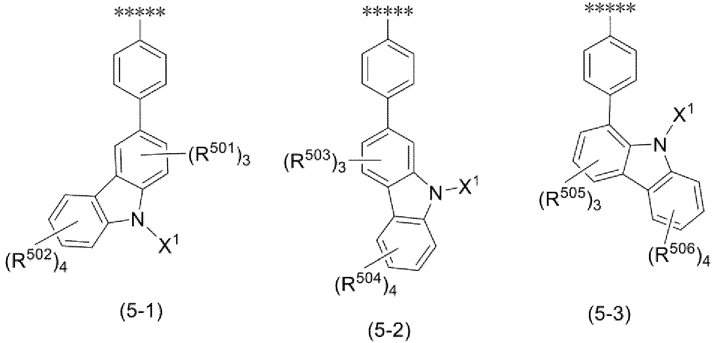

In Chemical Formulae (5-1), (5-2), or (5-3),
R⁵⁰¹ to R⁵⁰⁶ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom,
X¹ is the same as defined in Chemical Formula 1 (or Chemical Formula 1-1), and
***** binds to a nitrogen atom.
R⁵⁰¹ to R⁵⁰⁶ present in one benzene ring may be the same or different. R⁵⁰¹ to R⁵⁰⁶ present in different benzene rings may be the same or different.

Each substituent as R⁵⁰¹ to R⁵⁰⁶ may be applied to the same substituents as the examples given for R⁷⁰¹ to R⁷⁰⁶ in Chemical Formulae (7-1) to (7-3). R⁵⁰¹ to R⁵⁰⁶ may each independently be a hydrogen atom, or a substituted or unsubstituted alkyl group, for example, a hydrogen atom. In Chemical Formulae (5-1) to (5-3), exemplary forms of X¹ may be referred to in the description of X¹.

In Chemical Formula 1-1, R¹¹ to R¹⁴ and R²¹ to R²⁴ may each independently represent a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R¹¹ and R²¹ may be bonded with each other to form a ring.

R¹¹ to R¹⁴ and R²¹ to R²⁴ may be the same or different.

The alkyl groups as R¹¹ to R¹⁴ and R²¹ to R²⁴ may be either linear or branched, and examples thereof may include linear alkyl groups having 1 to 20 carbon atoms or branched alkyl groups having 3 to 20 carbon atoms. As a specific example, among the substituents described for the above "substituted," the same specific examples as those given for the alkyl group may be exemplified.

As the cycloalkyl group as R¹¹ to R¹⁴ and R²¹ to R²⁴, for example, a cycloalkyl group having 3 to 16 carbon atoms may be exemplified. As a specific example, among the substituents described for the above "substituted," the same specific examples as those given for the cycloalkyl group may be exemplified.

The alkoxy groups as R¹¹ to R¹⁴ and R²¹ to R²⁴ may be either linear or branched, and examples thereof include linear alkoxy groups having 1 to 20 carbon atoms or branched alkoxy groups having 3 to 20 carbon atoms. As a specific example, the same specific examples as those given for the alkoxy group among the substituents described for the above "substituted" may be exemplified.

As the cycloalkoxy group as R¹¹ to R¹⁴ and R²¹ to R²⁴, for example, a cycloalkyl group having 3 to 16 carbon atoms may be exemplified. As a specific example, the same specific examples as those given for the cycloalkoxy group among the substituents described for the above "substituted" may be exemplified.

As the aryl group as R¹¹ to R¹⁴ and R²¹ to R²⁴, for example, an aryl group having 6 to 30 ring-forming atoms may be exemplified. As a specific example, among the substituents described for the above "substituted," the same specific examples as those given for the aryl group may be exemplified.

Examples of halogen atoms as R¹¹ to R¹⁴ and R²¹ to R²⁴ may include a fluorine atom, a chlorine atom, a bromine atom, or an iodine atom.

Additionally, R¹¹ and R²¹ may be bonded with each other to form a ring. The ring structure formed by R¹¹ and R²¹ is not particularly limited, but for example, there is a form in which R¹¹ and R²¹ are bonded with each other to form a carbazole ring.

From the viewpoint of obtaining higher durability (e.g., luminescence life-span) or better luminous efficiency, R¹¹ to R¹⁴ and R²¹ to R²⁴ may each independently be a hydrogen atom or a linear or branched alkyl group having 1 to 5 carbon atoms. Additionally, R¹¹ to R¹⁴ and R²¹ to R²⁴ may each independently be a hydrogen atom or a linear or branched alkyl group having 1 to 3 carbon atoms. R¹¹ to R¹⁴ and R²¹ to R²⁴ may all be, for example, hydrogen atoms.

The structural unit (A) according to an embodiment may be selected from Chemical Formulae (A-1), (A-2), or (A-3).

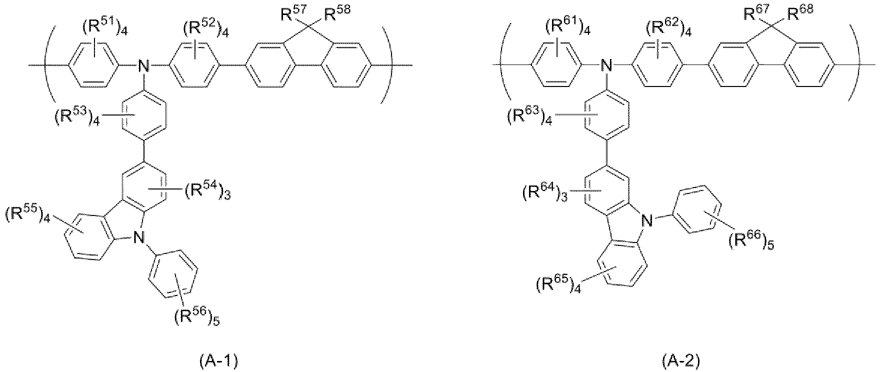

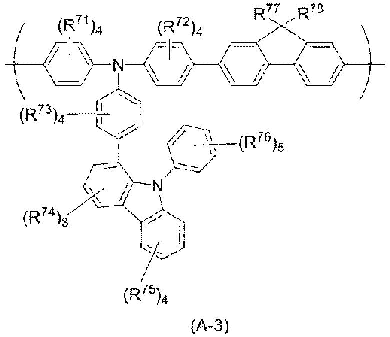

In Chemical Formulae (A-1), (A-2), or (A-3), R⁵⁷, R⁵⁸, R⁶⁷, R⁶⁸, R⁷⁷, and R⁷⁸ may each independently represent a substituent (a) or a substituent (b), and R⁵¹ to R⁵⁶, R⁶¹ to R⁶⁶, and R⁷¹ to R⁷⁶ may each independently represent a hydrogen atom or a linear or branched alkyl group having 1 to 12 carbon atoms;
For example, in Chemical Formulae (A-1), (A-2), or (A-3), R⁵⁷, R⁵⁸, R⁶⁷, R⁶⁸, R⁷⁷, and R⁷⁸ may each independently represent a substituent (a) or a substituent (b), and R⁵¹ to R⁵⁶, R⁶¹ to R⁶⁶, and R⁷¹ to R⁷⁶ may each independently represent a hydrogen atom or a linear or branched alkyl group having 2 to 10 carbon atoms;
for example, in Chemical Formulae (A-1), (A-2), or (A-3), R⁵⁷, R⁵⁸, R⁶⁷, R⁶⁸, R⁷⁷, and R⁷⁸ may each independently represent a substituent (a) or a substituent (b), R⁵¹ to R⁵⁵, R⁶¹ to R⁶⁵, and R⁷¹ to R⁷⁵ may each independently represent a hydrogen atom, and R⁵⁶, R⁶⁶, and R⁷⁶ may each independently represent a linear or branched alkyl group having 4 to 8 carbon atoms.

R⁵¹ to R⁵⁶, R⁶¹ to R⁶⁶ and R⁷¹ to R⁷⁶ present in one benzene ring may be the same or different. R⁵¹ to R⁵⁶, R⁶¹ to R⁶⁶ and R⁷¹ to R⁷⁶ present in different benzene rings may be the same or different.

For each of the above-mentioned forms, exemplary forms of the substituent (a) and the substituent (b) may be referred to in the description of the substituent (a) and the substituent (b). As an example, in each of the above forms, the substituent (a) and the substituent (b) included in Chemical Formulae (A-1), (A-2), or (A-3) may be the substituent (i) (substituent (i-1) or substituent (i-2)).

The structural unit (A) may be a structural unit represented by Chemical Formula (A-2), among the above, and exemplary forms of each substituent in the structural unit are as described above.

### Structural unit (B)

According to an embodiment, the polymer in the composition in accordance with an embodiment, may further include, in addition to the structural unit (A) represented by Chemical Formula 1, a structural unit (B) represented by Chemical Formula 2:

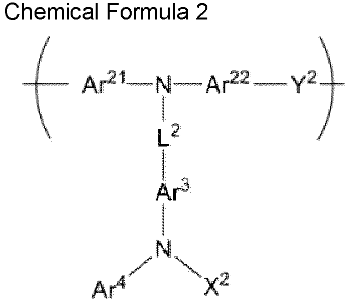

In Chemical Formula 2,
Ar²¹ and Ar²² are each independently a substituted or unsubstituted aromatic hydrocarbon group having 6 to 25 ring-forming atoms,
Ar²¹ and Ar²² are optionally bonded with each other to form a ring,
L² is a substituted or unsubstituted aromatic hydrocarbon group having 6 to 25 ring-forming atoms, or a substituted or unsubstituted heteroaromatic group having 5 to 25 ring-forming atoms,
Ar³ is a substituted or unsubstituted aromatic hydrocarbon group having 6 to 25 ring-forming atoms,
Ar⁴ is a substituted or unsubstituted aromatic hydrocarbon group having 6 to 25 ring-forming atoms, or a substituted or unsubstituted heteroaromatic group having 5 to 25 ring-forming atoms, and Ar⁴ may form a ring with Ar³,
X² is a substituted or unsubstituted aromatic hydrocarbon group having 6 to 25 ring-forming atoms, or a substituted or unsubstituted heteroaromatic group having 5 to 25 ring-forming atoms,
Y² is an aromatic hydrocarbon group having 6 to 25 ring-forming atoms, substituted or unsubstituted with an alkyl group having 1 to 14 carbon atoms, and
Ar²¹, Ar²², L², Ar³, Ar⁴, and X² do not have a thiol group-containing alkyl group having 1 to 14 carbon atoms, and do not have a thiol group-containing alkoxyalkyl group having 2 to 14 carbon atoms.

The structural unit (B) may be present as two or more units in the polymeric compounds, that is, the structural unit (B) represented by Chemical Formula 2 may be a repeating unit. Accordingly, the polymer may have a repeating unit (repeating unit (A)) represented by Chemical Formula 1 (for example, Chemical Formula 1-1) and a repeating unit (repeating unit (B)) represented by Chemical Formula 2.

The structural unit (B) represented by Chemical Formula 2 is at times simply referred to as "structural unit (B)". As with structural unit A, structural unit (B) represented by Chemical Formula 2, includes portion unit X¹, and 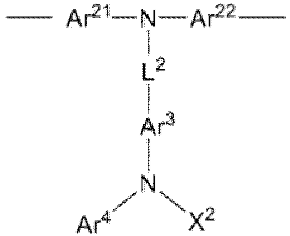 a portion unit Y².

In addition to the structural unit (A) represented by Chemical Formula 1, by further including a structural unit (B) represented by Chemical Formula 2, the polymer may have excellent hole injection properties for quantum dots and may further improve the durability (luminescence life-span) and luminous efficiency of the electroluminescence device. Moreover, high current efficiency and low driving voltage may be achieved. If the polymer does include a structural unit (B), the structural unit (B) may include only one type of structural unit (B), or may include two or more different types of structural unit (B). The plurality of structural units (B) may exist in a block form, a random form, an alternating form, or a periodic form.

In Chemical Formula 2, Y² differs from Y¹ in Chemical Formula 1 in that it does not have a thiol group-containing alkyl group having 1 to 14 carbon atoms (substituent (a)) and a thiol group-containing alkoxyalkyl group having 2 to 14 carbon atoms (substituent (b)). In Chemical Formula 2, the definitions of L², Ar³, Ar⁴, Ar²¹, and Ar²² are the same as the definitions of L¹, Ar¹, Ar², Ar²¹, and Ar²² of Chemical Formula 1, respectively, except that each of them does not have substituent (a) and substituent (b) (or is not substituent (a) and substituent (b)). Therefore, for L², Ar³, Ar⁴, Ar²¹, and Ar²², the term "substituted", unless specifically limited, means a form substituted with a substituent other than substituent (a) and substituent (b).

In Chemical Formula 2, Ar²¹ and Ar²² may each independently represent a substituted or unsubstituted aromatic hydrocarbon group having 6 to 25 ring-forming atoms. Ar²¹ and Ar²² may be the same or different. Here, as an aromatic hydrocarbon group having 6 to 25 ring-forming atoms, specifically, the same aromatic hydrocarbon groups as those described for Ar¹¹ and Ar¹² in Chemical Formula 1 may be exemplified.

The aromatic hydrocarbon group as Ar²¹ and Ar²² may be a group derived from a compound selected from benzene, biphenyl, terphenyl, and fluorene (for example, a group selected from a phenylene group, a biphenylene group, a terphenylene group, and a fluorenylene group), a group derived from a compound selected from benzene and fluorene (for example, a group selected from a phenylene group and a fluorenylene group), or, for example, a group derived from benzene (for example, a phenylene group).

The structural unit (B) may be represented by Chemical Formula 2-1:

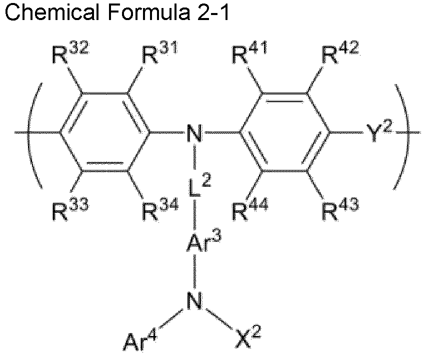

In Chemical Formula 2-1,
R³¹ to R³⁴ and R⁴¹ to R⁴⁴ may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R³¹ and R⁴¹ may be bonded with each other to form a ring,
L² may be a substituted or unsubstituted aromatic hydrocarbon group having 6 to 25 ring-forming atoms, or a substituted or unsubstituted heteroaromatic group having 5 to 25 ring-forming atoms,
Ar³ may be a substituted or unsubstituted aromatic hydrocarbon group having 6 to 25 ring-forming atoms,
Ar⁴ may be a substituted or unsubstituted aromatic hydrocarbon group having 6 to 25 ring-forming atoms, or a substituted or unsubstituted heteroaromatic having 5 to 25 ring-forming atoms, and Ar⁴ may form a ring with Ar³.
X² may be a substituted or unsubstituted aromatic hydrocarbon group having 6 to 25 ring-forming atoms, or a substituted or unsubstituted heteroaromatic group having 5 to 25 ring-forming atoms,
Y² may be an aromatic hydrocarbon group having 6 to 25 ring-forming atoms, substituted or unsubstituted with an alkyl group having 1 to 14 carbon atoms, and
R³¹ to R³⁴, R⁴¹ to R⁴⁴, L², Ar³, Ar⁴, and X² do not have a thiol group-containing alkyl group having 1 to 14 carbon atoms, and do not have a thiol group-containing alkoxyalkyl group having 2 to 14 carbon atoms.

In Chemical Formula 2 (Chemical Formula 2-1), Y² may represent an aromatic hydrocarbon group having 6 to 25 ring-forming atoms, substituted or unsubstituted with an alkyl group having 1 to 14 carbon atoms. As an aromatic hydrocarbon group having 6 to 25 ring-forming atoms, specifically, the same aromatic hydrocarbon group having 6 to 25 ring-forming atoms as described for Y¹ above may be exemplified.

Among these, the aromatic hydrocarbon group included in Y² may be a group derived from benzene or fluorene (e.g., a phenylene group or a fluorenylene group).

In an embodiment, for improving durability (e.g., luminescence life-span) and luminous efficiency with a better balance, in Chemical Formula 2 (Chemical Formula 2-1), Y² may be any one of the groups represented by Chemical Formulae (3'-1), (3'-2), or (3'-3):

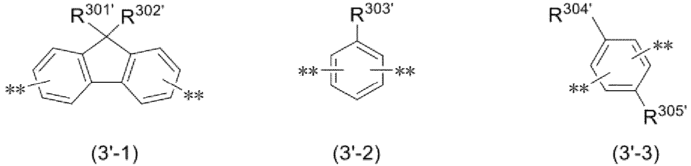

In Chemical Formulae (3'-1), (3'-2), or (3'-3), R^{301'} to R^{305'} may each independently be an alkyl group having 1 to 14 carbon atoms, unsubstituted or substituted with a substituent other than a thiol group (-SH), and ** represents a bonding site.

In Chemical Formulae (3'-1) and (3'-3), R301' and R^{301'} and R^{302'}, R^{304'} and R^{305'} may be the same or different. For example, R^{301'} and R^{302'}, R^{304'} and R^{305'} may be the same as each other.

The alkyl group having 1 to 14 carbon atoms as R^{301'} to R^{305'} is not particularly limited, but is a linear or branched alkyl group, and specific examples thereof include the same alkyl groups having 1 to 14 carbon atoms as those described for the substituent (a).

The alkyl group as R^{301'} to R^{305'} may have 1 to 12 carbon atoms, for example, 2 to 12 carbon atoms, 2 to 10 carbon atoms, or 4 to 10 carbon atoms, from the viewpoint of better balancing durability (e.g., luminescence life-span) and luminous efficiency, and may be, for example, an n-decyl group. For example, R^{301'} and R^{302'} may each independently be an alkyl group having a carbon number within the above range.

The alkyl group R^{301'} to R^{305'} may be linear. The alkyl groups as R^{301'} to R^{304'} may be unsubstituted.

Upon consideration of the film-forming property, etc., in Chemical Formula 2 (chemical formula 2-1), Y² may be a group represented by Chemical Formula (3'-1) (i.e., a fluorenylene group).

In Chemical Formula 2 (Chemical Formula 2-1), X² may represent a substituted or unsubstituted aromatic hydrocarbon group having 6 to 25 ring-forming atoms; or a substituted or unsubstituted heteroaromatic group having 5 to 25 ring-forming atoms.

As an aromatic hydrocarbon group having 6 to 25 ring-forming atoms, specifically, the same aromatic hydrocarbon group having 6 to 25 ring-forming atoms as described for X¹ above may be exemplified. As a heteroaromatic group having 5 to 25 ring-forming atoms, specifically, the same heteroaromatic group having 5 to 25 ring-forming atoms as described for X¹ may be exemplified.

Among these, X² may be a group derived from a compound selected from benzene, biphenyl, terphenyl, fluorene, or carbazole (for example, a group selected from a phenyl group, a biphenyl group, a terphenyl group, a fluorenyl group, or a carbazolyl group), for example, a group derived from a compound selected from benzene, biphenyl, terphenyl, or fluorene (for example, a group selected from a phenyl group, a biphenyl group, a terphenyl group, or a fluorenyl group), or for example, a group derived from benzene (for example, a phenyl group). X² may be a group derived from a compound selected from benzene, biphenyl, terphenyl, fluorene, or carbazole, which is substituted (substituted by a substituent other than substituent (a) and substituent (b)) or unsubstituted, a group derived from a compound selected from benzene, biphenyl, terphenyl, or fluorene, which is substituted (substituted by a substituent other than substituent (a) and substituent (b)) or unsubstituted, a group derived from a compound selected from benzene, biphenyl, terphenyl, or fluorene, which is unsubstituted or substituted by an alkyl group having 1 to 14 carbon atoms, or a group derived from benzene (for example, a phenyl group), which is unsubstituted or substituted by an alkyl group having 1 to 14 carbon atoms.

For improving durability, in an embodiment, in Chemical Formula 2 (or Chemical Formula 2-1), X² may be a group represented by Chemical Formula (6'-1).

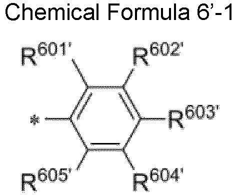

In Chemical Formula 6'-1,
R^{601'} to R^{605'} may each independently be a hydrogen atom, or an alkyl group having 1 to 14 carbon atoms, and
* binds to a nitrogen atom (a nitrogen atom bonded to Ar³).

Among R^{601'} to R^{605'}, at least one is an (unsubstituted) alkyl group having 1 to 14 carbon atoms, and the remainder may be hydrogen atoms. Among R^{601'} to R^{605'}, one may be an (unsubstituted) alkyl group having 1 to 14 carbon atoms, and the remaining four may be hydrogen atoms. R^{603'} may be an (unsubstituted) alkyl group having 1 to 14 carbon atoms, and R^{601'}, R^{602'}, R^{604'}, and R^{605'} may be hydrogen atoms, that is, the alkyl group may be at the para position (p position or 4 position) with respect to the bond (*) to the nitrogen atom (the nitrogen atom bonded to Ar³).

The alkyl group having 1 to 14 carbon atoms as R^{601'} to R^{605'} is not particularly limited, but may be a linear or branched alkyl group, and specific examples thereof may include the same alkyl groups having 1 to 14 carbon atoms as those described for the substituent (a).

The alkyl group as R^{601'} to R^{605'} may have 1 to 12 carbon atoms, for example, 2 to 10 carbon atoms, 4 to 8 carbon atoms, for example, be an n-hexyl group, from the viewpoint of improving durability (e.g., luminescence life-span) and luminous efficiency with a better balance. Additionally, R^{603'} may be an alkyl group having a carbon number within the above range.

The alkyl group as R^{601'} to R^{605'} may be linear from the viewpoint of improving durability.

In another embodiment, in Chemical Formula 2 (or Chemical Formula 2-1), X² may be a group represented by Chemical Formulae (8'-1), (8'-2), or (8'-3):

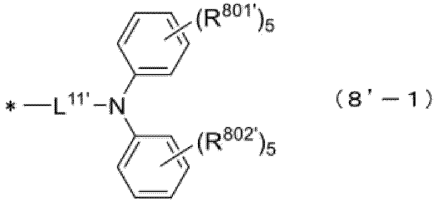

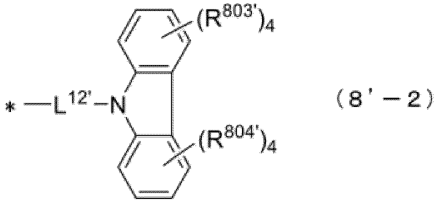

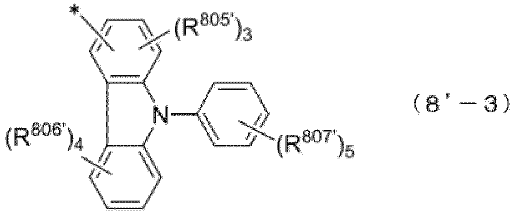

In Chemical Formulae (8'-1), (8'-2), or (8'-3),
L^{11'} and L^{12'} may each independently represent a substituted or unsubstituted aromatic hydrocarbon group having 6 to 12 ring-forming atoms,
R^{801'} to R^{807'} may each independently represent a hydrogen atom, a halogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aromatic hydrocarbon group having 6 to 25 ring-forming atoms, or a substituted or unsubstituted heteroaromatic group having 5 to 12 ring-forming atoms, and
* binds to a nitrogen atom (a nitrogen atom bonded to Ar³).

R^{801'} to R^{807'} present in one benzene ring may be the same or different. R^{801'} to R^{807'} present in different benzene rings may be the same or different.

Specific examples of the aromatic hydrocarbon group as L^{11'} and L^{12'} may include the same ones as L¹¹ and L¹². Specific examples of each substituent as R^{801'} to R^{807'} may include the same ones as R⁸⁰¹ to R⁸⁰⁷.

As described above, in Chemical Formula 2, the definitions of L², Ar³, Ar⁴, Ar²¹, and Ar²² are each the same as the definitions of L¹, Ar¹, Ar², Ar¹¹, and Ar¹² in Chemical Formula 1. In addition, in Chemical Formula 2-1, the definitions of L², Ar³, Ar⁴, R³¹ to R³⁴ and R⁴¹ to R⁴⁴ are each the same as the definitions of L¹, Ar¹, Ar², R¹¹ to R¹⁴ and R²¹ to R²⁴ in Chemical Formula 1-1. Also, the exemplary forms are each the same.

In Chemical Formula 2 (or Chemical Formula 2-1), L² may represent a substituted or unsubstituted aromatic hydrocarbon group having 6 to 25 ring-forming atoms; or a substituted or unsubstituted heteroaromatic group having 5 to 25 ring-forming atoms.

As an aromatic hydrocarbon group of L², examples thereof may include the same aromatic hydrocarbon group having 6 to 25 ring-forming atoms as described for L¹, and as a heteroaromatic group of L², examples thereof may include the same heteroaromatic group having 5 to 25 ring-forming atoms as described for L¹.

Among these, L² may be a group derived from a compound selected from substituted or unsubstituted benzene, biphenyl, terphenyl, tetraphenyl or fluorene, for example, a group derived from substituted or unsubstituted benzene or biphenyl (a substituted or unsubstituted phenylene group or biphenylene group).

If L² is a substituted aromatic hydrocarbon group, the substituent may be an alkyl group or a phenyl group, for example, an alkyl group, or a methyl group, an ethyl group, an n-propyl group, or an isopropyl group, for example, a methyl group or an ethyl group, for example, a methyl group, that is, L² may be a group derived from benzene or biphenyl, which is unsubstituted or substituted with a methyl group, an ethyl group, an n-propyl group or an isopropyl group. For example, L² may be a group derived from benzene or biphenyl, substituted or unsubstituted with a methyl group or an ethyl group. For example, L² may be a group derived from benzene, substituted or unsubstituted with one or two methyl groups, or biphenyl, substituted or unsubstituted with one or two methyl groups. For example, L² may be a benzene-derived group, substituted or unsubstituted with one or two methyl groups. For example, L² may be an unsubstituted benzene-derived group *(o-, m-,* or p-phenylene group), for example, a p-phenylene group. As such, L² may improve the durability (e.g., luminescence life-span) and luminous efficiency of LED (e.g., QLED) with a better balance.

In Chemical Formula 2 (or Chemical Formula 2-1), L² may be any one of the groups represented by Chemical Formulae (4'-1) to (4'-24):

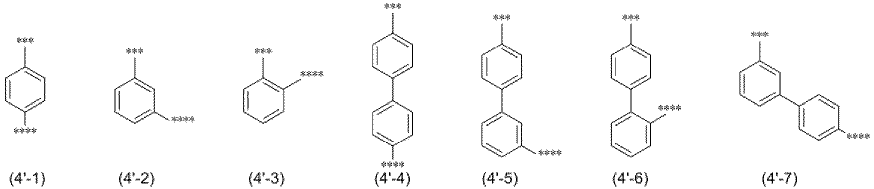

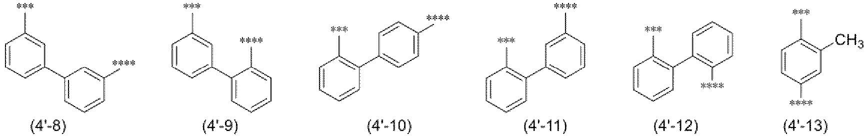

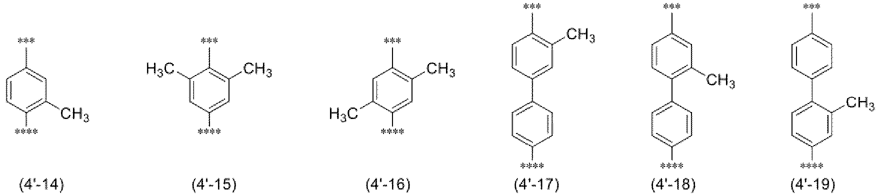

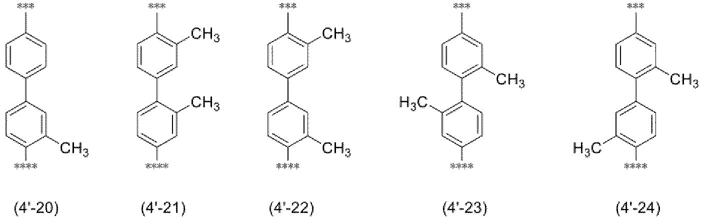

In Chemical Formulae (4'-1) to (4'-24), *** bonds to a nitrogen atom, and **** bonds to Ar³.

L² may be a group represented by Chemical Formulae (4'-1) to (4'-3) and (4'-13) to (4'-16) (i.e., a substituted or unsubstituted phenylene group). L² may be any one of the groups represented by Chemical Formulae (4'-1) and (4'-13) to (4'-16) (i.e., a substituted or unsubstituted p-phenylene group), for example, may be a group represented by Chemical Formula (4'-1) (i.e., an unsubstituted p-phenylene group). As such, L² may achieve higher hole injection properties (and consequently higher durability) or better luminous efficiency.

In Chemical Formula 2 (or Chemical Formula 2-1), Ar³ may represent a substituted or unsubstituted aromatic hydrocarbon group having 6 to 25 ring-forming atoms. At this time, Ar³ may also form a ring with Ar⁴.

The aromatic hydrocarbon group as Ar³ is not particularly limited. Specific examples of Ar³ may include the same ones as those derived from aromatic hydrocarbons having 6 to 25 ring-forming atoms described for the above L¹.

Among these, Ar³ may be a group derived from a compound selected from substituted or unsubstituted benzene, biphenyl or fluorene, may be a substituted or unsubstituted group derived from benzene or biphenyl, or may be a substituted or unsubstituted group derived from benzene (for example, when Ar³ and Ar⁴ do not form a ring, Ar³ may be, for example, an o-, *m-,* or p-phenylene group, and when Ar³ and Ar⁴ form a ring, Ar³ may be, for example, a 1,3,4-phenylylene group). Ar³ may form a ring with Ar⁴ and may be a substituted or unsubstituted 1,3,4-phenylylene group as such Ar³ may achieve higher hole injection properties (and consequently higher durability) and good film forming properties. Additionally, durability and luminous efficiency may be improved with a good balance.

The substituent that may exist when any one of the hydrogen atoms of Ar³ is substituted is not particularly limited, and the same substituents as those described for the above "substituted" may be applied. In an embodiment, Ar³ may be unsubstituted.

In Chemical Formula 2 (or Chemical Formula 2-1), Ar⁴ may represent a substituted or unsubstituted aromatic hydrocarbon group having 6 to 25 ring-forming atoms, or a substituted or unsubstituted heteroaromatic group having 5 to 25 ring-forming atoms. Ar⁴ may also form a ring with Ar³.

The aromatic hydrocarbon group and heteroaromatic group as Ar⁴ are not particularly limited. Specific examples of the aromatic hydrocarbon group as Ar⁴ may include a group derived from an aromatic hydrocarbon having 6 to 25 ring-forming atoms as described for L¹. Likewise, the heteroaromatic group as Ar⁴ may be exemplified by a group derived from a heteroaromatic compound having 5 to 25 ring-forming atoms as described for L¹ above.

Ar⁴ may be a group derived from a compound selected from substituted or unsubstituted benzene, biphenyl or fluorene, may be a substituted or unsubstituted group derived from benzene or biphenyl, may be a substituted or unsubstituted group derived from benzene (for example, when Ar³ and Ar⁴ do not form a ring, Ar⁴ may be, for example, a phenyl group, and when Ar³ and Ar⁴ form a ring, Ar⁴ may be, for example, an o-, *m-,* or p-phenylene group), or may be, for example, a substituted or unsubstituted o-phenylene group. If Ar⁴ forms a ring with Ar³ one may improve durability and luminous efficiency with a better balance.

The substituent that may exist when any one of the hydrogen atoms of Ar⁴ is substituted is not particularly limited, and the same substituents as those described for the above "substituted" may be applied. Ar⁴ may be unsubstituted.

As described above, Ar³ and Ar⁴ may be joined to form a ring. In this way, by forming a ring with Ar³ and Ar⁴, higher hole injection properties may be obtained, durability (e.g., luminescence life-span) may be further improved, and good film forming properties may be achieved.

If Ar³ and Ar⁴ form a ring, the ring structure formed by Ar³ and Ar⁴ is not particularly limited, but Ar³ and Ar⁴ may be bonded with each other to form a carbazole ring. In an embodiment, -Ar³-N(Ar⁴)(X²) in Chemical Formula 2 (or Chemical Formula 2-1) may have a structure represented by any one of Chemical Formulae (7'-1), (7'-2), or (7'-3). In an embodiment, -Ar³-N(Ar⁴)(X²) in Chemical Formula 2 (or Chemical Formula 2-1) may have a structure represented by Chemical Formula (7'-2):

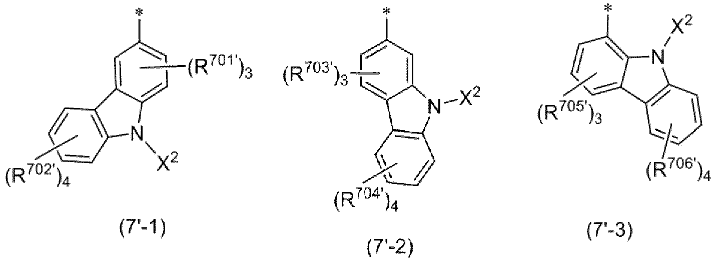

In Chemical Formulae (7'-1), (7'-2), or (7'-3),
R^{701'} to R^{706'} may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom,
X² may be the same as defined in Chemical Formula 2 (Chemical Formula 2-1), and * binds to L².

R^{701'} to R^{706'} present in one benzene ring may be the same or different. R^{701'} to R^{706'} present in different benzene rings may be the same or different.

The alkyl group as R^{701'} to R^{706'} may be either linear or branched, and examples thereof may include linear alkyl groups having 1 to 20 carbon atoms or branched alkyl groups having 3 to 20 carbon atoms. As a specific example, among the substituents described for the above "substituted," the same specific examples as those given for the alkyl group may be exemplified.

As the cycloalkyl group as R^{701'} to R^{706'}, for example, a cycloalkyl group having 3 to 16 carbon atoms may be exemplified. As a specific example, among the substituents described for the above "substituted," the same specific examples as those given for the cycloalkyl group may be exemplified.

The alkoxy group as R^{701'} to R^{706'} may be either linear or branched, and examples thereof may include linear alkoxy groups having 1 to 20 carbon atoms or branched alkoxy groups having 3 to 20 carbon atoms. As a specific example, the same specific examples as those given for the alkoxy group among the substituents described for the above "substituted" may be exemplified.

As the cycloalkyloxy group as R^{701'} to R^{706'}, for example, a cycloalkyloxy group having 3 to 16 carbon atoms may be exemplified. As a specific example, the same specific examples as those given for the cycloalkyloxy group among the substituents described for the above "substituted" may be exemplified.

As the aryl group as R^{701'} to R^{706'}, for example, an aryl group having 6 to 30 ring-forming atoms may be exemplified. As a specific example, among the substituents described for the above "substituted," the same specific examples as those given for the aryl group may be exemplified.

As halogen atoms as R^{701'} to R^{706'}, a fluorine atom, a chlorine atom, a bromine atom, or an iodine atom may be exemplified.

In Chemical Formulae (7'-1), (7'-2), or (7'-3), R^{701'} to R^{706'} may each independently be a hydrogen atom, or a substituted or unsubstituted alkyl group, or for example, a hydrogen atom. In Chemical Formulae (7'-1), (7'-2), or (7'-3), exemplary forms of X² may be referred to in the description of X².

From the viewpoint of improving durability (e.g., luminescence life-span) and luminous efficiency with a better balance, in Chemical Formula 2 (or Chemical Formula 2-1), Ar³ may form a ring with Ar⁴, and -L²-Ar³-N(Ar⁴)(X²) may be any one of the groups represented by Chemical Formulae (5'-1), (5'-2), or (5'-3). In an embodiment, -L²-Ar³-N(Ar⁴)(X²) in Chemical Formula 2 (or Chemical Formula 2-1) may have a structure represented by Chemical Formula (5'-2):

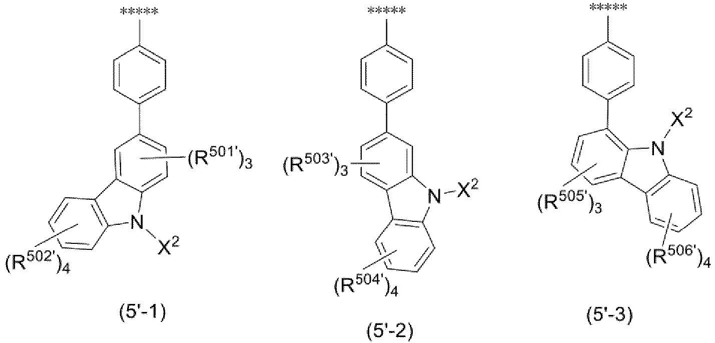

In Chemical Formulae (5'-1), (5'-2), or (5'-3),
R^{501'} to R^{506'} may each independently be a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom,
X² may be the same as defined in Chemical Formula 2 (Chemical Formula 2-1), and ***** is bonded to a nitrogen atom.

R^{501'} to R^{506'} present in one benzene ring may be the same or different. R^{501'} to R^{506'} present in different benzene rings may be the same or different.

Each substituent as R^{501'} to R^{506'} may be applied to the same substituent as the example given for R^{701'} to R^{706'} in Chemical Formulae (7'-1), (7'-2), or (7'-3). R^{501'} to R^{506'} may each independently be a hydrogen atom, or a substituted or unsubstituted alkyl group, or for example, a hydrogen atom. In Chemical Formulae (5'-1), (5'-2), or (5'-3), exemplary forms of X² may be referred to in the description of X².

In Chemical Formula 2-1, R³¹ to R³⁴ and R⁴¹ to R⁴⁴ may each independently represent a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R³¹ and R⁴¹ may be bonded with each other to form a ring.

R³¹ to R³⁴ and R⁴¹ to R⁴⁴ may be the same or different.

The alkyl groups as R³¹ to R³⁴ and R⁴¹ to R⁴⁴ may be either linear or branched, and examples thereof include linear alkyl groups having 1 to 20 carbon atoms or branched alkyl groups having 3 to 20 carbon atoms. As a specific example, among the substituents described for the above "substituted," the same specific examples as those given for the alkyl group may be exemplified.

As the cycloalkyl group as R³¹ to R³⁴ and R⁴¹ to R⁴⁴, for example, a cycloalkyl group having 3 to 16 carbon atoms may be exemplified. As a specific example, among the substituents described for the above "substituted," the same specific examples as those given for the cycloalkyl group may be exemplified.

The alkoxy groups as R³¹ to R³⁴ and R⁴¹ to R⁴⁴ may be either linear or branched, and examples thereof include linear alkoxy groups having 1 to 20 carbon atoms or branched alkoxy groups having 3 to 20 carbon atoms. As a specific example, the same specific examples as those given for the alkoxy group among the substituents described for the above "substituted" may be exemplified.

As the cycloalkoxy group as R³¹ to R³⁴ and R⁴¹ to R⁴⁴, for example, a cycloalkyl group having 3 to 16 carbon atoms may be exemplified. As a specific example, the same specific examples as those given for the cycloalkoxy group among the substituents described for the above "substituted" may be exemplified.

As the aryl group as R³¹ to R³⁴ and R⁴¹ to R⁴⁴, for example, an aryl group having 6 to 30 ring-forming atoms may be exemplified. As a specific example, among the substituents described for the above "substituted," the same specific examples as those given for the aryl group may be exemplified.

As halogen atoms as R³¹ to R³⁴ and R⁴¹ to R⁴⁴, a fluorine atom, a chlorine atom, a bromine atom, and an iodine atom may be exemplified.

Additionally, R³¹ and R⁴¹ may be bonded with each other to form a ring. At this time, the ring structure formed by R³¹ and R⁴¹ is not particularly limited, but for example, there is a form in which R³¹ and R⁴¹ are bonded with each other to form a carbazole ring.

R³¹ to R³⁴ and R⁴¹ to R⁴⁴ may each independently be a hydrogen atom or a linear or branched alkyl group having 1 to 5 carbon atoms. As such, higher durability (e.g., luminescence life-span) or better luminous efficiency may be achieved. R³¹ to R³⁴ and R⁴¹ to R⁴⁴ may each independently be a hydrogen atom or a linear or branched alkyl group having 1 to 3 carbon atoms. R³¹ to R³⁴ and R⁴¹ to R⁴⁴ may all be, for example, hydrogen atoms.

The structural unit (B) represented by Chemical Formula 2 described above may have the same structure and substituent as the structural unit (A) represented by Chemical Formula 1, except for the part including the substituent (a) or the substituent (b) (i.e., Y¹). Accordingly, Ar²¹ in Chemical Formula 2 is the same as Ar¹¹ in Chemical Formula 1, Ar²² in Chemical Formula 2 is the same as Ar¹² in Chemical Formula 1, L² in Chemical Formula 2 is the same as L¹ in Chemical Formula 1, Ar³ in Chemical Formula 2 is the same as Ar¹ in Chemical Formula 1, Ar⁴ in Chemical Formula 2 is the same as Ar² in Chemical Formula 1, and X² in Chemical Formula 2 is the same as X¹ in Chemical Formula 1.

Likewise, R¹¹ in Chemical Formula 1-1 may be the same as R³¹ in Chemical Formula 2-1, R¹² in Chemical Formula 1-1 may be the same as R³² in Chemical Formula 2-1, R¹³ in Chemical Formula 1-1 may be the same as R³³ in Chemical Formula 2-1, R¹⁴ in Chemical Formula 1-1 may be the same as R³⁴ in Chemical Formula 2-1, R²¹ in Chemical Formula 1-1 may be the same as R⁴¹ in Chemical Formula 2-1, R²² in Chemical Formula 1-1 may be the same as R⁴² in Chemical Formula 2-1, R²³ in Chemical Formula 1-1 may be the same as R⁴³ in Chemical Formula 2-1, R²⁴ in Chemical Formula 1-1 may be the same as R⁴⁴ in Chemical Formula 2-1, L¹ in Chemical Formula 1-1 may be the same as L² in Chemical Formula 2-1, Ar¹ in Chemical Formula 1-1 may be the same as Ar³ in Chemical Formula 2-1, Ar² in Chemical Formula 1-1 may be the same as Ar⁴ in Chemical Formula 2-1, and X¹ in Chemical Formula 1-1 may be the same as X² in Chemical Formula 2-1.

And, in the above, for example, "Ar¹¹ in Chemical Formula 1 is the same as Ar²¹ in Chemical Formula 2" means that Ar¹¹ and Ar²¹ have the same structure. For example, if Ar¹¹ is an unsubstituted phenylene group, it indicates that Ar²¹ is also an unsubstituted phenylene group.

The structural unit (B) according to an embodiment may be selected from the following groups:

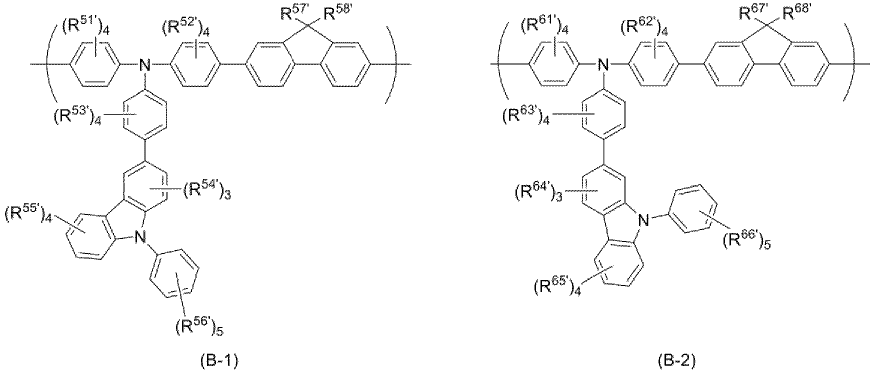

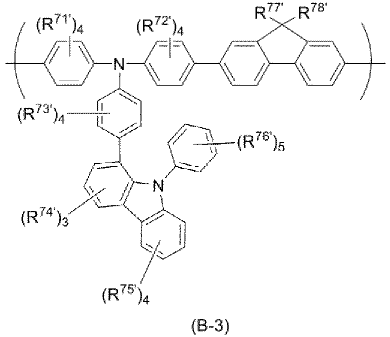

In Chemical Formulae (B-1), (B-2), or (B-3), R^{57'}, R^{58'}, R^{67'}, R^{68'}, R^{77'}, and R^{78'} may each independently represent a linear or branched alkyl group having 1 to 14 carbon atoms, and R^{51'} to R^{56'}, R^{61'} to R^{66'}, and R^{71'} to R^{76'} may each independently represent a hydrogen atom or a linear or branched alkyl group having 1 to 12 carbon atoms; for example, in Chemical Formulae (B-1), (B-2), or (B-3), R^{57'}, R^{58'}, R^{67'}, R^{68'}, R^{77'} and R^{78'} may each independently represent a linear or branched alkyl group having 2 to 12 carbon atoms, and R^{51'} to R^{56'}, R^{61'} to R^{66'}, and R^{71'} to R^{76'} may each independently represent a hydrogen atom or a linear or branched alkyl group having 2 to 10 carbon atoms; and for example, in Chemical Formulae (B-1), (B-2), or (B-3), R^{57'}, R^{58'}, R^{67'}, R^{68'}, R^{77'} and R^{78'} may each independently represent a linear or branched alkyl group having 4 to 10 carbon atoms, R^{51'} to R^{55'}, R^{61'} to R^{65'} and R^{71'} to R^{75'} may each independently represent a hydrogen atom, and R^{56'}, R^{66'} and R^{76'} may each independently represent a linear or branched alkyl group having 4 to 8 carbon atoms.

R^{51'} to R^{56'}, R^{61'} to R^{66'} and R^{71'} to R^{76'} present in one benzene ring may be the same or different, respectively. R^{51'} to R^{56'}, R^{61'} to R^{66'} and R^{71'} to R^{76'} present in different benzene rings may be the same or different.

The structural unit (B) may be a structural unit represented by chemical formula (B-2) among the above, and the specific form of each substituent in the structural unit is as described above.

### Other structural units

The polymer contained in the composition of an embodiment may further include a structural unit other than the structural unit (A), and optionally, the structural unit (B). In cases where another structural unit is included, the structural unit is not particularly limited as long as it does not inhibit the effect of the polymeric compound. The other structural unit may include those derived from compounds such as azulene, naphthalene, anthracene, phenanthrene, pyrene, etc. Hereinafter, the other structural unit is referred to as "structural units (C)".

### Composition of Polymer

The composition of structural units (A) to (C) in a polymeric compound according to an embodiment is not particularly limited. Considering a further good balance of the durability (luminescence life-span) and luminous efficiency of a layer (e.g., a hole injection layer, a hole transport layer) formed by the thiol-ene cross-linking between the obtained polymer and the compound represented by Chemical Formula 10, the structural unit (A) may be included in an amount of, for example, about 1 mol% or more and less than about 100 mol%, for example, about 1 mol% or more and about 50 mol% or less, for example, about 1 mol% or more and about 30 mol% or less, for example, about 5 mol% or more and about 20 mol% or less, or for example, about 8 mol% or more and about 15 mol% or less, based on a total number of moles of the structural units of the polymer. When the polymer includes two or more types of the structural units (A), the amount of the structural units (A) means a total amount of all structural units (A).

In an embodiment, the structural unit (A) is included in the polymeric compound in a ratio of less than about 100 mol%, for example, less than about 50 mol%, based on a total number of moles of structural units. Considering an objective is to achieve good balance between the durability (luminescence life-span) and luminescence efficiency of a layer (e.g., a hole injection layer, a hole transport layer) formed by the thiol-ene cross-linking between the obtained polymer and the compound represented by Chemical Formula 10, the structural unit (B) may be included in an amount of, for example, more than 0 mol% and less than or equal to about 99 mol%, for example, more than 20 mol% and less than or equal to about 95 mol%, for example, more than about 70 mol% and less than or equal to about 95 mol%, for example, more than about 80 mol% and less than or equal to about 95 mol%, or, for example, more than about 85 mol% and less than or equal to about 92 mol%, based on a total number of moles of the structural units of the polymer. When the polymer contains two or more types of the structural units (B), the amount of the structural units (B) means a total amount of all structural units (B).

As described above, the polymer may further include another structural unit structural unit (C). The composition of the other structural unit structural units (C) is not particularly limited. Considering a cross-linking ratio produced by the thiol-ene cross-linking between the polymer and the compound represented by Chemical Formula 10, and the effect of improving film strength obtained by the thiol-ene cross-linking between the polymer and the compound, the structural unit (C) may be included in an amount of, for example, more than 0 mol% and less than or equal to about 10 mol% based on a total number of moles of the structural units of the polymeric compound. If the polymer includes two or more types of structural units (C), the amount of the structural units (C) means a total amount of all structural units (C).

Based on a total (sum) number of moles of structural units (A) and structural units (B), a molar ratio of structural unit (A) may be greater than or equal to about 1 mol% and less than about 30 mol%, or greater than or equal to about 5 mol% and less than or equal to about 20 mol%, or for example, greater than or equal to about 8 mol% and less than or equal to about 15 mol%. Similarly, the molar ratio of the structural unit (B) may be greater than about 70 mol% and less than or equal to about 99 mol%, greater than or equal to about 80 mol% and less than or equal to about 95 mol%, or greater than or equal to about 85 mol% and less than or equal to about 92 mol% (based on a total number of moles of the structural unit (A) and the structural unit (B)).

The molar ratio among the structural unit (A), the structural unit (B), and the structural unit (C) may appropriately be controlled by adjusting the molar ratio of the monomers that serve as raw materials. In addition, the molar ratio of each structural unit (A), structural unit (B), and structural unit (C) in a polymer may be measured by using ¹H-NMR, ¹³C-NMR, mass spectrometry, liquid chromatography-mass spectrometry (LC-MS), Fourier transform infrared spectroscopy (FTIR), etc., or by combining these methods.

When considering good balance between the durability (e.g., luminescence life-span) and luminous efficiency of a thin film (e.g., hole transport layer) prepared from the product of the thiol-ene cross-linking reaction between the polymer and the compound represented by Chemical Formula 10 due to a heat-treatment of a composition comprising the polymer and the compound at a temperature of less than or equal to 200°C, for example, less than or equal to 190°C, the polymer may include only the structural unit (A) and the structural unit (B) (i.e., the total ratio of the structural unit (A) and the structural unit (B) to the total structural units of the polymeric compound is 100 mol%).

The weight average molecular weight (Mw) of the polymer is not particularly limited. The weight average molecular weight (Mw) may be, for example, greater than or equal to about 5,000 Da and less than or equal to about 1,000,000 Da, for example, greater than or equal to about 8,000 Da and less than or equal to about 1,000,000 Da, greater than or equal to about 10,000 Da and less than or equal to about 800,000 Da, or for example, greater than or equal to about 50,000 Da and less than or equal to about 500,000 Da. With such a weight average molecular weight, it is possible to form a layer with a uniform film thickness by appropriately controlling the viscosity of the coating solution for forming a thin film (e.g., a hole transport layer) including a product prepared by a thiol-ene cross-linking reaction by using the composition according to an embodiment.

In addition, the number average molecular weight (Mn) of the polymer is not particularly limited. The number average molecular weight (Mn) may be, for example, greater than or equal to about 4,000 Da and less than or equal to about 300,000 Da , for example, greater than or equal to about 6,000 Da and less than or equal to about 250,000 Da, greater than or equal to about 10,000 Da and less than or equal to about 200,000 Da, or for example, greater than or equal to about 20,000 Da and less than or equal to about 150,000 Da. With such a number-average molecular weight, it is possible to form a layer with a uniform film thickness by appropriately controlling the viscosity of the coating solution for forming a thin film (e.g., a hole transport layer) including a product prepared by a thiol-ene cross-linking reaction by using the composition according to an embodiment. In addition, the polydispersity (weight average molecular weight/number average molecular weight) of the polymer may be, for example, greater than or equal to about 1.1 and less than or equal to about 5.0, for example, greater than or equal to about 1.5 and less than or equal to about 4.0, or for example, greater than or equal to about 2.0 and less than or equal to about 3.5.

The measurement of the number average molecular weight (Mn) and the weight average molecular weight (Mw) is not particularly limited, and may be measured by using a known method or by appropriately modifying a known method. In this specification, the number average molecular weight (Mn) and weight average molecular weight (Mw) adopt values measured by the following methods. The polydispersity (Mw/Mn) of the polymer is calculated by dividing the weight average molecular weight (Mw) by the number average molecular weight (Mn) measured by the following method.

### Measurement of Number Average Molecular Weight (Mn) and Weight Average Molecular Weight (Mw)

The number average molecular weight (Mn) and weight average molecular weight (Mw) of the polymeric material is measured by SEC (Size Exclusion Chromatography) using polystyrene as a standard material under the following conditions: SEC Measurement Condition

Analysis equipment (SEC): Shimadzu Corporation, Prominence (registered trademark)
Column: Polymer Laboratories, PLgel MIXED-B
Column temperature: 40 °C
Flow rate: 1.0 mL/min
Injection amount of sample solution: 20 µL (concentration of polymer: about 0.05 mass%)
Eluent: tetrahydrofuran (THF)
Detector (UV-VIS detector): Shimadzu Corporation, SPD-10AV
Standard sample: polystyrene.

The terminal end of the main chain of the polymer included in the composition according to the present embodiment is not particularly limited and is appropriately defined depending on the type of raw material used, but is usually a hydrogen atom.

The glass transition temperature (T_{g}) of the polymer according to one embodiment is not particularly limited, but may be, for example, 75°C or higher, for example, 90°C or higher, or 100°C or higher. Meanwhile, the upper limit thereof is not particularly limited, but may be, for example, 180°C or lower, for example, 150°C or lower.

When the glass transition temperature (T_{g}) of the polymer is within the above range, it is advantageous for device manufacturing, and also, a device with improved characteristics may be obtained. The glass transition temperature (T_{g}) of the polymer may be measured by using a differential scanning calorimeter (DSC) (manufactured by Seiko Instruments, Inc., product name: DSC6000). The details of the measurement method are described in the examples.

Even if the polymer does not form a cross-linking product through a thiol-ene cross-linking reaction with the compound represented by Chemical Formula 10, it is a material that has hole transport properties in itself, and according to an embodiment, even if the polymer forms a cross-linking product through a thiol-ene bond reaction with the compound represented by Chemical Formula 10, the hole transport properties can be maintained as is. For example, the hole mobility of a thin film manufactured by curing a composition containing only the polymer without the compound represented by Chemical Formula 10 may be greater than or equal to about 10⁻⁵ cm²V⁻¹S⁻¹. In addition, when the composition containing the polymer together with the compound represented by Chemical Formula 10, i.e., the composition according to an embodiment, is cured to produce a thin film, the hole mobility of the thin film may also be greater than or equal to about 10⁻⁵ cm²V⁻¹S⁻¹. That is, the composition according to an embodiment can maintain the hole transport characteristics of the polymer containing the structural unit (A) represented by Chemical Formula 1 almost intact.

US2022/0320453A1discloses that a cross-linked product through a thiol-ene bonding reaction between a hole-transporting polymer including an unsaturated bond such as a carbon-carbon double bond and an additive including a thiol group may be applied as a hole-transport layer, etc. However, the cross-linked product according to the prior document practically exhibits little hole-transport properties. However, the composition according to an embodiment may be advantageously used as a hole transport material for an electroluminescent device, unlike the cross-linked product disclosed in the above-cited U.S. patent publication, as the hole transport property of the polymer itself is maintained at substantially the same level even after forming a cross-linked product through a thiol-ene bonding reaction between the polymer and the compound represented by Chemical Formula 10.

The polymer may be synthesized by using a known organic synthesis method. A person skilled in the art would understand the specific method of synthesis of the polymer by referring to the examples described later. For example, the polymer may be prepared by a copolymerization reaction using at least one monomer (I-x) represented by Chemical Formula I-X and at least one monomer (I-y) represented by Chemical Formula I-Y. If necessary, monomers of structural unit (B) may be added. Specifically, the polymeric compound may be prepared by a copolymerization reaction using at least one monomer (II-x) represented by Chemical Formula II-X and at least one monomer (II-y) represented by Chemical Formula II-Y (i.e., monomers constituting structural unit (B) according to an embodiment) in addition to at least one monomer (I-x) represented by Chemical Formula I-X and at least one monomer (I-y) represented by Chemical Formula I-Y (i.e., monomers constituting structural unit (A) according to an embodiment). In the polymer, when X in structural unit (A) and X' in structural unit (B) have the same structure, the polymeric compound according to an embodiment may also be prepared by copolymerization reaction using at least one monomer (I-x) represented by Chemical Formula I-X, at least one monomer (I-y) represented by Chemical Formula I-Y, and at least one monomer (II-y) represented by Chemical Formula II-Y. If necessary, other monomers corresponding structural unit (C) may be added. By appropriately controlling the molar ratio of each monomer, i.e., the molar ratio of structural units (A), (B), and (C) in the polymeric compound may be controlled.

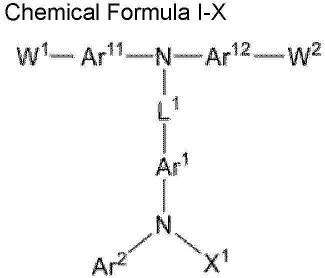

Chemical Formula I-Y W³-Y¹-W⁴

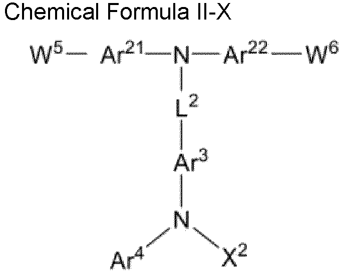

Chemical Formula II-Y W⁷-Y²-W⁸

Alternatively, the polymer may be produced by a polymerization reaction using one or more monomers represented by Chemical Formula 1'. If necessary, a monomer corresponding to the structural unit (B) may also be added. Specifically, when a polymer includes a structural unit (A) and a structural unit (B), the compound can be produced by a copolymerization reaction using at least one monomer represented by Chemical Formula 1' and at least one monomer represented by Chemical Formula 2'. If necessary, another monomer corresponding to the (structural unit (C) may be added.

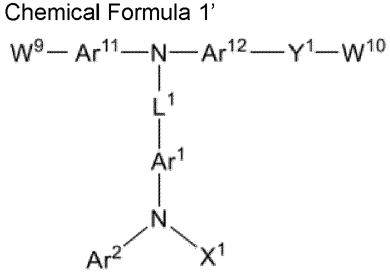

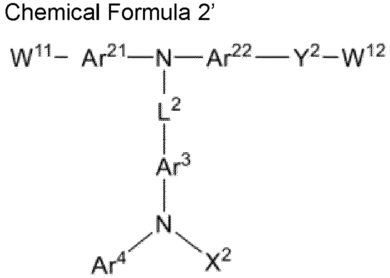

In an embodiment, the monomer used for polymerization of a polymer may be synthesized by appropriately combining known synthetic reactions, and its structure can also be confirmed by a known method (e.g., NMR, LC-MS, etc.).

In Chemical Formula I-X, Chemical Formula I-Y, Chemical Formula II-X, Chemical Formula II-Y, Chemical Formula 1', and Chemical Formula 2', Ar¹¹, Ar¹², Ar²¹, Ar²², L¹, L², Ar¹, Ar², Ar³, Ar⁴, X¹, X², Y¹, and Y² are the same as defined in Chemical Formula 1 or Chemical Formula 2, and W¹ o W¹² are each independently a halogen atom (fluorine atom, chlorine atom, bromine atom, iodine atom, for example, bromine atom) or a group having the following structure. In the structure below, R^{A} to R^{D} are each independently an alkyl group having 1 to 3 carbon atoms. R^{A} to R^{D} may be a methyl group.

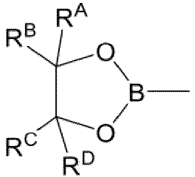

W¹ and W² in Chemical Formula I-X, W³ and W⁴ in Chemical Formula I-Y, W⁵ and W⁶ in Chemical Formula II-X, W⁷ and W⁸ in Chemical Formula II-Y, W⁹ and W¹⁰ in Chemical Formula 1', and W¹¹ and W¹² in Chemical Formula 2' may be the same or different, respectively. However, in order to suppress self-polymerization of monomers (I-x), W¹ and W² in Chemical Formula I-X may be atoms or groups that do not react with each other. In order to inhibit self-polymerization of monomers (I-y), W³ and W⁴ in Chemical Formula I-Y may be atoms or groups that do not react with each other. In order to inhibit self-polymerization between monomers (II-x) or monomers (II-y), W⁵ and W⁶ in Chemical Formula II-X and W⁷ and W⁸ in Chemical Formula II-Y may be atoms or groups that do not react with each other, respectively. In order to suppress self-polymerization between monomers represented by Chemical Formula 1' or between monomers represented by Chemical Formula 2', W⁹ and W¹⁰ in Chemical Formula 1' and W¹¹ and W¹² in Chemical Formula 2' may be atoms or groups that do not react with each other, respectively. For example, W¹ and W² in Chemical Formula I-X, W³ and W⁴ in Chemical Formula I-Y, W⁵ and W⁶ in Chemical Formula II-X, and W⁷ and W⁸ in Chemical Formula II-Y may each be the same. For example, W⁹ and W¹⁰ in Chemical Formula 1' may be different. Likewise, for example, W¹¹ and W¹² in Chemical Formula 2' may be different.

### Compound

A compound included in the composition according to an embodiment may be represented by Chemical Formula 10:

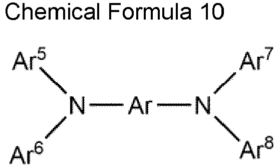

In Chemical Formula 10,
Ar and Ar⁵ to Ar⁸ are each independently a substituted or unsubstituted aromatic hydrocarbon group having 6 to 25 ring-forming atoms, a substituted or unsubstituted heteroaromatic ring group having 5 to 25 ring-forming atoms, or a combination thereof, wherein the aromatic hydrocarbon group and the heteroaromatic ring group include a single ring, a fused ring of two or more rings, a ring assembly in which the single ring and/or the fused ring are connected by a single bond,
Ar⁵ and Ar⁶, and/or Ar⁷ and Ar⁸, are each independently optionally linked to form a ring, respectively,
at least two of Ar and Ar⁵ to Ar⁸ are each independently substituted by a C2 to C10 aliphatic hydrocarbon group containing a carbon-carbon double bond or a carbon-carbon triple bond, or a C3 to C10 alicyclic hydrocarbon group containing a carbon-carbon double bond or a carbon-carbon triple bond.

In the compound represented by Chemical Formula 10, at least two of Ar and Ar⁵ to Ar⁸ are substituted by an aliphatic hydrocarbon group containing a carbon-carbon double bond or a carbon-carbon triple bond, or an alicyclic hydrocarbon group. Therefore, the unsaturated bond group containing at least two carbon-carbon double or triple bonds in the compound represented by Chemical Formula 10 may form a thiol-ene bonding reaction with a thiol group substituted for Y¹ in structural unit (A) of the polymer represented by Chemical Formula 1. For example, two or more unsaturated bonding groups included in the compound represented by Chemical Formula 10 form thiol-ene bonding reactions with two or more thiol groups substituted for Y¹ in structural unit (A) of the polymer represented by Chemical Formula 1, so that a composition according to an embodiment may be manufactured to a thin film including a cross-linking product between the polymer represented by Chemical Formula 1 and the compound represented by Chemical Formula 10.

The compound represented by Chemical Formula 10 may be a compound that exhibits hole transport properties by itself. That is, when a composition containing the compound represented by Chemical Formula 10 alone, without a polymer including structural unit (A) represented by Chemical formula 1, is cured to produce a thin film, the hole mobility of the thin film can be greater than or equal to about 10⁻⁵ cm²V⁻¹S⁻¹. In addition, when the compound is cured together with a polymer including the structural unit (A) represented by Chemical Formula 1 to produce a thin film, the hole mobility of the thin film can also be greater than or equal to about 10⁻⁵ cm²V⁻¹S⁻¹. That is, both the polymer including the structural unit (A) represented by Chemical Formula 1 and the compound represented by Chemical Formula 10 included in the composition according to an embodiment exhibit a hole mobility of greater than or equal to about 10⁻⁵ cm²V⁻¹S⁻¹, and a hole mobility of a thin film manufactured by curing the composition according to an embodiment including the polymer and compound together may also be greater than or equal to about 10⁻⁵ cm²V⁻¹S⁻¹. Therefore, the composition according to an embodiment can maintain the hole transport properties of the polymer and the compound without deterioration even after cross-linking of the polymer including the structural unit (A) represented by Chemical Formula 1 and the compound represented by Chemical Formula 10. Therefore, the composition according to an embodiment may be advantageously applied to a hole transport layer of an electroluminescent device.

In Chemical Formula 10, Ar and Ar⁵ to Ar⁸ may each independently be a substituted or unsubstituted aromatic hydrocarbon group having 6 to 15 ring-forming atoms, a substituted or unsubstituted heteroaromatic ring group having 5 to 15 ring-forming atoms, or a combination thereof, wherein the aromatic hydrocarbon group and the heteroaromatic ring group include a single ring, a fused ring of two or more rings, a ring assembly in which the single ring and/or the fused ring are connected by a single bond, Ar⁵ and Ar⁶, and/or Ar⁷ and Ar⁸, may each independently be optionally linked to form a ring, respectively, and at least two of Ar and Ar⁵ to Ar⁸ may each independently be substituted by a C2 to C5 aliphatic hydrocarbon group containing a carbon-carbon double bond or a carbon-carbon triple bond, or a C3 to C6 alicyclic hydrocarbon group containing a carbon-carbon double bond or a carbon-carbon triple bond.

In Chemical Formula 10, Ar may be a substituted or unsubstituted phenylene group, a substituted or unsubstituted pyridinylene group, a substituted or unsubstituted pyrimidylene group, a substituted or unsubstituted pyrazinylene group, a substituted or unsubstituted triazinylene group, a substituted or unsubstituted biphenylene group, or a combination thereof, for example, may be a substituted or unsubstituted phenylene group, or a substituted or unsubstituted biphenylene group, or for example, a substituted or unsubstituted biphenylene group.

In Chemical Formula 10, Ar⁵ to Ar⁸ may each independently be a substituted or unsubstituted phenyl group, a substituted or unsubstituted biphenyl group, a substituted or unsubstituted naphthyl group, a substituted or unsubstituted anthracenyl group, a substituted or unsubstituted phenanthrenyl group, a substituted or unsubstituted acridinyl group, a substituted or unsubstituted pyridinyl group, or a combination thereof, Ar⁵ and Ar⁶ and/or Ar⁷ and Ar⁸ may each independently be optionally linked to form a substituted or unsubstituted carbazole ring, respectively, or a fused ring including an indole or a pyridine ring, wherein the indole and/or the pyridine ring is optionally substituted, and one of Ar⁵ and Ar⁶, and one of Ar⁷ and Ar⁸ are each independently substituted with a C2 to C4 aliphatic hydrocarbon group including a carbon-carbon double bond or a carbon-carbon triple bond.

In an embodiment, the compound represented by Chemical Formula 10 may be represented by Chemical Formula 10-1: 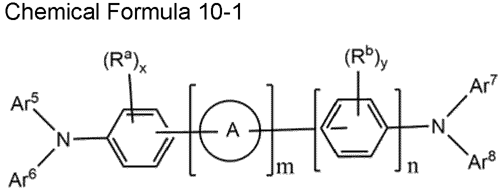 In Chemical Formula 10-1, 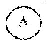 may be a substituted or unsubstituted heteroaromatic ring group having 5 to 15 ring-forming atoms,
Ar⁵ to Ar⁸ may each independently be the same as defined in Chemical Formula 10,
R^{a} and R^{b} may each independently be, deuterium, a C1 to C10 alkyl group, a C2 to C10 alkenyl group, a C1 to C10 haloalkyl group, a halogen atom, a cyano group, a nitro group, or a combination thereof,
x and y may each independently be an integer from 0 to 4, and
m and n may each independently be an integer from 0 to 3.

In Chemical Formula 10-1, 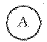 may be substituted or unsubstituted pyridinylene group, a substituted or unsubstituted pyrimidylene group, a substituted or unsubstituted pyrazinylene group, a substituted or unsubstituted triazinylene group, or a combination thereof.

In Chemical Formula 10-1, R^{a} and R^{b} may each independently be a C1 to C4 alkyl group, a C1 to C2 haloalkyl group, a halogen atom, a cyano group, or a combination thereof, and for example, R^{a} and R^{b} may each independently be a trifluoromethyl group, a fluoro group, a cyano group, or a combination thereof, but are not limited thereto. In Chemical Formula 10-1, x and y, may each independently be an integer of 0 or 4.

In Chemical Formula 10-1, m and n, may each independently be an integer of 0 or 1, both m and n may be 0, both m and n may be 1, or one of m and n may be 0, and the other may be 1.

The compound represented by Chemical Formula 10 may include the compounds represented by Group 1, Group 2, Group 3, and Group 4, but are not limited thereto.

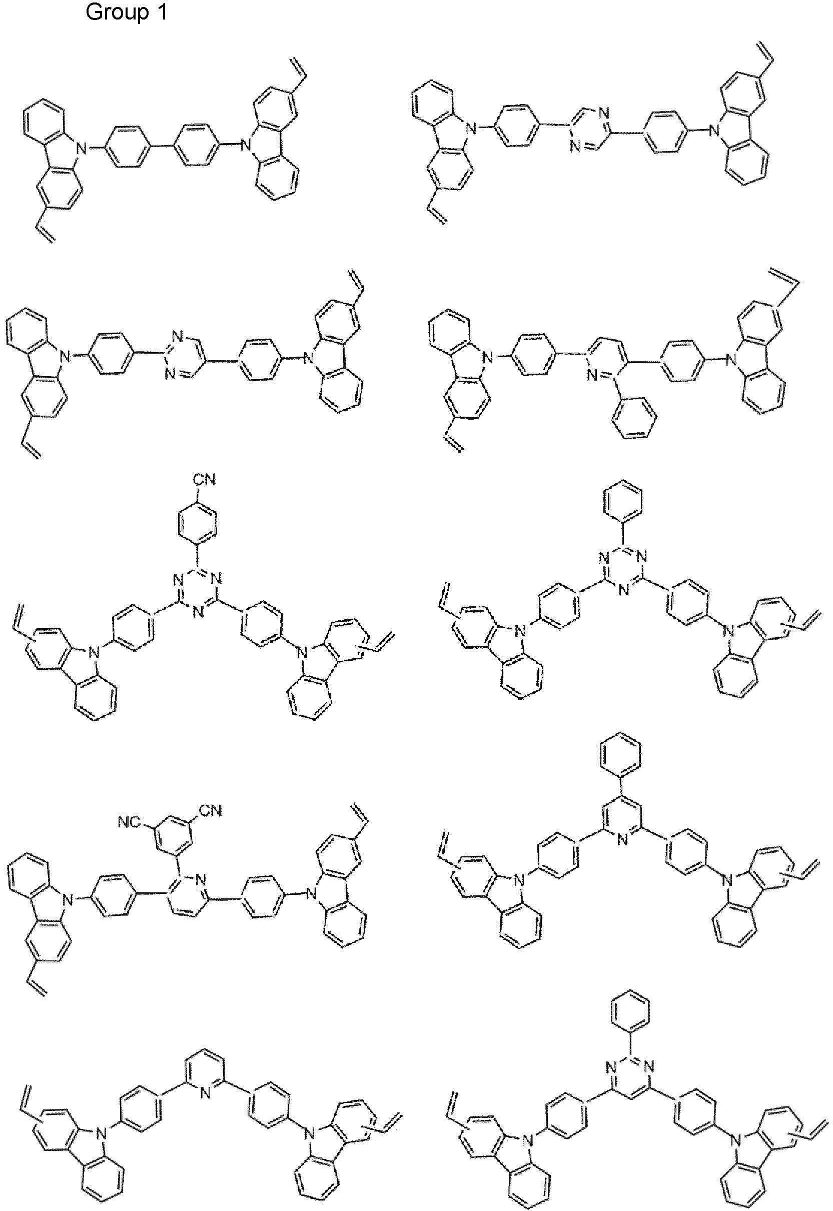

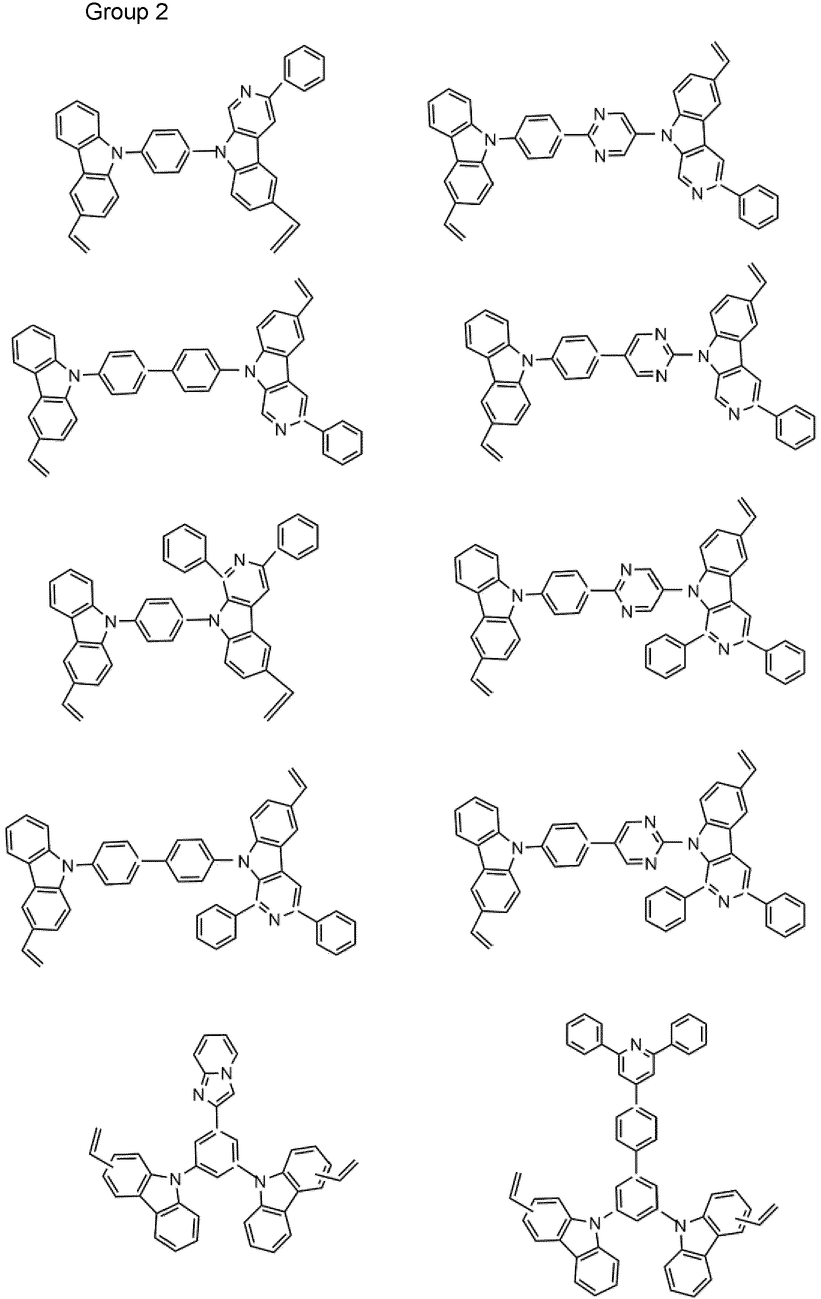

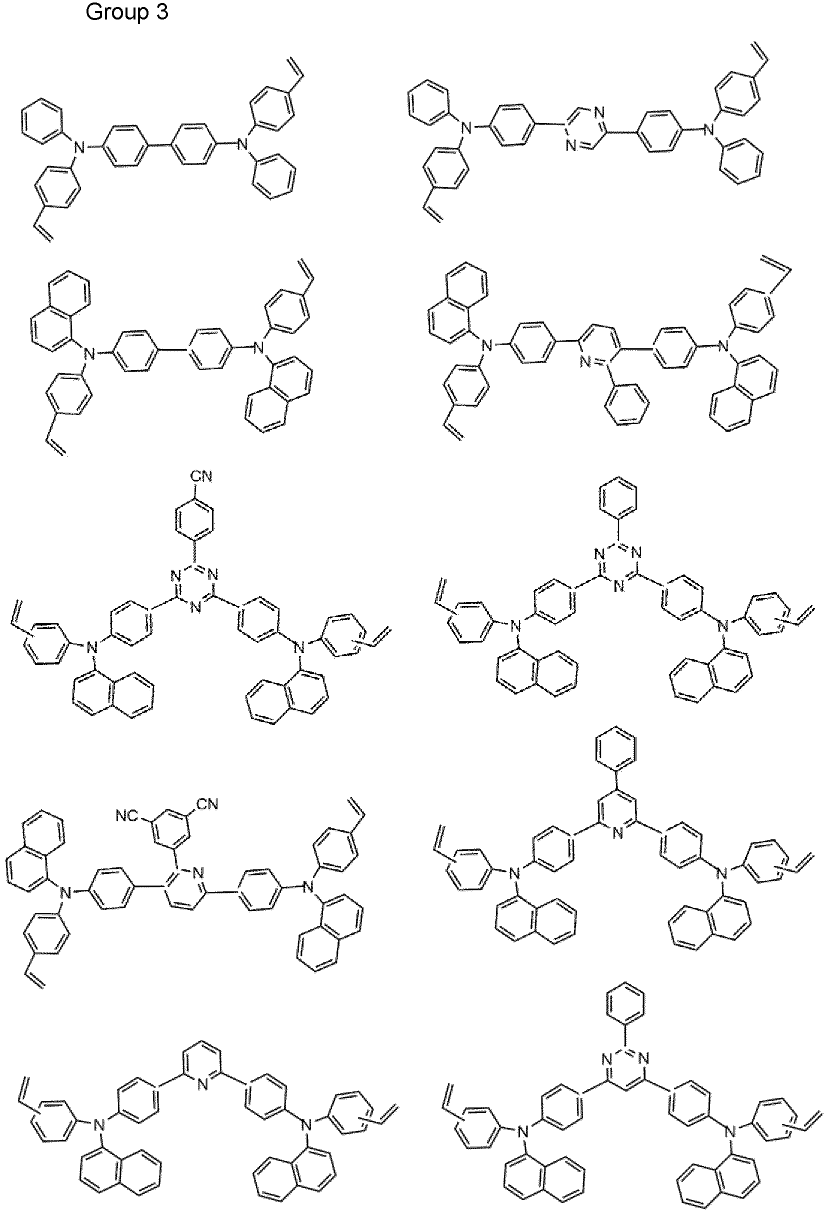

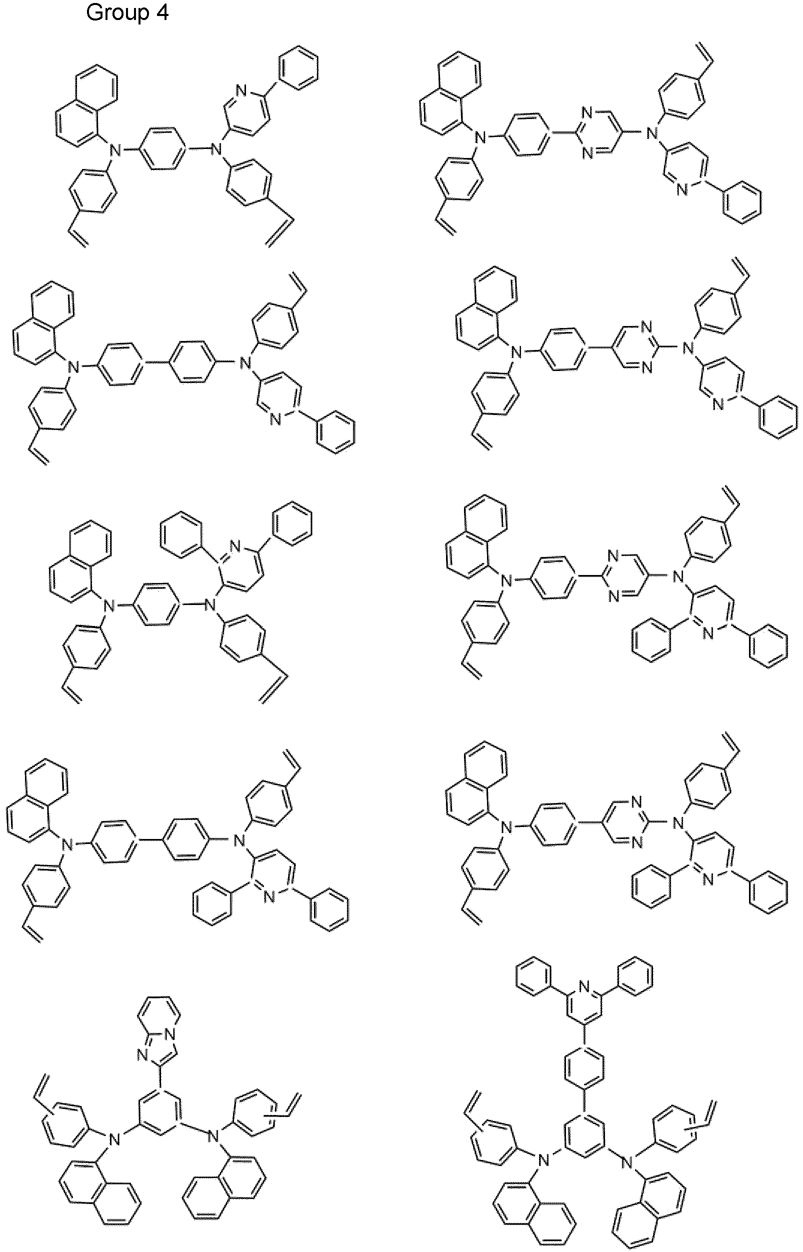

In an embodiment, the compound represented by Chemical Formula 10 may include, but is not limited to, a compound represented by Chemical Formula 10-2, a compound represented by Chemical Formula 10-3, or a combination thereof:

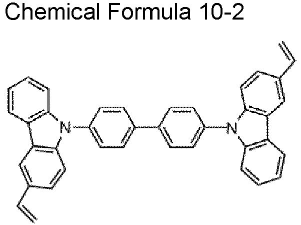

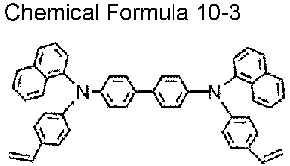

Since two or more carbon-carbon unsaturated bond groups included in the compound represented by Chemical Formula 10 undergo a thiol-ene bonding reaction at a molar ratio of 1:1 with the thiol group in the polymer including structural unit (A) represented by Chemical Formula 1, the amount of the compound represented by Chemical Formula 10 in the composition according to an embodiment may be in an appropriate amount in consideration of the amount of the polymer including structural unit (A) represented by Chemical Formula 1 and the amount of the thiol group in the polymer.

For example, when the amount of structural unit (A) including a thiol group in the polymer is about 20 mol% based on a number of moles of the total structural units forming the polymer, the compound represented by Chemical Formula 10 may be included in an amount corresponding to about 20 mol% based on the number of moles of the total structural units of the polymer. In addition, for example, when the amount of the structural unit (A) in the polymer is about 10 mol%, the compound represented by Chemical Formula 10 may be included in an amount corresponding to about 10 mol% based on the number of moles of the total structural units of the polymer.

The compound represented by Chemical Formula 10 may be easily prepared by substituting a C2 to C10 aliphatic hydrocarbon group or a C3 to C10 alicyclic hydrocarbon group containing a carbon-carbon double bond or a carbon-carbon triple bond, at two or more of the positions corresponding to Ar⁵ to Ar₈ of a compound satisfying the basic structure of Chemical Formula 10 among any conventional low-molecular-weight organic compounds known to have a hole-transport property. That is, hole-transporting small-molecular-weight organic compounds satisfying the basic structure of Chemical Formula 10 have been known, and the introduction of an aliphatic hydrocarbon group or an alicyclic hydrocarbon group including a carbon-carbon double bond or a carbon-carbon triple bond to two or more of the positions corresponding to Ar⁵ to Ar⁸ of these small-molecular-weight organic compounds can be easily performed by those skilled in the art using a known organic chemical synthesis method with reference to the examples described below.

### Material for Electroluminescence Device

The composition according to an embodiment may be advantageously used as a material for an electroluminescence device. By using a composition according to an embodiment, a hole transport layer having a high film retention rate may be formed, and at this time, deterioration of a hole injection layer disposed under the hole transport layer may be prevented, so that an electroluminescent device having excellent hole injection and hole transport characteristics, low driving voltage, excellent luminescence characteristics, and high luminescence efficiency may be provided. Accordingly, in another embodiment is an electroluminescence device fabricated by using the composition according to an embodiment provided. Alternatively, use of the composition as a material for the electroluminescence device, for example, a material for forming a hole transport layer is provided.

### Electroluminescence Device

As described above, the composition according to an embodiment may be advantageously used in an electroluminescence device. The electroluminescence device may include a pair of electrodes facing each other, a light-emitting layer between the pair of electrodes, and at least one layer of an organic film between the light-emitting layer and one of the pair of electrodes, the at least one layer of an organic film includes the composition, or a material for forming an electroluminescence device. The electroluminescence device in accordance with an embodiment may exhibit excellent luminescent characteristics and luminous efficiency at low driving voltages. The electroluminescence device including a first electrode and a second electrode facing each other, a light-emitting layer between the first electrode and second electrode, and at least one layer of an organic film between the first electrode and the light-emitting layer, where the at least one layer of the organic film includes a thin film of a cured material of the composition according to an embodiment. The electroluminescence device may further include a light emitting layer between the electrodes, where the light emitting layer includes a light-emitting material capable of emitting light from triplet excitons.

An embodiment includes method for manufacturing an electroluminescence device including a pair of electrodes, a light-emitting layer between the pair of electrodes, and at least one layer of an organic film disposed between the light-emitting layer and one of the pair of electrodes, the at least one layer of an organic film is prepared from the composition according to an embodiment, where the at least one layer of an organic film is formed by a coating method. Accordingly, an embodiment provides an electroluminescence device in which at least one layer of the organic film is formed by a coating method.

The composition and material for preparing an electroluminescence device (i.e., EL device material) according to an embodiment (hereinafter collectively referred to as "polymeric compound/EL device material") may have excellent solubility in organic solvents. Accordingly, the composition/EL device material according to an embodiment may be advantageously used in manufacture of a device (e.g., a thin film) by a coating method (wet process). Accordingly, a liquid composition including a composition according to an embodiemnt and a solvent or dispersion medium is provided. The liquid composition may further contain a known dispersant.

As described above, the material for an electroluminescence device according to an embodiment may advantageously be used in the manufacture of an EL device (e.g., a thin film) by a coating method (wet process). In view of the above, the present embodiment provides a thin film including the composition according to an embodiment. A thin film like this is an example of a thin film according to an embodiment.

The material for an EL device according to the present embodiment may have excellent hole injection properties and hole mobility. Accordingly, the material may advantageously be used in formation of any organic film, such as a hole injection material, a hole transport material, or a light emitting material (host). In particular, the material may advantageously be used as a hole injection material or a hole transport material, or, for example, may advantageously be used as a hole transport material.

In an embodiment, the light emitting material is not particularly limited but may contain at least one of semiconductor nanocrystal particles (semiconductor inorganic nanoparticles) and/or perovskite-type compounds (perovskite-type halides). In an embodiment, the light emitting material may be a phosphorescent emitter, e.g., a phosphorescent emitter that emits in the blue region of the visible spectrum.

An electroluminescence device according to an embodiment will be described in detail with reference to FIG. 1. As shown in the Figure, the EL device 100 according to an embodiment comprises a substrate 110, a first electrode 120 on the substrate 110, a hole injection layer 130 on the first electrode 120, a hole transport layer 140 on the hole injection layer 130, an emitting layer 150 on the hole transport layer 140, an electron transport layer 160 on the emitting layer 150, an electron injection layer 170 on the electron transport layer 160, and a second electrode 180 on the electron injection layer 170.

The composition according to an embodiment may be included in, for example, one organic film (organic layer) between the first electrode 120 and the second electrode 180. Specifically, the composition may be included in a hole transport layer 140 as a hole transport material. That is, in an embodiment, the organic film including the composition according to an embodiment may be a hole transport layer.

An organic film including a composition/EL device material according to an embodiment may be formed by a coating method (solution coating method). For example, the organic film may be formed using a solution coating method such as a spin coat method, a casting method, a micro gravure coat method, a gravure coat method, a bar coat method, a roll coat method, a wire bar coat method, a dip coat method, a spray coat method, a screen printing method, a flexographic printing method, an offset printing method, or an ink jet printing method.

A solvent that can dissolve the composition/EL device material according to an embodiment may be used to provide the solution for the coating method, and may be appropriately selected depending on the type of polymeric compound used. Examples thereof may include toluene, xylene, ethylbenzene, diethylbenzene, mesitylene, propylbenzene, cyclohexylbenzene, dimethoxybenzene, anisole, ethoxytoluene, phenoxytoluene, isopropylbiphenyl, dimethylanisole, phenyl acetate, phenyl propionate, methyl benzoate, ethyl benzoate, or cyclohexane, etc. An amount of solvent used is not particularly limited, but considering ease of application, etc., the amount is such that the concentration of the composition may be, for example, greater than or equal to about 0.1 mass% and less than or equal to about 10 mass% or less, or for example, greater than or equal to about 0.5 mass% and less than or equal to about 5 mass%.

There is no particular limitation on the method for forming a film other than an organic film including a composition/EL device material according to an embodiment. A layer other than an organic film including a composition/EL device material according to an embodiment may be formed by, for example, a vacuum deposition method or a solution coating method.

The substrate 110 may be a substrate used as a general EL device. For example, the substrate 110 may be a semiconductor substrate such as, for example, a glass substrate, a silicon substrate, or a transparent plastic substrate.

The first electrode 120 is formed on the substrate 110. The first electrode 120 may be, for example, an anode, and may be formed by a metal, an alloy, a conductive compound, or the like having a large work function. For example, the first electrode 120 may be formed as a transparent electrode using indium tin oxide (In₂O₃-SnO₂: ITO), indium zinc oxide (In₂O₃-ZnO), tin oxide (SnO₂), or zinc oxide (ZnO), etc., which has excellent transparency and conductivity. The first electrode 120 may be formed as a reflective electrode by laminating magnesium (Mg), aluminum (Al), etc. on the transparent conductive film. After forming the first electrode 120 on the substrate 110, if necessary, cleaning and UV-ozone treatment may be performed.

The hole injection layer 130 may be formed on the first electrode 120. The hole injection layer 130 may be a layer that facilitates the injection of holes from the first electrode 120, and specifically, may be formed to have a thickness (dry film thickness; the same applies hereinafter) of, for example, about 10 nm to about 1000 nm, or for example, about 20 nm to about 50 nm.

The hole injection layer 130 may be formed using a known hole injection material. The known hole injection materials forming the hole injection layer 130 may include, for example, poly(ether ketone)-containg triphenylamine (TPAPEK), 4-isopropyl-4'-methyldiphenyliodonium tetrakis(pentafluorophenyl)borate (PPBI), N,N'-diphenyl-N,N'-bis-[4-(phenyl-m-tolyl-amino)-phenyl]-biphenyl-4,4'-diamine (DNTPD), copper phthalocyanine, 4,4',4"-tris(3-methylphenylphenylamino)triphenylamine (m-MTDATA), N,N'-di(1-naphthyl)-N,N'-diphenylbenzidine (NPB), 4,4',4"-tris(diphenylamino)triphenylamine (TDATA), 4,4',4"-tris(N,N-2-naphthylphenylamino)triphenylamine (2-TNATA), polyaniline/dodecylbenzenesulphonic acid, poly(3,4-ethylenedioxythiophene)/poly(4-styrenesulfonate): PEDOT/PSS, or polyaniline/10-camphorsulfonic acid.

The hole transport layer 140 may be formed on the hole injection layer 130. The hole transport layer 140 may be a layer having a function of transporting holes, and may be formed with a thickness of, for example, about 10 nm to about 150 nm, for example, about 20 nm to about 50 nm. The hole transport layer 140 may be formed by a solution coating method using a composition according to an embodiment. As demonstrated, the durability (luminescence life-span) of the EL device 100 may be extended by the presence of the polymeric compound in the hole transport layer. Moreover, it may also be demonstrated that an improvement in the current efficiency of the EL device 100 and/or reduction in the driving voltage is achieved. Moreover, because the hole transport layer may be formed by a solution coating method, a large-area film may be efficiently formed.

The light emitting layer 150 may be formed on the hole transport layer 140. The light emitting layer 150 may be a layer that emits light by fluorescence, phosphorescence, etc., and may be formed using a vacuum deposition method, spin coating method, inkjet printing method, etc. The light emitting layer 150 may be formed with a thickness of, for example, greater than or equal to about 10 nm and less than or equal to about 60 nm, or for example, greater than or equal to about 20 nm and less than or equal to about 50 nm. As the light emitting material of the light emitting layer 150, any known light emitting material may be used. The light emitting material included in the light emitting layer 150 may be a light emitting material capable of light emission from triplet excitons (i.e., phosphorescence). In this case, the life-span and luminous efficiency of the EL device 100 may be further improved.

The light emitting layer 150 is not particularly limited and may have a known configuration. For example, the light emitting layer includes at least one of semiconductor nanocrystal particles and a perovskite-type compound. That is, in an embodiment, the electroluminescence device may have a light emitting layer including at least one of semiconductor nanocrystal particles and a perovskite-type compound. When the emitting layer includes semiconductor nanocrystal particles, the EL device may be a quantum dot electroluminescence device (QLED), a quantum dot light emitting device, or a quantum dot light emitting diode. In addition, when the emitting layer includes a perovskite compound (perovskite halide), the EL device is a perovskite electroluminescence device (PeLED) or a perovskite light emitting device.

In the form of a light emitting layer including semiconductor nanocrystal particles (QLED), the light emitting layer is a single layer or multiple layers of a plurality of semiconductor nanocrystal particles (quantum dots). Semiconductor nanocrystal particles (quantum dots) are particles of a certain size that have a quantum confinement effect. The diameter of semiconductor nanocrystal particles (quantum dots) is not particularly limited, but may be approximately about 1 nm to about 20 nm.

The semiconductor nanocrystal particles (quantum dots) arranged in the light emitting layer may be synthesized by a wet chemical process, an organometallic chemical vapor deposition process, a molecular beam epitaxy process, or other similar processes. Among these, the wet chemical process is a method of growing particles by adding precursor materials to an organic solvent.

In a wet chemical process, when a crystal grows, an organic solvent is naturally distributed to the surface of the quantum dot crystal and acts as a dispersant, thereby controlling a growth of the crystal. Accordingly, in wet chemical processes, the growth of semiconductor nanocrystal particles may be controlled easily and at low cost compared to vapor deposition methods such as metal organic chemical vapor deposition (MOCVD) or molecular beam epitaxy (MBE).

Semiconductor nanocrystal particles (quantum dots) may control the energy band gap by controlling their size, whereby light of various wavelengths may be obtained from the light emitting layer (quantum dot light emitting layer). By using multiple quantum dots of different sizes, it is possible to create a display that emits (or emits light) light of multiple wavelengths. The size of the quantum dots may be selected to emit red, green, or blue light, enabling color displays to be constructed. Additionally, the size of the quantum dots may be combined to emit white light with various colors.

As the semiconductor nanocrystal particles (quantum dots), a semiconductor material selected from a Group II-VI semiconductor compound; a Group III-V semiconductor compound; a Group IV-VI group semiconductor compound; a Group IV element or compound; or a combination thereof may be used.

The Group II-VI semiconductor compound is not particularly limited, and examples thereof may include a binary compound selected from CdSe, CdTe, ZnS, ZnSe, ZnTe, ZnO, HgS, HgSe, HgTe, and a mixture thereof; a ternary compound selected from CdSeS, CdSeTe, CdSTe, ZnSeS, ZnTeSe, ZnSTe, HgSeS, HgSeTe, HgSTe, CdZnS, CdZnSe, CdZnTe, CdHgS, CdHgSe, CdHgTe, HgZnS, HgZnSe, HgZnTe, or a mixture thereof; and a quaternary compound selected from CdZnSeS, CdZnSeTe, CdZnSTe, CdHgSeS, CdHgSeTe, CdHgSTe, HgZnSeS, HgZnSeTe, HgZnSTe, or a mixture thereof.

The Group III-V semiconductor compound is not particularly limited, and examples thereof may include a binary compound selected from GaN, GaP, GaAs, GaSb, AIN, AlP, AlAs, AlSb, InN, InP, InAs, InSb, or a mixture thereof; a ternary compound selected from GaNP, GaNAs, GaNSb, GaPAs, GaPSb, AINP, AlNAs, AlNSb, AlPAs, AlPSb, InNP, InNAs, InNSb, InPAs, InPSb, or a mixture thereof; and a quaternary compound selected from GaAlNP, GaAlNAs, GaAINSb, GaAlPAs, GaAlPSb, GalnNP, GalnNAs, GaInNSb, GalnPAs, GalnPSb, InAlNP, InAlNAs, InAlNSb, InAlPAs, InAlPSb, or a mixture thereof.

The Group IV-VI semiconductor compound is not particularly limited, and examples thereof may include a binary compound selected from SnS, SnSe, SnTe, PbS, PbSe, PbTe, or a mixture thereof; a ternary compound selected from SnSeS, SnSeTe, SnSTe, PbSeS, PbSeTe, PbSTe, SnPbS, SnPbSe, SnPbTe, or a mixture thereof; and a quaternary compound selected from SnPbSSe, SnPbSeTe, SnPbSTe, or a mixture thereof.

The Group IV element or compound is not particularly limited, and examples thereof may include a single elemental selected from Si, Ge, or a mixture thereof; ot a binary elemental compound selected from SiC, SiGe, or a mixture thereof.

The semiconductor nanocrystal particles (quantum dots) may have a homogeneous single structure or a core-shell dual structure. The core and shell may include different materials. The material constituting each of core and shell may be composed of different semiconductor compounds. The energy bandgap of the shell material may be larger than the energy bandgap of the core material. For example, the core-shell structures may be ZnTeSe/ZnSe/ZnS, InP/ZnSe/ZnS, CdSe/ZnS, InP/ZnS, etc.

A process for making a quantum dot having a core (CdSe)/shell (ZnS) structure is described. First, a core (CdSe) precursor material such as (CH₃)₂Cd (dimethylcadmium) and TOPSe (trioctylphosphine selenide) is injected into an organic solvent using TOPO (trioctylphosphine oxide) as a surfactant to form a crystal. At this time, after maintaining the crystal at a high temperature for a certain period of time so that it grows to a certain size, a precursor material for the shell (ZnS) is injected to form a shell on the surface of the already formed core. This allows the production of TOPO-capped CdSe/ZnS quantum dots.

In a form (PeLED) in which the light emitting layer includes a perovskite-type compound (perovskite-type halide), the light emitting layer 150 may include a compound having a perovskite-type crystal structure (perovskite-type compound). The perovskite-type compound may include, for example, organic-inorganic hybrid materials or inorganic materials having a perovskite-type crystal structure represented by a general formula: ApMqXr.

In the above general formula, A may be at least one cation selected from a cation of an alkali metal element and an organic cation, M may be a cation of at least one metal element selected from a Group 14 element such as Ge, Sn, or Pb; a Group 15 element such as Sb or Bi; or a transition metal such as Cu, Ni, Co, Fe, Mn, Cr, Pd, Cd, or Ag, X may be at least one anion selected from a halide ion such as CI, Br, or I; cyanide, thiocyanate, isothiocyanate, or sulfide, p may represent an integer of 1 or more and 4 or less, q may represent 1 or 2, and r may represent an integer of 3 or more and 9 or less.

The A may include, for example, an alkali metal ion such as Li, Na, K, Rb, or Cs; or an organic cation such as an ammonium ion, a methylammonium ion, a formamidinium ion, a guanidium ion, an imidazolium ion, a pyridinium ion, or a pyridinium ion.

Specific examples of the perovskite compound may include, for example, the following compounds: CsPbI₃, CsSnI₃, CsPbBr₃, CsSnBr₃, CsPbCl₃, CsSnCl₃, RbPbI₃, RbSnl₃, RbPbBr₃, RbSnBr₃, RbPbCl₃, or RbSnCl₃, etc.

The perovskite compound may be obtained by known methods. The perovskite compound may be obtained by any one of the following methods: wet synthesis, dry synthesis by milling, and *in situ* synthesis.

The average particle diameter of the perovskite compound is not particularly limited, and may be, for example, greater than or equal to about 1 nm and less than or equal to about 100 nm, greater than or equal to about 1 nm and less than or equal to about 50 nm, or, for example, greater than or equal to about 1 nm and less than or equal to about 30 nm.

The perovskite-type compound may have a ligand on its surface. By coordinating appropriate ligands to the perovskite compound, the photoluminescence quantum yield may be improved. Examples of such a ligand may include, but are not particularly limited to, a crosslinking ligand compound such as an organic ammonium ion, an organic acid compound having two or more unsaturated bonds, or an organic base compound.

The method for forming the light emitting layer is not particularly limited. The light emitting layer may be formed by coating a coating solution including at least one of semiconductor nanocrystal particles and a perovskite-type compound (solution coating method). As a solvent constituting the coating solution, a solvent that does not dissolve the material in the hole transport layer, for example, a hole transport material, for example, a polymeric compound, may be selected. However, the hole transport layer formed using the composition according to an embodiment includes a cross-linked product formed by a thiol-ene bonding reaction between a polymer including a structural unit (A) represented by Chemical Formula 1 and a compound represented by Chemical Formula 10, and this cross-linked product increases the solvent resistance of the hole transport layer, thereby significantly increasing the durability against a solvent for forming the light-emitting layer. Accordingly, a hole transport layer formed using a composition according to an embodiment may exhibit a high film retention rate even for a solvent such as a solvent for forming a quantum dot inkjet composition.

The electron transport layer 160 may be formed on the light emitting layer 150. The electron transport layer 160 may be a layer that has the function of transporting electrons and may be formed by using a vacuum deposition method, spin coating method, inkjet method, or the like. The electron transport layer 160 may be formed to have a thickness of, for example, greater than or equal to about 15 nm and less than or equal to about 50 nm.

The electron transport layer 160 may be formed of a known electron transport material. Examples of known electron transport materials may include (8-quinolinolato)lithium (lithium quinolate, Liq), tris(8-quinolinolato)aluminium (Alq₃), or a compound having a nitrogen-containing aromatic ring. Examples of the compound having a nitrogen-containing aromatic ring may include a compound including a pyridine ring, such as, for example, 1,3,5-tri[(3-pyridyl)-phen-3-yl]benzene, a compound including a triazine ring, such as, for example, 2,4,6-tris(3'-(pyridin-3-yl)biphenyl-3-yl)-1,3,5-triazine, a compound including an imidazole ring, such as, for example, 2-(4-(N-phenylbenzimidazol-1-yl-phenyl)-9,10-dinaphthylanthracene or 1,3,5-tris(N-phenylbenzimidazol-2-yl)benzene (TPBI). The electron transport material may be used alone or as a mixture of two or more types.

The electron injection layer 170 may be formed on the electron transport layer 160. The electron injection layer 170 may be a layer that has the function of facilitating the injection of electrons from the second electrode 180. The electron injection layer 170 may be formed by using a vacuum deposition method or the like. The electron injection layer 170 may be formed to have a thickness of, for example, greater than or equal to about 0.1 nm and less than or equal to about 5 nm, or for example, greater than or equal to about 0.3 nm and less than or equal to about 2 nm. Any known material may be used as a material for forming the electron injection layer 170. For example, the electron injection layer 170 may be formed by a lithium compound such as, for example, (8-quinolinato)lithium (lithium quinolate, Liq), lithium fluoride (LiF), sodium chloride (NaCl), cesium fluoride (CsF), lithium oxide (Li₂O), or barium oxide (BaO).

The second electrode 180 may be formed on the electron injection layer 170. The second electrode 180 may be formed by using a vacuum deposition method or the like. The second electrode 180 may be, for example, a cathode, and may be formed by a metal, alloy, or conductive compound having a small work function. For example, the second electrode 180 may be formed as a reflective electrode using a metal, such as, for example, lithium (Li), magnesium (Mg), aluminum (Al), calcium (Ca), or an alloy, such as, for example, aluminum-lithium (Al-Li), magnesium-indium (Mg-In), or magnesium-silver (Mg-Ag). The second electrode 180 may be formed with a thickness of, for example, from about 10 nm to about 200 nm, for example, from about 50 nm to about 150 nm. Alternatively, the second electrode 180 may be formed as a transparent electrode by a thin film of the metal material having a thickness of 20 nm or less, a transparent conductive film, such as, for example, indium tin oxide (In₂O₃-SnO₂) or indium zinc oxide (In₂O₃-ZnO).

As described above, as an example of an electroluminescence device according to an embodiment, an EL device 100 according to the present embodiment has been **described.** The EL device 100 according to the present embodiment may have an increased film retention ratio when preparing a light-emitting layer by including a thin film prepared by curing a composition according to an embodiment at a low temperature of less than or equal to 200°C, and exhibit excellent hole injection property or hole transport property by not deteriorating another organic film present under the thin film, for example, a hole injection layer, by preparing the thin film with a heat-treatment at a low temperature, whereby exhibit excellent luminescent characteristics and high luminous efficiency (current efficiency) at a low driving voltage.

The stacked structure of the EL device 100 according to an embodiment is not limited to the above example. The EL device 100 according to an embodiment may be formed in another known stacked structure. For example, the EL device 100 may omit one or more of the hole injection layer 130, the electron transport layer 160, or the electron injection layer 170, and may additionally include another layer. Additionally, each layer of the EL device 100 may be formed as a single layer or as multiple layers.

For example, the EL device 100 may further include a hole blocking layer between the hole transport layer 140 and the light emitting layer 150 to prevent electrons or holes from diffusing into the electron transport layer 160. And, the hole blocking layer may be formed by, for example, an oxadiazole derivative, a triazole derivative, or a phenanthroline derivative.

In addition, the polymeric compound according to an embodiment may be applied to electroluminescence devices other than the QLED or PeLED. Other electroluminescence devices to which the polymeric compound according to an embodiment may be applied include, but are not particularly limited to, organic electroluminescence devices.

### Examples

The disclosure is described in more detail by providing the following representative examples and comparative examples. However, the scope of the claims is not limited to the representative examples.

In the following examples, unless specifically described, each operation was performed at room temperature (25 °C). In addition, unless specifically stated, "%" and "a part" mean "mass%" and "a part by mass", respectively. In addition, in the chemical formulas below, the description of "CₘH₂ₘ₊₁ (m is an integer)" indicating an alkyl group indicates a linear alkyl group unless specifically limited.

### Synthesis Example 1: Synthesis of Compound M-1

Compound M-1 is synthesized according to Reaction Scheme 1.

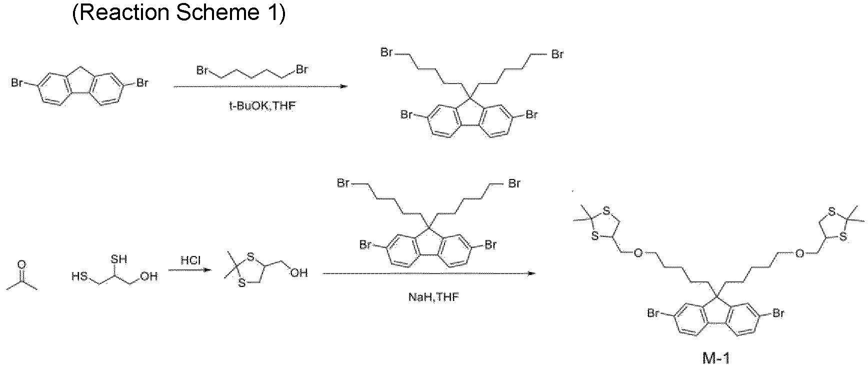

2,7-dibromofluorene (26.4 g) and tetrahydrofuran (THF) (400 mL) were added to a 1 L-four-necked (reaction) flask and stirred at 0 °C under a nitrogen atmosphere. Subsequently, tert-butoxy potassium (t-BuOK, 27.0 g) was added to the flask, and the mixture stirred at 0 °C for 10 minutes. A solution prepared by dissolving 1,5-dibromohexane (414 g) in THF (180 mL) was slowly added dropwise to the reaction flask and stirred at 0 °C for 30 minutes. After adding 200 mL of water to the reaction flask and following removal of the solvent under reduced pressure, extraction of the product was performed with ethyl acetate. After separating an aqueous layer, the organic layer was dried with magnesium sulfate. After removing the volatile organics and unreacted 1,6-dibromohexane under reduced pressure, the solid was washed with hexane to obtain 2,7-dibromo-9,9-bis(5-bromopentyl)-9H-fluorene (40.9 g).

To a 200 mL-four-necked (reaction) flask, 2,3-dimercapto-1-propanol (25.0 g) and acetone (100 mL) were added, to which one drop of 10N-HCl was added, and the mixture was stirred at room temperature for 12 hours. 25 g of magnesium sulfate was added and the mixture stirred for 1 hour. The magnesium sulfate was filtered off and the acetone was removed under reduced pressure to obtain (2,2-dimethyl-1,3-dithiolan-4-yl)methanol (31.6 g).

(2,2-dimethyl-1,3-dithiolan-4-yl)methanol (3.10 g), 2,7-dibromo-9,9-bis(5-bromopentyl)-9H-fluorene (5.83 g), and THF (38 mL) were charged into a 50 mL-four-necked (reaction) flask, and stirred under a nitrogen atmosphere at 0 °C. 64%-NaH (1.05 g) was added to the flask and the mixture stirred for 30 minutes, and then, further stirred at room temperature for 3 days. Additional NaH (0.3 g) was then added to the reaction flask, and the reaction mixture was stirred for 1 hour. Subsequently, the temperature of the reaction mixture was reduced to 0 °C and to the stirred mixture methanol was added to quench the reaction. After removing volatile organics under reduced pressure, extraction of the product residue was performed with ethyl acetate. A collected organic layer was washed with water, separated, and dried with magnesium sulfate. After removing solvent under reduced pressure, the product residue was purified through column chromatography (silica gel, hexane/dichloromethane) to obtain Compound M-1 (1.07 g).

### Synthesis Example 2: Synthesis of Compound M-2

Compound M-2 is synthesized according to Reaction Scheme 2.

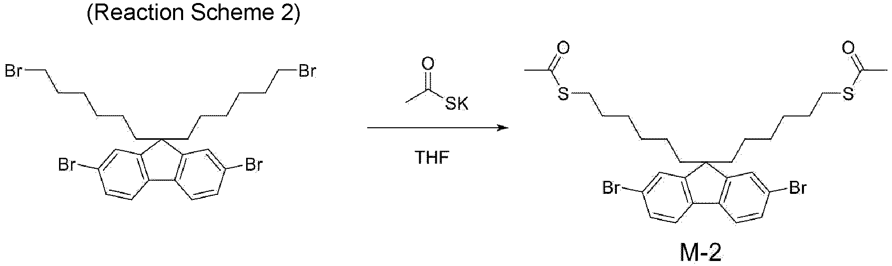

2,7-dibromo-9,9-bis(6-bromohexyl)-9H-fluorene (10.6 g) obtained in the same manner as in Synthesis Example 1, potassium thioacetate (5.28 g), and THF (154 mL) were charged into a 300 mL-four-necked flask and stirred under a nitrogen atmosphere at 60 °C for 3 hours. The resulting mixture was cooled to room temperature, and ion-exchange water (100 mL) was added to the mixture to provide an organic layer. The aqueous layer was extracted with dichloromethane (100 mL×3), and the extracts combined with the organic layer. The combined product dichloromethane solution was washed with saturated brine (100 mL×3), separated from the aqueous layer, and dried with magnesium sulfate. After removing the volatile organics under reduced pressure, the product residue was purified through column chromatography (silica gel, hexane/toluene) to obtain Compound M-2 (7.84 g).

### Synthesis Example 3: Synthesis of Compound C-1

Compound C-1 is synthesized according to Reaction Scheme 3.

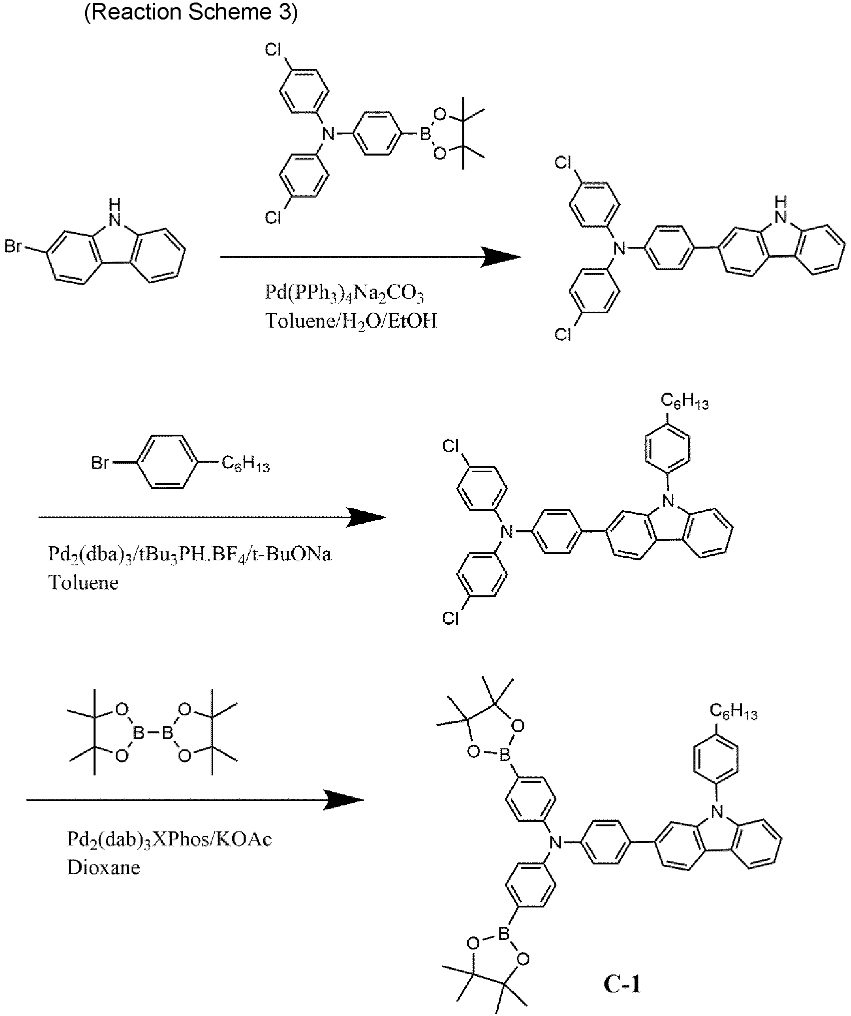

2-bromocarbazole (20.0 g), 4-chloro-N-(4-chlorophenyl)-N-(4-(4,4,5,5-tetramethyl-1,3,2-dioxaborane-2-yl)phenyl)aniline (10.0 g), sodium carbonate (4.84 g), tetrakis(triphenylphosphine)palladium (0) (Pd(PPh₃)₄, 1.31 g), toluene (80 mL), ethanol (30 mL), and water (30 mL) were charged into a 100 mL-four-necked (reaction) flask, and stirred at 100 °C (a bath temperature) for 3 hours. After cooling to room temperature, an aqueous layer was separated and removed, and the organic layer was washed with water (100 mL×2), separated, and dried with magnesium sulfate. After removing organic volatiles under a reduced pressure, toluene (200 mL) was added to the residue, refluxed at 60 °C for 1 hour, and a solid was filtered, collected and dried to obtain N-(4-(9-carbazole-2-yl)phenyl)-4-chloro-N-(4-chlorophenyl)aniline (6.08 g).

Subsequently, the obtained N-(4-(9-carbazole-2-yl)phenyl)-4-chloro-N-(4-chlorophenyl)aniline (6.00 g), 1-bromo-4-hexylbenzene (3.00 g), tris(dibenzylideneacetone)dipalladium (Pd₂(dba)₃, 0.580 g), tri-tert-butylphosphoniumtetrafluoroborate (t-Bu₃PH·BF₄, 0.276 g), sodium tert-butoxide (t-BuONa, 2.43 g), and toluene (60 mL) were charged into a four-necked flask substituted with argon and heated at 110 °C for 7 hours. After cooling to room temperature, solid impurities were filtered out with Celite as a filter agent. The solvent was removed from the filtrate solution under reduced pressure, and the product residue was purified through column chromatography to obtain 4-chloro-N-(4-chlorophenyl)-N-(4-(9-(4-hexylphenyl)-9-carbazole-2-yl)phenyl)aniline (1.60 g).

The obtained 4-chloro-N-(4-chlorophenyl)-N-(4-(9-(4-hexylphenyl)-9-carbazole-2-yl)phenyl)aniline (1.60 g), bispinacol diborate (1.90 g), potassium acetate (KOAc,1.47g), tris(dibenzylideneacetone)dipalladium (Pd₂(dba)₃, 0.114 g), Xphos (0.177 g), and 1,4-dioxane (16 mL) were charged into a 50 mL-3-neck flask and stirred under a nitrogen atmosphere at a bath temperature of 100 °C for 3 hours. After cooling to room temperature, insoluble solids were removed with Celite. The solvent was removed from the filtrate solution under a reduced pressure, and the product residue was combined with a mixed solvent of toluene (20 mL), hexane (40 mL), and activated carbon (2.0 g). and the resulting mixture was refluxed for 30 minutes. After removing (filtering) insoluble solids with Celite solvent was removed under reduced pressure, and the residue was recrystallized with toluene/acetonitrile to obtain Compound C-1 (1.85 g).

### Synthesis Example 4: Synthesis of Polymer P-1

Under a nitrogen atmosphere, Compound M-1 (0.141 g) according to Synthesis Example 1, Compound C-1 (1.438 g) according to Synthesis Example 3, 2,7-dibromo-9,9-di-n-decylfluorene (hereinafter, also described as "Compound D-1," 0.941 g), dichlorobis[di-tert-butyl(p-dimethylaminophenyl)phosphine]palladium (II) (12.1 mg), toluene (50 mL), and a 20 mass% tetraethylammonium hydroxide aqueous solution (9.01 g) were added to a four-necked flask and the mixture stirred at 85 °C for 2 hours. Afterwards, phenylboronic acid (211 mg), bis(triphenylphosphine) palladium(II) dichloride (73.6 mg), and a 20 mass% tetraethylammonium hydroxide aqueous solution (9.01 g) were added to the flask, and stirred at 85 °C for 6 hours. Then, sodium N,N-diethyldithiocarbamate trihydrate (5.91 g) dissolved in ion-exchange water (50 mL) was added to the flask, and stirred at 85 °C for 6 hours. Under a nitrogen atmosphere, after separating an organic layer and an aqueous layer, the organic layer was sequentially washed with ion-exchange water (50 mL×2), a saturated NH₄Cl aqueous solution (50 mL×5), and ion-exchange water (50 mL×2).

Methanol was added to the washed organic layer to facilitate the formation of solids, and the solids washed with methanol, filtered, and vacuum-dried. The dried solid was dissolved in toluene (20 mL), and activated alumina (9.0 g) and Celite (4.5 g) were added to the toluene solution, which was stirred at 90 °C for 1 hour, and the solids were filtered off. Upon addition of methanol to the filtrate a solid precipitated, filtered and vacuum-dried. The obtained solid was dissolved in toluene (50 mL), an ion exchange resin (a mixture of 0.5 parts by weight of a cation exchange resin and 0.5 parts by weight of an anion exchange resin, 10 g) was added to the toluene solution, and stirred at room temperature for 12 hours. The ion exchange resin was filtered off, and a solid reprecipitated with methanol, and vacuum-dried to obtain a P-1 precursor (0.747 g).

Thereafter, P-1 precursor (0.730 g), a Dess-Martin reagent (648 mg), toluene (28 mL), and ion-exchange water (7 mL) were charged into a 2-necked flask, and stirred under a nitrogen atmosphere at room temperature for 12 hours. An organic layer was separated and added dropwise to methanol to precipitate a solid, which was separated and vacuum-dried. The obtained solid was dissolved in toluene (50 mL), and an anion exchange resin (10 g) was added and stirred for 12 hours. The ion exchange resin was filtered off, the filtrate was added dropwise to methanol to precipitate a solid. The solid was filtered, dissolved in toluene, and the solution was added dropwise to methanol to precipitate a solid, which was filtered and dried to obtain Polymer P-1 (0.634 g). Polymer P-1 was measured with respect to a weight average molecular weight (Mw) and polydispersity (Mw/Mn) by SEC; Mw was 202,000 Da (Dalton), and Mw/Mn was 3.34.

Polymer P-1 was determined from an input ratio of monomers to have the following structural unit.

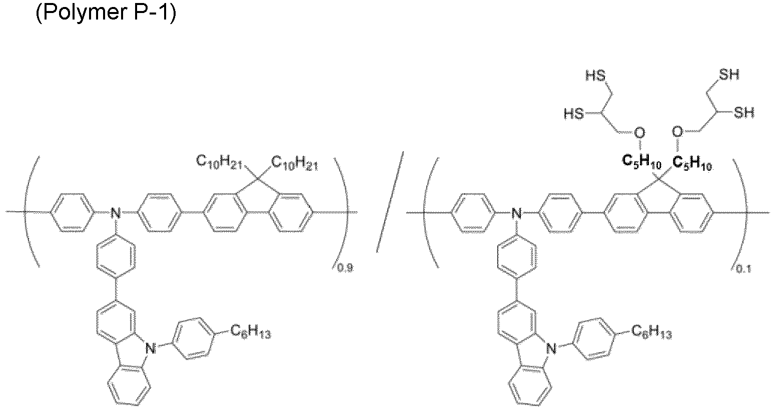

### Synthesis Example 5: Synthesis of Polymer P-2

Under a nitrogen atmosphere, Monomer M-2 (0.111 g) according to Synthesis Example 2, Compound C-1 (1.434 g) according to Synthesis Example 3, 2,7-dibromo-9,9-di-n-decylfluorene (Compound D-1, 0.939 g), dichlorobis[di-tert-butyl(p-dimethylaminophenyl)phosphine]palladium(II) (12.3 mg), toluene (54 mL), and a 20 mass% tetraethylammonium hydroxide aqueous solution (8.99 g) were charged into a four-necked flask, and stirred at 85 °C for 2 hours. Subsequently, phenylboronic acid (211 mg), bis(triphenylphosphine)palladium(II) dichloride (73.6 mg), and a 20 mass% tetraethylammoniumhydroxide aqueous solution (9.01 g) were added to the flask, and stirred at 85 °C for 6 hours. Then, a solution prepared by dissolving sodium N,N-diethyldithiocarbamate trihydrate (5.89 g) in ion-exchange water (50 mL) was added to the flask, and stirred at 85 °C for 6 hours. Under the nitrogen atmosphere, after separating an organic layer from the aqueous layer, the organic layer was sequentially washed with ion exchange water (50 mL×2), a saturated NH₄Cl aqueous solution (50 mL×5), and ion exchange water (50 mL×2).

Upon addition of methanol to the washed organic layer the solid obtained was washed with methanol, filtered, and vacuum-dried. The dried solid was dissolved in toluene (20 mL), and activated alumina (9.0 g) and Celite (4.5 g) were added, the mixture was stirred at 90 °C for 1 hour, and filtered. Upon addition of methanol to the filtrate a solid formed, which was filtered and vacuum-dried. The obtained solid was dissolved in toluene (50 mL), and an ion exchange resin (a mixture of 0.5 parts by mass of a cation exchange resin and 0.5 parts by mass of an anion exchange resin, 10 g) was added, and the mixture was stirred at room temperature for 12 hours. The ion exchange resin was filtered off and upon the addition of methanol a solid was obtained, separated, and vacuum-dried to obtain P-2 precursor (0.785 g).

Thereafter, the P-2 precursor (0.730 g), a Dess-Martin reagent (365 mg), toluene (20 mL), and ion-exchange water (20 mL) were charged into a 2-neck flask, and stirred under a nitrogen atmosphere at room temperature for 12 hours. An organic layer was separated from the mixture and was added dropwise to methanol to precipitate a solid, which was then filtered and vacuum-dried. The obtained solid was dissolved in toluene (50 mL), 10 g of an anion exchange resin was added, and the mixture stirred for 12 hours. The ion exchange resin was filtered off and the filtrate was added dropwise to methanol to obtain a solid that was then dissolved in toluene. The solution was again added dropwise to methanol to precipitate a solid, which was filtered and dried to obtain Polymer P-2 (0.491 g). Polymer P-2 was measured with respect to a weight average molecular weight (Mw) and polydispersity (Mw/Mn) by SEC; Mw was 277,000 Da, and Mw/Mn was 2.56.

Polymer P-2 was determined from an input ratio of monomers to have the following structural unit.

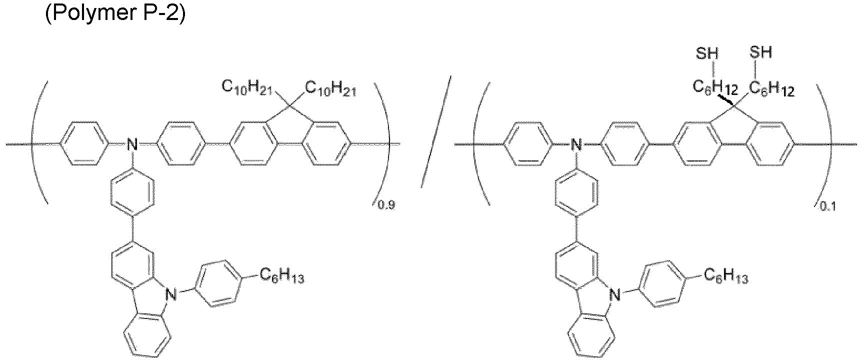

### Synthesis Example 6: Preparation of a Low Molecular Weight Compound

A compound represented by the following chemical formula was purchased from Alfa Chemistry and used in the following syntheses.

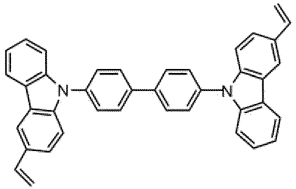

### Example 1: Preparation of Composition 1

The polymer P-2 manufactured in Synthesis Example 5 and the compound prepared in Synthesis Example 6 were mixed in a weight ratio of 2:1 and dissolved in an o-xylene at a solid concentration of 1 wt%, and 0.1 wt% of Irgacure369, a photoinitiator, based on the weight of Polymer P-2, was added to prepare Composition 1 according to Example 1.

### Example 2: Preparation of Composition 2

The polymer P-1 manufactured in Synthesis Example 4 and the compound prepared in Synthesis Example 6 were mixed in a weight ratio of 2:1 and dissolved in an o-xylene solvent at a solid concentration of 1 wt%, and 0.1 wt% of Irgacure369, a photoinitiator, based on the weight of Polymer P-2, was added to prepare Composition 2 according to Example 2.

### Comparative Examples 1 to 3: Preparation of Comparative Compositions 1 to 3

Comparative Composition 1 was prepared by dissolving Polymer P-2 prepared in Synthesis Example 5 alone in an o-xylene solvent at a concentration of 0.1 wt%, without adding the compound prepared in Synthesis Example 6.

Comparative Composition 2 was prepared by dissolving Polymer P-1 prepared in Synthesis Example 4 alone in an o-xylene solvent at a concentration of 0.1 wt%, without adding the compound prepared in Synthesis Example 6.

Comparative Composition 3 was prepared by dissolving the compound prepared in Synthesis Example 6, Polymer P-1 alone in an o-xylene solvent at a concentration of 0.1 wt%, without adding any polymer prepared in Synthesis Example 4 or Synthesis Example 5.

### Manufacturing Example 1: Fabrication and Evaluation of Thin Film

The compositions according to Examples 1 and 2 and Comparative Examples 1 to 3 were each coated on a glass substrate using a spin coating method, and each of the deposited compositions of Examples 1 and 2, and Comparative Examples 1 to 3, were heated to 150 °C and to 190 °C to produce thin films, and the thicknesses of the produced thin films were measured. Thereafter, the glass substrates on which the thin films were formed were immersed in cyclohexylbenzene, and following removal from the cyclohexylbenzene, the thicknesses of the obtained thin films were measured. The thickness of each thin film before immersion in cyclohexylbenzene and the thickness of each thin film after immersion in cyclohexylbenzene are shown in Table 1, and the ratio of the thickness after immersion in cyclohexylbenzene to the thickness before immersion in cyclohexylbenzene is described as a film retention ratio in Table 1.

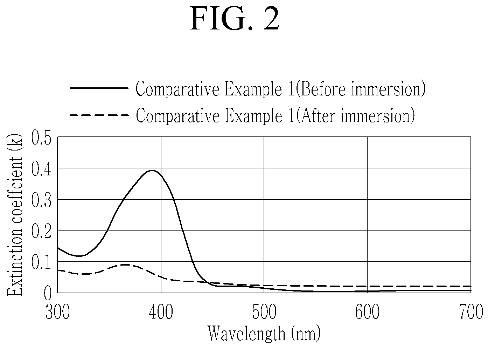

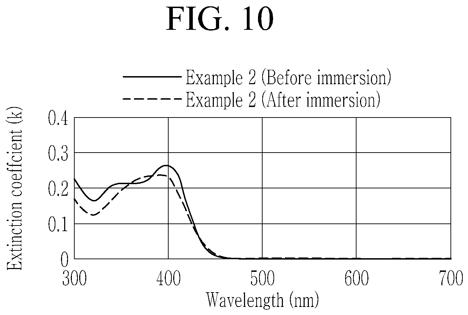

In addition, absorption coefficients of each thin film prepared by curing each composition according to the Examples and Comparative Examples at 150 °C and 190 °C were determined before and after immersing the thin films in cyclohexylbenzene using an ellipsometer for wavelengths from about 300 nm to about 700 nm, and the results are indicated in the spectra of FIGS. 2 to 11.

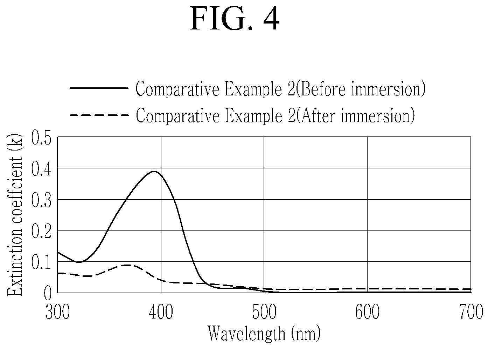

Referring to the spectra of FIGS. 2 and 4, when both the compositions according to Comparative Examples 1 and 2 were cured at 150°C, and then immersed in cyclohexylbenzene, the absorption coefficients between about 300 nm and about 450 nm were almost non-existent compared to before cyclohexylbenzene immersion, indicating that the thin films were almost dissolved by cyclohexylbenzene, resulting in very low film retention rates.

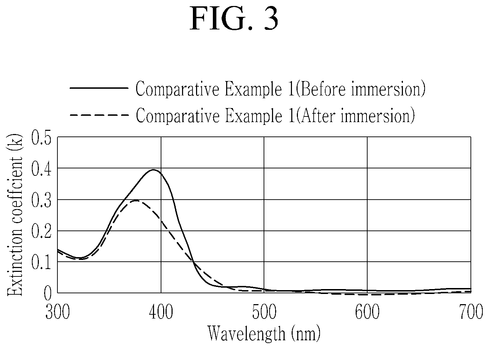

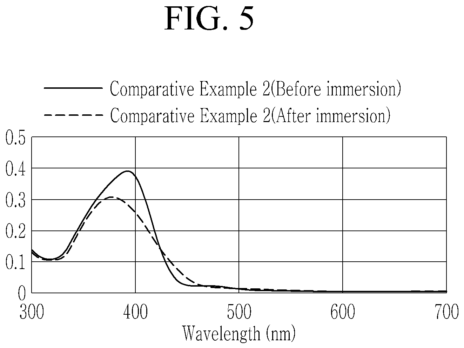

In contrast, referring to the spectra of FIGS. 3 and 5, it can be confirmed that when both the compositions according to Comparative Examples 1 and 2 were cured at 190°C, the absorption coefficients between about 300 nm and about 450 nm decreased after cyclohexylbenzene immersion compared to before cyclohexylbenzene immersion, but relatively higher film retention rates were observed compared to when cured at 150°C. That is, as demonstrated the film retention rate of the polymer can be increased by curing at a higher temperature.

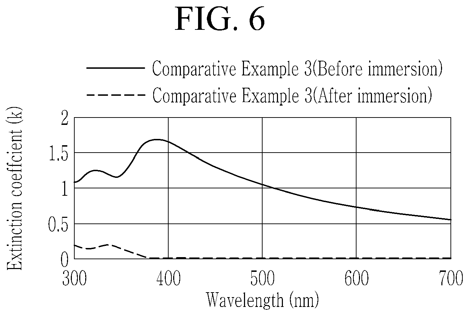

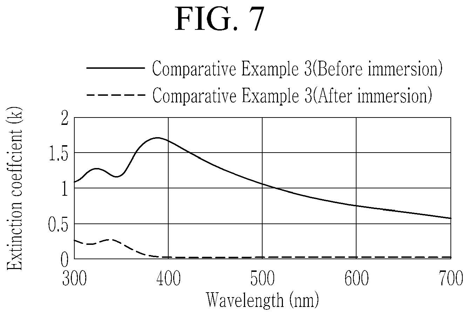

In the case of the thin film manufactured from the composition according to Comparative Example 3, curing at 150°C (FIG. 6) and 190°C (FIG. 7), the absorption coefficients for wavelengths between 300 nm to 400 nm were significantly lower after cyclohexylbenzene immersion than before cyclohexylbenzene immersion, indicating that for the low-molecular weight compounds compared to the relatively high-molecular weight compounds, the resistance to solvents is significantly low even when cured at a relatively high temperature.

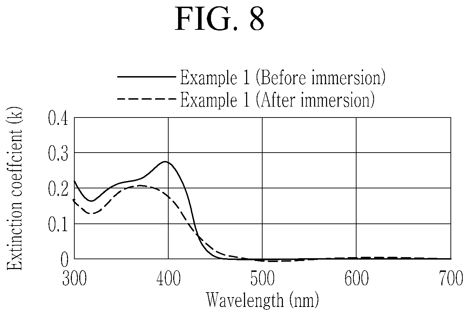

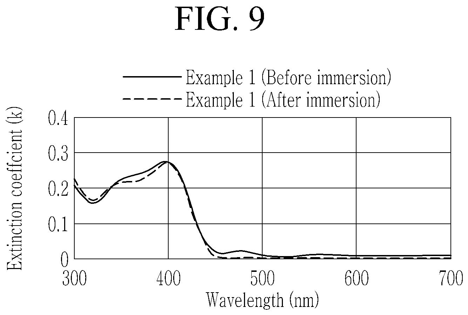

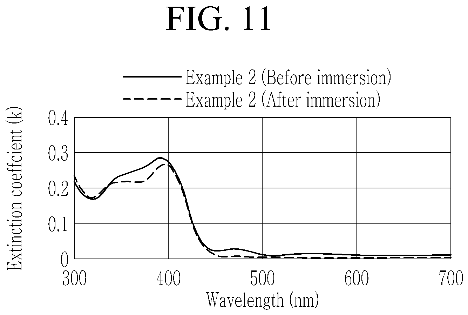

On the other hand, the thin films manufactured by heat-treating the compositions according to Examples 1 and 2 at 150°C and 190°C the absorption coefficients before and after immersion in cyclohexylbenzene as indicated from the spectra of FIGS. 8 to 11, exhibit differences in the films manufactured at the two different temperatures. Examples 1 and 2 by curing at 150°C showed slightly lower absorption coefficients after being immersed in cyclohexylbenzene than before being immersed in cyclohexylbenzene. However, compared to the thin films according to the comparative examples, the degree of decrease in the absorption coefficient is minimal. Moreover if the compositions of Example 1 and 2 are cured at 190°C, the absorption coefficients after immersion do not appear to exhibit a decrease in absorption coefficient, if any, compared to before cyclohexylbenzene treatment (see, FIG. 9 and FIG. 11).

Accordingly, by heat-treating a composition including both a polymer including a thiol group and a low-molecular-weight compound including a vinyl group according to an embodiment at a low temperature of 190°C or less, a cross-linked product is formed between the polymer and the low-molecular-weight compound by a thiol-ene bonding reaction between the thiol group and the vinyl group, so that the solvent resistance of a thin film is significantly increased, and thus the film retention rate of the thin film is significantly increased even after cyclohexylbenzene treatment. The results are shown in Table 1.

**Table 1**

| | | | Comp. Ex. 1 | | Ex. 1 | | Comp. Ex. 2 | | Ex. 2 | | Comp. Ex. 3 | |
|---|---|---|---|---|---|---|---|---|---|---|---|---|
| Film retention rate (%) | 150°C | Thickness before immersion | 27.2 nm | 37% | 25.8 nm | 62% | 27.7 nm | 38% | 26.7 nm | 71% | 26.0 nm | 42% |
| | | Thickness after immersion | 10.1 nm | | 16.0 nm | | 10.5 nm | | 19.0 nm | | 10.8 nm | |
| | 190°C | Thickness before immersion | 26.6 nm | 56% | 25.7 nm | 98% | 28.0 nm | 64% | 26.5 nm | 100% | 25.7 nm | 58% |
| | | Thickness after immersion | 15.0 nm | | 25.1 nm | | 17.9 nm | | 26.9 nm | | 14.8 nm | |

### Manufacturing Example 2-1:

### Manufacturing and Evaluation of Quantum Dot Electroluminescence Device 1

As a first electrode (an anode), an ITO-attached glass substrate, on which indium tin oxide (ITO) was patterned to have a film thickness of 150 nm, was used. This ITO-attached glass substrate was sequentially washed with a neutral detergent, deionized water, water, and isopropylalcohol, and treated with UV-ozone. Subsequently, on this ITO-attached glass substrate, poly(3,4-ethylenedioxythiophene)/poly(4-styrenesulfonate)(PEDOT/PSS) (Sigma-Aldrich Co., Ltd.) was spin-coated to have a dry film thickness of 30 nm, and dried. As a result, a hole injection layer with a thickness (dry film thickness) of 30 nm was formed on the ITO-attached glass substrate.

On the hole injection layer, a toluene solution including a composition, e.g., the composition according to Example 1, that contains Polymer P-2 according to Synthesis Example 5 and the compound according to Synthesis Example 6 was spin-coated to have a dry film thickness of 30 nm. The applied composition was heat-treated at 150 °C for 60 minutes to form a hole transport layer. As a result, the hole transport layer with a thickness (dry film thickness) of 30 nm was formed on the hole injection layer.

A quantum dot dispersion was prepared by dispersing blue quantum dots of ZnTeSe/ZnSe/ZnS (core/shell/shell; an average diameter of about 10 nm) to be 1.0 mass% in cyclohexylbenzene. The quantum dot dispersion was spin-coated on the hole transport layer to have a dry film thickness of 30 nm, and dried. As a result, a quantum dot light emitting layer having the thickness (dry film thickness) of 30 nm was formed on the hole transport layer. The light emitted by the quantum dot dispersion upon irradiation of ultraviolet rays has a central wavelength of 462 nm and a full width at half maximum (FWHM) of 30 nm.

The quantum dot light emitting layer was completely dried. On this quantum dot light emitting layer, (8-quinolinolato)lithium (lithium quinolate, Liq₈) and 1,3,5-tris(N-phenylbenzimidazole-2-yl)benzene (TPBI) (Sigma-Aldrich Co., Ltd.) as an electron transport material were co-deposited by using a vacuum deposition device. As a result, an electron transport layer with a thickness of 36 nm was formed on the quantum dot light emitting layer.

On the electron transport layer, (8-quinolinolato)lithium (lithium quinolate, Liq₈) was deposited by using the vacuum deposition device. As a result, a 0.5 nm-thick electron injection layer was formed on the electron transport layer.

On the electron injection layer, aluminum (Al) was deposited by using the vacuum deposition device. As a result, a 100 nm-thick second electrode (a cathode) was formed on the electron injection layer. In this way, Quantum Dot Electroluminescence Device 1 was obtained.

### Manufacturing Example 2-2:

### Manufacturing of Quantum Dot Electroluminescence Device 2

Quantum Dot Electroluminescence Device 2 was manufactured in the same manner as in Manufacturing Example 2-1, except that a hole transport layer was formed by heat-treating the composition according to Example 2 at 150 °C for 60 minutes.

### Manufacturing Example 2-3:

### Manufacturing of Quantum Dot Electroluminescence Device 3

Quantum Dot Electroluminescence Device 3 was manufactured in the same manner as in Manufacturing Example 2-1, except that a hole transport layer was formed by heat-treating the composition according to Example 1 at 190 °C for 60 minutes.

### Manufacturing Example 2-4:

### Manufacturing of Quantum Dot Electroluminescence Device 4

Quantum Dot Electroluminescence Device 4 was manufactured in the same manner as in Manufacturing Example 2-1, except that a hole transport layer was formed by heat-treating the composition according to Example 2 at 190 °C for 60 minutes.

### Comparative Manufacturing Example 1:

### Manufacturing of Comparative Quantum Dot Electroluminescence Device 1

Comparative Quantum Dot Electroluminescence Device 1 was manufactured in the same manner as in Manufacturing Example 2-1, except that a hole transport layer was formed by using the composition according to Comparative Example 1 that contains Polymer P-2 according to Synthesis Example 5 (alone, i.e., in the absence of a compound of Synthesis Example 6), instead of the composition according to Example 1.

### Comparative Manufacturing Example 2: Manufacturing of Comparative Quantum Dot Electroluminescence Device 2

Comparative Quantum Dot Electroluminescence Device 2 was manufactured in the same manner as in Manufacturing Example 2-1, except that a hole transport layer was formed by using the composition according to Comparative Example 2 that contains Polymer P-1 according to Synthesis Example 4 (alone, i.e., in the absence of a compound of Synthesis Example 6), instead of the composition according to Example 1.

### Comparative Manufacturing Example 3: Manufacturing of Comparative Quantum Dot Electroluminescence Device 3

Comparative Quantum Dot Electroluminescence Device 3 was manufactured in the same manner as in Manufacturing Example 2-1, except that a hole transport layer was formed by using the composition according to Comparative Example 3 that contains the low-molecular-weight compound according to Synthesis Example 6 (alone, i.e., in the absence of Polymer P-2), instead of the composition according to Example 1.

### Evaluation of Electroluminescence Devices

Quantum Dot Electroluminescence Devices 1 to 4 of Manufacturing Examples 2-1 to 2-4, and Comparative Quantum Dot Electroluminescence Devices 1 to 3 of Comparative Manufacturing Examples 1 to 3 were evaluated with respect to maximum external quantum efficiency (EQE_{Max}), maximum luminance (Lum. Max.), luminous efficiency at 20,000 nit (EQE@20000nit), voltage at 5 mA (V@5mA), luminance at 5 mA (Cd/m²) (Cd/m²@5mA), and durability (Max. T90, T90, T50) as described using the methods described below. The data results are listed in Table 2.

External quantum efficiency (EQE) refers to the ratio of the number of photons emitted from a given light-emitting device to the number of electrons passing through the light-emitting device. EQE may be a measure of how efficiently a light-emitting device converts electrons into photons and allows them to escape. Here, maximum external quantum efficiency (EQE_{Max}) refers to the maximum value of external quantum efficiency.

### Luminous efficiency (External Quantum Efficiency (EQE))

When a voltage was applied to each of the quantum dot electroluminescence devices, as a current began to flow at a predetermined voltage, the quantum dot electroluminescence devices emitted light. The voltage was slowly increased for each device by using a DC constant voltage power supply (Keithley 2200) to measure a current at this point, and in addition, a luminance meter (Minolta CS200) was used to measure luminance of the devices at the light emission. The luminance measurement was stopped at the point where the luminance started to attenuate.

In addition, a spectral radiance luminance spectrum measured by the luminance meter, assuming that Lambertian radiation was performed, was used to calculate maximum external quantum efficiency (EQEₘₐₓ) (%), which was used to evaluate the luminous efficiency.

### T90, T50, and Max. T90

A DC constant voltage power supply (Keithley 2200) was used to apply a predetermined voltage to each of the quantum dot electroluminescence devices resulting in light emission. Luminance of each device was measured by using a luminance meter (Minolta CS200) by slowly increasing the applied current. The device was then operated by maintaining the current constant when the luminance reached 650 nit (cd/m²). Over time the luminance of the device decreases, the amount of time taken to reach 90% of the initial luminance (100%) of the device was measured as "T90 (h), and the amount of time taken to reach 50% of the initial luminance (100%) of the device was measured as "LT50 (hr).

Accordingly, Max T90 refers to the time required for the brightness of a given device to decrease from maximum brightness (100%) to 90% when the device is driven at a given brightness. Here, maximum brightness (Lum. Max.) refers to the maximum brightness that the device can achieve.

**Table 2**

| Device | EQE Max | Lum. Max. (cd/m²) | EQE @ 20000nit | V @5mA | Cd/m² @5mA | Max T90 (h) | T90 (h) | **T50** (h) |
|---|---|---|---|---|---|---|---|---|
| Comp. Mfg. Ex. 1 | 1.6 | 34218 | 1.3 | 2.4 | 57.7 | 8.82 | 36.25 | 56.7 |
| Comp. Mfg. Ex. 2 | 1.8 | 36692 | 1.4 | 2.4 | 68.9 | 6.42 | 39.53 | 66.2 |
| Comp. Mfg. Ex. 3 | 2.2 | 21389 | 2.1 | 3.4 | 57.7 | 0.14 | 0.97 | 1.1 |
| Mfg. Ex. 2-1 | 3.1 | 38792 | 2.2 | 2.6 | 137.4 | 7.75 | 29.62 | 51.4 |
| Mfg. Ex. 2-2 | 3.5 | 39179 | 2.6 | 2.6 | 162.4 | 8.15 | 14.70 | 80.4 |
| Mfg. Ex. 2-3 | 7.5 | 67155 | 6.4 | 3.4 | 312.6 | 15.41 | 18.45 | 101.5 |
| Mfg. Ex. 2-4 | 6.6 | 63098 | 6.0 | 3.3 | 311.3 | 10.79 | 21.68 | 109.6 |

Referring to the results of Table 2, Quantum Dot Electroluminescence Devices 1 to 4 of Manufacturing Examples 2-1 to 2-4, which contain hole transport layers prepared by using the composition according to an embodiment, compared with Comparative Quantum Dot Electroluminescence Devices 1 and 2, which contain hole transport layer prepared by using the composition containing the polymers alone, and Comparative Quantum Dot Electroluminescence Device 3, which contains a hole transport layer prepared by using the composition containing the low-molecular-weight compound alone, instead of the composition according to an embodiment, confirmed that the maximum external quantum efficiency (EQE_{Max}) is at least about 1.5 times greater to about 3.5 times greater, the maximum brightness is also at least about 1.1 times greater to nearly 3 times greater, and the external quantum efficiency at high brightness of 20,000 nits (EQE@20,000nits) and the voltage and brightness at 5 mA are also significantly greater. That is, it can be demonstrated that the quantum dot electroluminescent devices manufactured with the compositions according to an embodiment to the hole transport layer exhibit better luminescence characteristics and luminous efficiency than the comparative quantum dot electroluminescent devices.

In addition, Max T90, T90, and T50, etc. of the quantum dot electroluminescent devices of Manufacturing Examples 2-1 to 2-4 are much greater than those of the comparative quantum dot electroluminescent devices, indicating that the quantum dot electroluminescent device including a hole transport layer prepared by using the composition according to an embodiment also has excellent durability (significantly long luminescence life-span).

In particular, it can be seen that, compared to quantum dot electroluminescent devices 1 and 2 of Manufacturing Examples 2-1 and 2-2, which were formed by curing the compositions according to Examples 1 and 2 at 150°C to form a hole transport layer, quantum dot electroluminescent devices 3 and 4 according to Manufacturing Examples 2-3 and 2-4, in which the hole transport layer was formed by curing the compositions at 190°C, exhibit significantly superior luminescence characteristics and superior luminous efficiency and lifespan compared to comparative quantum dot electroluminescent devices 1 to 3. That is, by curing at 190°C, which is higher than 150°C, the thiol-ene bonding reaction during the heat treatment of the applied composition according to an embodiment appears to be more complete (more crosslinking), and as a result, a denser cross-linked structure is formed so that the film retention ratio of the hole transport layer is further increased. As a result, better hole transport characteristics are demonstrated with the films cured at 190° C, and the physical properties of the electroluminescent device including the same are also improved upon.

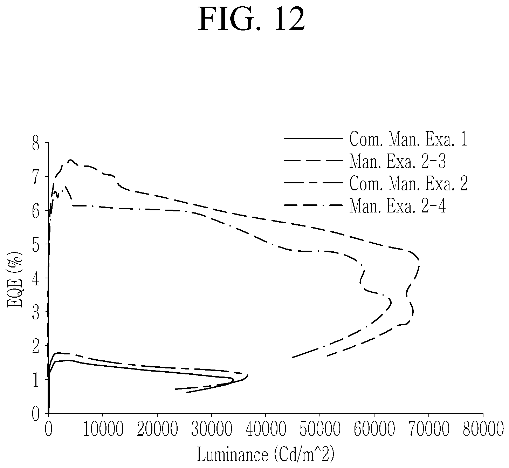

FIG. 12 is a graph showing external quantum efficiency to luminance of quantum dot electroluminescent devices 1 and 2 according to Comparative Manufacturing Examples 1 and 2, and quantum dot electroluminescent devices 3 and 4 according to Manufacturing Examples 2-3 and 2-4. From FIG. 12, it can be seen that comparative quantum dot electroluminescent devices 1 and 2 including hole transport layers made only of a polymer including a thiol group, when cured at about 150°C to form the hole transport layer, have significantly lower external quantum efficiencies than quantum dot electroluminescent devices 3 and 4 in which the hole transport layer was formed by curing the composition according to Examples 1 and 2 at 190° C, and can hardly function as electroluminescent devices.

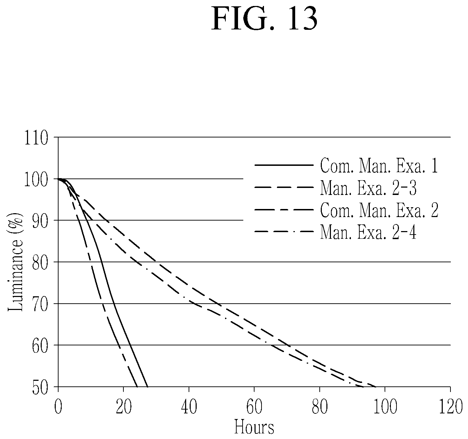

FIG. 13 is a graph showing the decrease in luminance over time of quantum dot electroluminescent devices 3 and 4 according to Manufacturing Examples 2-3 and 2-4, compared to comparative quantum dot electroluminescent devices 1 and 2 according to Comparative Manufacturing Examples 1 and 2. From FIG. 13, it can be seen that the comparative quantum dot electroluminescent devices 1 and 2, in which a composition consisting only of a polymer including a thiol group was cured at 150°C to form a hole transport layer, show a luminance decrease to half (50%) of the initial luminance after about 20 hours. In contrast, the quantum dot electroluminescent devices 3 and 4, in which a hole transport layer was formed by curing the composition according to Examples 1 and 2 at 190°C, took more than 90 hours, or about 100 hours, to show a luminance decrease to 50% of the initial luminance. That is, it is confirmed that the quantum dot electroluminescent device formed by curing a composition according to an embodiment at 190°C to form a hole transport layer is significantly superior in durability compared to the electroluminescent devices according to the comparative manufacturing examples.

In conclusion, it can be seen that by curing a composition including a polymer including a thiol group and a low molecular weight compound including an unsaturated bond such as a vinyl group together at a relatively low temperature of 200°C or less, for example, about 190°C, about 180°C, about 170°C, or about 160°C, according to an embodiment, excellent cross-linking can be formed without damage to the hole injection layer due to curing at a high temperature in the prior art, and as a result, the produced cross-linked product can exhibit excellent hole transport characteristics and high luminous efficiency and luminescence characteristics according to a higher film retention ratio without deterioration of each hole transport characteristic.

Although the above has been described with reference to embodiments, the present disclosure is not limited to specific embodiments, and various modifications and changes are possible within the scope of the invention defined in the claims.

### <Description of symbols>

- 100: electroluminescence device (EL device)
- 110: substrate
- 120: first electrode
- 130: hole injection layer
- 140: hole transport layer
- 150: light emitting layer
- 160: electron transport layer
- 170: electron injection layer
- 180: second electrode

## Claims

1. A composition comprising a polymer including a structural unit (A) represented by Chemical Formula 1, and a compound represented by Chemical Formula 10: 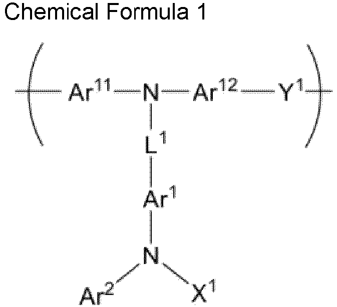 wherein, in Chemical Formula 1,
Ar¹¹ and Ar¹² are each independently a substituted or unsubstituted aromatic hydrocarbon group having 6 to 25 ring-forming atoms, wherein Ar¹¹ and Ar¹² are optionally linked to form a ring,
L¹ is a substituted or unsubstituted aromatic hydrocarbon group having 6 to 25 ring-forming atoms, or a substituted or unsubstituted heteroaromatic group having 5 to 25 ring-forming atoms,
Ar¹ is a substituted or unsubstituted aromatic hydrocarbon group having 6 to 25 ring-forming atoms,
Ar² is a substituted or unsubstituted aromatic hydrocarbon group having 6 to 25 ring-forming atoms, or a substituted or unsubstituted heteroaromatic group having 5 to 25 ring-forming atoms, wherein Ar¹ and Ar² are optionally linked to form a ring,
X¹ is a substituted or unsubstituted aromatic hydrocarbon group having 6 to 25 ring-forming atoms, or a substituted or unsubstituted heteroaromatic group having 5 to 25 ring-forming atoms, and
Y¹ is a group selected from an aromatic hydrocarbon group having 6 to 25 ring-forming atoms substituted with a thiol group-containing alkyl group having 1 to 14 carbon atoms, an aromatic hydrocarbon group having 6 to 25 ring-forming atoms substituted with a thiol group-containing alkoxyalkyl group having 2 to 14 carbon atoms, or an aromatic hydrocarbon group having 6 to 25 ring-forming atoms substituted with a thiol group-containing alkyl group having 1 to 14 carbon atoms and a thiol group-containing alkoxyalkyl group having 2 to 14 carbon atoms; 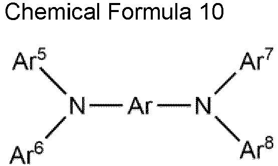 wherein, in Chemical Formula 10,
Ar and Ar⁵ to Ar⁸ are each independently a substituted or unsubstituted aromatic hydrocarbon group having 6 to 25 ring-forming atoms, a substituted or unsubstituted heteroaromatic ring group having 5 to 25 ring-forming atoms, or a combination thereof, wherein the aromatic hydrocarbon group and the heteroaromatic ring group include a single ring, a fused ring of two or more rings, a ring assembly in which the single ring and/or the fused ring are connected by a single bond,
wherein Ar⁵ and Ar⁶, and/or Ar⁷ and Ar⁸, are each independently optionally linked to the other to form a ring, respectively,
at least two of Ar and Ar⁵ to Ar⁸ are each independently substituted by a C2 to C10 aliphatic hydrocarbon group containing a carbon-carbon double bond or a carbon-carbon triple bond, or a C3 to C10 alicyclic hydrocarbon group containing a carbon-carbon double bond or a carbon-carbon triple bond.

2. The composition of claim 1, wherein the structural unit (A) is represented by Chemical Formula 1-1: 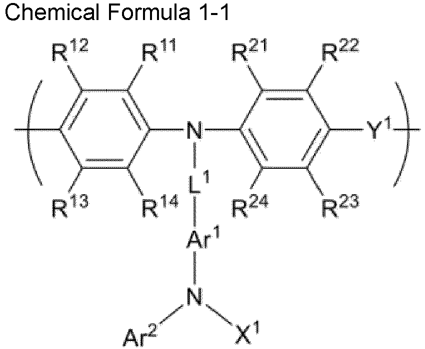 wherein, in Chemical Formula 1-1,
R¹¹ to R¹⁴ and R²¹ to R²⁴ are each independently a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R¹¹ and R²¹ are optionally linked to form a ring, and
L¹, Ar¹, Ar², X¹, and Y¹ are the same as defined in Chemical Formula 1.

3. The composition of claims 1 or 2, the polymer further including a structural unit (B) represented by Chemical Formula 2: 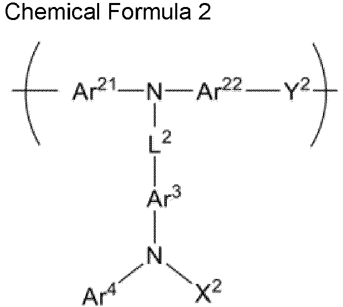 wherein, in Chemical Formula 2,
Ar²¹ and Ar²² are each independently a substituted or unsubstituted aromatic hydrocarbon group having 6 to 25 ring-forming atoms, wherein Ar²¹ and Ar²² are optionally linked to form a ring,
L² is a substituted or unsubstituted aromatic hydrocarbon group having 6 to 25 ring-forming atoms, or a substituted or unsubstituted heteroaromatic group having 5 to 25 ring-forming atoms,
Ar³ is a substituted or unsubstituted aromatic hydrocarbon group having 6 to 25 ring-forming atoms,
Ar⁴ is a substituted or unsubstituted aromatic hydrocarbon group having 6 to 25 ring-forming atoms, or a substituted or unsubstituted heteroaromatic group having 5 to 25 ring-forming atoms, wherein Ar³ and Ar⁴ are optionally linked to form a ring,
X² is a substituted or unsubstituted aromatic hydrocarbon group having 6 to 25 ring-forming atoms, or a substituted or unsubstituted heteroaromatic group having 5 to 25 ring-forming atoms,
Y² is an aromatic hydrocarbon group having 6 to 25 ring-forming atoms unsubstituted or substituted with an alkyl group having 1 to 14 carbon atoms, and
Ar²¹, Ar²², L², Ar³, Ar⁴, and X² do not have a thiol group-containing alkyl group having 1 to 14 carbon atoms, and do not have a thiol group-containing alkoxyalkyl group having 2 to 14 carbon atoms.

4. The composition of claim 3, wherein the structural unit (B) is represented by Chemical Formula 2-1: 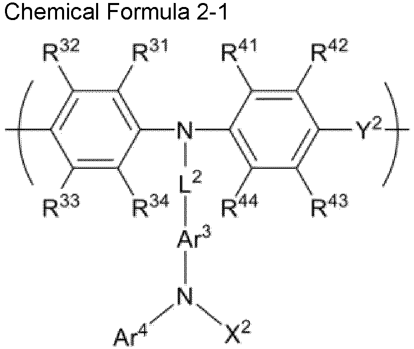 wherein, in Chemical Formula 2-1,
R³¹ to R³⁴ and R⁴¹ to R⁴⁴ are each independently a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom, wherein R³¹ and R⁴¹ are optionally linked to form a ring,
L², Ar³, Ar⁴, X², and Y² are the same as defined in Chemical Formula 2, and
R³¹ to R³⁴, R⁴¹ to R⁴⁴, L², Ar³, Ar⁴ and X² do not have a thiol group-containing alkyl group having 1 to 14 carbon atoms, and do not have a thiol group-containing alkoxyalkyl group having 2 to 14 carbon atoms; and/or
wherein the structural unit (A) is included in an amount of greater than or equal to 1 mol% and less than 30 mol% based on a total number of moles of the structural unit (A) and the structural unit (B) in the polymer.

5. The composition of any of claims 1-4, wherein the thiol group-containing alkoxyalkyl group substituent of Y¹ is represented by Chemical Formula i-1, and the thiol group-containing alkyl group substituent of Y¹ is represented by Chemical Formula i-2:
Chemical Formula i-1 *-Z¹ -O-Z²-SH
Chemical Formula i-2 *-Z1- SH
wherein, in Chemical Formula i-1 and Chemical Formula i-2,
Z¹ represents an alkylene group having 1 to 14 carbon atoms, substituted or unsubstituted with a thiol group,
Z² represents an alkylene group having 1 to 13 carbon atoms, substituted or unsubstituted with a thiol group,
a sum of the carbon number of the alkylene group represented by Z¹ and the carbon number of the alkylene group represented by Z² in Chemical Formula i-1 is an integer of 14 or less, and
* is bonded to a ring carbon of the aromatic hydrocarbon group having 6 to 25 ring-forming atoms.

6. The composition of any of claims 1-5, wherein Y¹ is the aromatic hydrocarbon group having 6 to 25 ring-forming atoms substituted with the thiol group-containing alkoxyalkyl group having 2 to 14 carbon atoms, or the aromatic hydrocarbon group having 6 to 25 ring-forming atoms substituted with a thiol group-containing alkyl group having 1 to 10 carbon atoms;
preferably wherein Y¹ is the aromatic hydrocarbon group having 6 to 25 ring-forming atoms substituted with the thiol group-containing alkoxyalkyl group, wherein the thiol group-containing alkoxyalkyl group has two or more thiol groups.

7. The composition of any of claims 1-6, wherein in Chemical Formula 1, Y¹ is represented by Chemical Formulae (3-1) to (3-6): 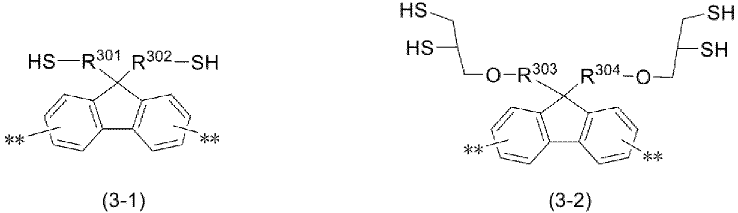 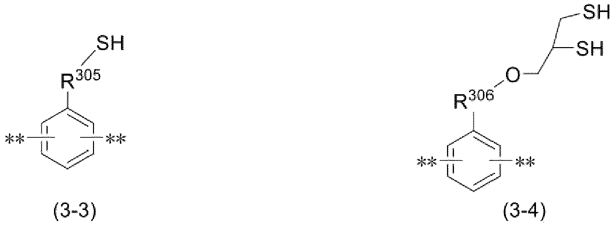 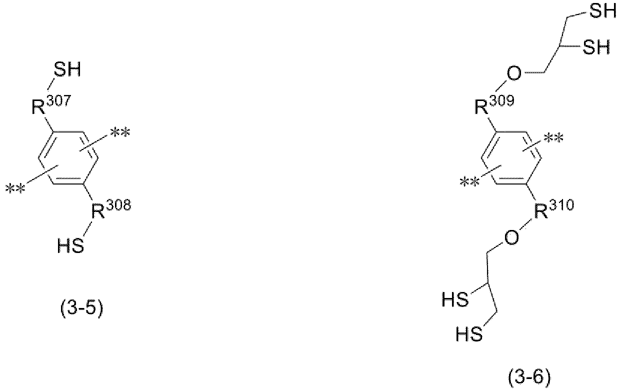 wherein, in Chemical Formulas 3-1 to 3-6,
R³⁰¹, R³⁰², R³⁰⁵, R³⁰⁷, and R³⁰⁸ are each independently a substituted or unsubstituted alkylene group having 1 to 14 carbon atoms,
R³⁰³, R³⁰⁴, R³⁰⁰, R³⁰⁹, and R³¹⁰ are each independently a substituted or unsubstituted alkylene group having 1 to 11 carbon atoms, and
one ** indicates a connection to Ar¹² and the other ** indicates a connection to an adjacent structural unit; and/or
wherein L¹ is represented by Chemical Formulae (4-1) to (4-24): 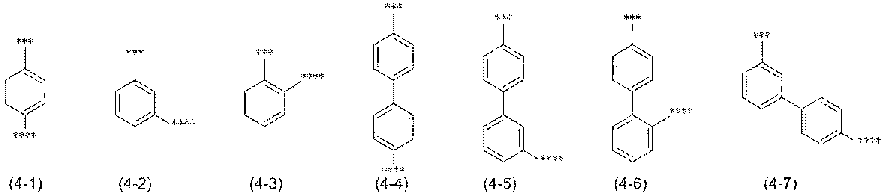 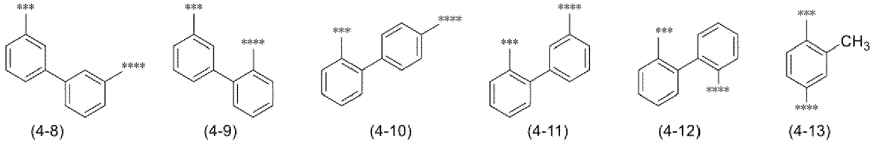 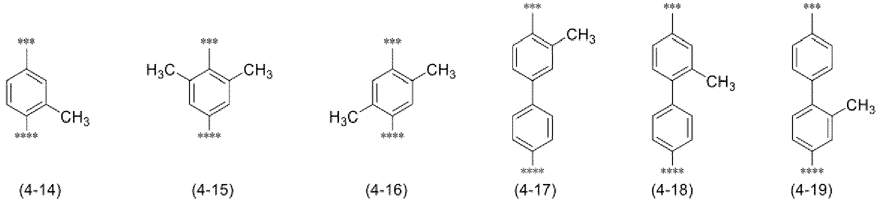 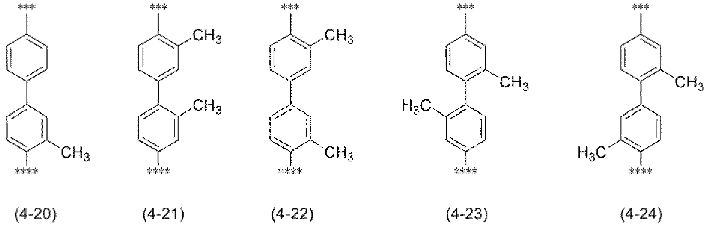 wherein, in Chemical Formulae 4-1 to 4-24,
*** indicates a connection to the nitrogen atom of Chemical Formula 1, and
**** indicates a connection to Ar¹.

8. The composition of any of claims 1-7, wherein in Chemical Formula 1, - L¹-Ar¹-N(Ar²)(X¹) is represented by Chemical Formulae (5-1), (5-2), or (5-3): 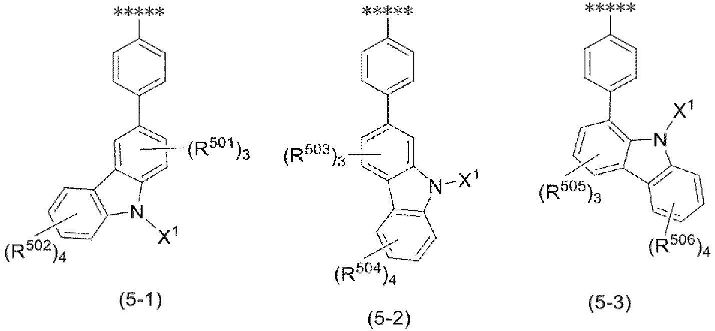 wherein, in Chemical Formulae (5-1), (5-2), or (5-3),
R⁵⁰¹ to R⁵⁰⁶ are each independently a hydrogen atom, a substituted or unsubstituted alkyl group, a substituted or unsubstituted cycloalkyl group, a substituted or unsubstituted alkoxy group, a substituted or unsubstituted cycloalkoxy group, a substituted or unsubstituted aryl group, or a halogen atom,
X¹ is the same as defined in Chemical Formula 1, and
***** indicates a connection to the nitrogen atom of Chemical Formula 1.

9. The composition of any of claims 1-8, wherein in Chemical Formula 10,
Ar and Ar⁵ to Ar⁸ are each independently a substituted or unsubstituted aromatic hydrocarbon group having 6 to 15 ring-forming atoms, a substituted or unsubstituted heteroaromatic ring group having 5 to 15 ring-forming atoms, or a combination thereof, wherein the aromatic hydrocarbon group and the heteroaromatic ring group each independently include a single ring, a fused ring of two or more rings, or a ring assembly in which the single ring and/or the fused ring are connected by a single bond,
Ar⁵ and Ar⁶, and/or Ar⁷ and Ar⁸, are each independently optionally linked to form a ring, respectively, and
at least two of Ar⁵ to Ar⁸ are each independently substituted by a C2 to C5 aliphatic hydrocarbon group containing a carbon-carbon double bond or a carbon-carbon triple bond, or a C3 to C6 alicyclic hydrocarbon group containing a carbon-carbon double bond or a carbon-carbon triple bond.

10. The composition of any of claims 1-9, wherein in Chemical Formula 10,
Ar is a substituted or unsubstituted phenylene group, a substituted or unsubstituted pyridinylene group, a substituted or unsubstituted pyrimidylene group, a substituted or unsubstituted pyrazinylene group, a substituted or unsubstituted triazinylene group, a substituted or unsubstituted biphenylene group, or a combination thereof,
Ar⁵ to Ar⁸ are each independently a substituted or unsubstituted phenyl group, a substituted or unsubstituted biphenyl group, a substituted or unsubstituted naphthyl group, a substituted or unsubstituted anthracenyl group, a substituted or unsubstituted phenanthrenyl group, a substituted or unsubstituted acridinyl group, a substituted or unsubstituted pyridinyl group, or a combination thereof,
wherein Ar⁵ and Ar⁶, and/or Ar⁷ and Ar⁸, are each independently optionally linked to form a substituted or unsubstituted carbazole ring, or a fused ring including an indole or a pyridine ring, wherein the indole and/or the pyridine ring is optionally substituted, and
one of Ar⁵ and Ar⁶, and one of Ar⁷ and Ar⁸, are each independently substituted with a C2 to C4 aliphatic hydrocarbon group including a carbon-carbon double bond or a carbon-carbon triple bond.

11. The composition of any of claims 1-10, wherein Chemical Formula 10 is represented by Chemical Formula 10-1: 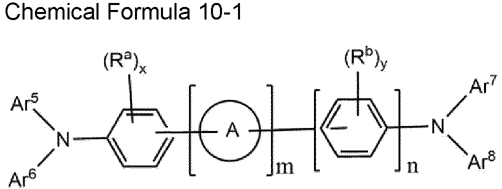 wherein, in Chemical Formula 10-1, 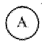
is a substituted or unsubstituted heteroaromatic ring group having 5 to 15 ring-forming atoms,
Ar⁵ to Ar⁸ are each independently the same as defined in Chemical Formula 10,
R^{a} and R^{b} are each independently, deuterium, a C1 to C10 alkyl group, a C2 to C10 alkenyl group, a C1 to C10 haloalkyl group, a halogen atom, a cyano group, a nitro group, or a combination thereof,
x and y are each independently an integer from 0 to 4, and
m and n are each independently an integer from 0 to 3.

12. The composition of any of claims 1-11, wherein the polymer represented by Chemical Formula 1 and the compound represented by Chemical Formula 10 independently have a hole transport coefficient of greater than or equal to 10⁻⁵ cm²V⁻¹s⁻¹.

13. A thin film fabricated by curing the composition of any of claims 1-12, preferably comprising a crosslinked polymer in which the compound of Chemical Formula 10 forms crosslinks within the polymer between adjacent structural units A through a thiolene bond reaction.

14. An electroluminescence device, comprising:
a first electrode and a second electrode facing each other,
a light-emitting layer disposed between the first electrode and the second electrode, and
at least one organic film between the first electrode and light-emitting layer,
wherein the at least one organic film comprises the thin film of claim 13,
wherein the thin film is a hole transport layer.

15. The electroluminescence device of claim 14, wherein the at least one organic film further comprises a hole injection layer disposed between the first electrode and the thin film; and/or
wherein the light-emitting layer comprises a semiconductor nanocrystal particle, a perovskite-type compound, or a combination thereof.
